(19) Europäisches Patentamt
European Patent Office
Office européen des brevets

(11) **EP 4 080 448 B1**

(12) **EUROPEAN PATENT SPECIFICATION**

(45) Date of publication and mention
of the grant of the patent:
**25.02.2026 Bulletin 2026/09**

(21) Application number: **20910651.7**

(22) Date of filing: **25.12.2020**

(51) International Patent Classification (IPC):
*G01S 17/10* (2020.01)      *G01S 17/894* (2020.01)
*G01S 7/481* (2006.01)      *G01S 7/4865* (2020.01)
*G06T 7/00* (2017.01)      *G02F 1/13* (2006.01)
*G01S 17/89* (2020.01)      *G01S 7/499* (2006.01)
*G02B 26/10* (2006.01)      *G02B 27/28* (2006.01)
*G02B 5/02* (2006.01)      *G02B 26/08* (2006.01)

(52) Cooperative Patent Classification (CPC):
**G02F 1/1313; G01S 7/4815; G01S 7/4817;
G01S 7/499; G01S 17/89; G02B 26/0833;
G02B 26/101; G02B 26/105; G02B 27/283;**
G02B 5/0278; G02F 2201/305; G02F 2203/07

(86) International application number:
**PCT/CN2020/139510**

(87) International publication number:
**WO 2021/136098 (08.07.2021 Gazette 2021/27)**

(54) **TOF DEPTH SENSING MODULE AND IMAGE GENERATION METHOD**

TOF-TIEFENMESSMODUL UND BILDERZEUGUNGSVERFAHREN

MODULE DE DÉTECTION DE PROFONDEUR DE TOF ET PROCÉDÉ DE GÉNÉRATION D'IMAGE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **03.01.2020 CN 202010006467**

(43) Date of publication of application:
**26.10.2022 Bulletin 2022/43**

(73) Proprietor: **Huawei Technologies Co., Ltd.
Longgang
Shenzhen, Guangdong 518129 (CN)**

(72) Inventors:
• **QIU, Meng**
**Shenzhen, Guangdong 518129 (CN)**
• **WU, Jushuai**
**Shenzhen, Guangdong 518129 (CN)**

• **GAO, Shaorui**
**Shenzhen, Guangdong 518129 (CN)**
• **GUO, Banghui**
**Shenzhen, Guangdong 518129 (CN)**
• **SONG, Xiaogang**
**Shenzhen, Guangdong 518129 (CN)**

(74) Representative: **Gill Jennings & Every LLP
The Broadgate Tower
20 Primrose Street
London EC2A 2ES (GB)**

(56) References cited:
WO-A1-2018/221049      CN-A- 101 866 056
CN-A- 102 222 329      CN-A- 102 679 868
CN-A- 106 574 964      CN-A- 109 541 631
US-A1- 2006 221 250      US-A1- 2016 187 471
US-A1- 2016 245 903      US-A1- 2021 124 030

EP 4 080 448 B1

**Description**

**TECHNICAL FIELD**

This application relates to the field of TOF technologies, and more specifically, to a TOF depth sensing module and an image generation method.

**BACKGROUND**

A time of flight (time of flight, TOF) technology is a common depth or distance measurement technology, whose basic principle is as follows: A transmit end emits continuous-wave light or pulsed light. The continuous-wave light or the pulsed light is reflected after irradiating a to-be-measured object. Then, a receive end receives reflected light of the to-be-measured object. Next, a distance or a depth of the to-be-measured object to a TOF system may be calculated by determining a time of flight of the light from the transmit end to the receive end.

In a conventional solution, a pulsed TOF technology is usually used to measure a distance. The pulsed TOF technology is measuring a distance by measuring a time difference between an emission time of an emergent beam (emitted by a transmit end) and a reception time of a reflected beam (received by a receive end). Specifically, in the pulsed TOF technology, a light source generally emits a pulsed beam with a short duration, which is received by a photodetector at a receive end after reflected by a to-be-measured object. A depth or a distance of the to-be-measured object may be obtained by measuring a time interval between pulse emission and pulse reception.

The pulsed TOF technology requires high sensitivity of the photodetector to detect a single photon. A common photodetector is a single-photon avalanche diode (single-photon avalanche diode, SPAD). Due to a complex interface and processing circuit of the SPAD, a resolution of a common SPAD sensor is low, which cannot meet a high spatial resolution requirement of depth sensing.

US-A-2016/0245903 describes a light beam scanning device which includes a controller device which dynamically adjusts a divergence of the beam. Divergence adjustment can include adjusting the beam divergence along one or more cross sectional axes of the beam. Beam divergence can be adjusted between consecutive scans, during a scan, etc. Beam divergence can be adjusted based on the field of view and scan rate.

WO-A-2018/221049 and apparatus that includes a polarized light filter which is disposed on an optical path between an object and a light-receiving part of a ToF sensor and which transmits light that has been polarized in the direction perpendicular to the scanning direction.

US-A-2016/0187471 describes a method for determining the distance of an object by means of a polarization-modulated transmission light beam, wherein the transmission light beam reflected at the object is received as reception light beam by a polarization analyzer and the output signal thereof is fed to an evaluation unit for determining the distance.

**SUMMARY**

This application provides a TOF depth sensing module as defined in claim 1 and an image generation method as defined in claim 12, to improve a spatial resolution of a depth image that is finally generated by the TOF depth sensing module.

According to a first aspect, a TOF depth sensing module is provided. The TOF depth sensing module includes a light source, a polarization filter, a beam shaper, a first optical element, a second optical element, a receiving unit, and a control unit. The light source can generate light in a plurality of polarization states, and the polarization filter is located between the light source and the beam shaper.

Functions of the modules or units in the TOF depth sensing module are specifically as follows:

The light source is configured to generate a beam.

The polarization filter is configured to filter the beam to obtain a beam in a single polarization state.

The beam shaper is configured to increase a FOV of the beam in the single polarization state to obtain a first beam.

The control unit is configured to control the first optical element to control a direction of the first beam to obtain an emergent beam.

The control unit is further configured to control the second optical element to deflect, to the receiving unit, a reflected beam that is obtained by reflecting the beam from the first optical element by a target object.

The FOV of the first beam meets a first preset range.

Optionally, the first preset range may be [5°×5°, 20°×20°]. The single polarization state is one of the plurality of polarization states.

For example, the plurality of polarization states may include linear polarization, left-handed circular polarization,

and right-handed circular polarization, and the single polarization state may be any one of the linear polarization, the left-handed circular polarization, and the right-handed circular polarization.

The first optical element and the second optical element are different elements, the first optical element is located at a transmit end, and the second optical element is located at a receive end. Specifically, the first optical element may be located between the beam shaper and the target object, and the second optical element may be located between the receiving unit and the target object.

The receiving unit may include a receiving lens and a sensor. The receiving lens may converge the reflected beam to the sensor, so that the sensor can receive the reflected beam, then a moment at which the reflected beam is received by the receiving unit is obtained, to obtain a TOF corresponding to the emergent beam, and finally, a depth image of the target object may be generated based on the TOF corresponding to the emergent beam.

Optionally, the control unit is configured to adjust a birefringence parameter of the first optical element to obtain an adjusted birefringence parameter. The first optical element is configured to adjust the direction of the first beam based on the adjusted birefringence parameter, to obtain the emergent beam.

The first optical element can adjust the first beam to different directions by using different birefringence of the first optical element.

According to the invention, the control unit is configured to: control the first optical element to respectively control the direction of the first beam at M different moments, to obtain emergent beams in M different directions; and control the second optical element to respectively deflect, to the receiving unit, M reflected beams that are obtained by reflecting the beams from the first optical element at the M different moments by the target object.

Optionally, a total FOV covered by the emergent beams in the M different directions meets a second preset range.

Optionally, the second preset range may be [50°×50°, 80°×80°].

In this embodiment of this application, the beam shaper adjusts the FOV of the beam so that the first beam has a large FOV, and scanning is performed in a time division multiplexing manner (the first optical element emits emergent beams in different directions at different moments), thereby improving a spatial resolution of the finally obtained depth image of the target object.

With reference to the first aspect, according to the invention, the control unit is further configured to: generate a depth image of the target object based on TOFs respectively corresponding to the emergent beams in the M different directions.

The TOFs corresponding to the emergent beams in the M different directions may specifically refer to time difference information between moments at which the reflected beams corresponding to the emergent beams in the M different directions are received by the receiving unit and emission moments of the emergent beams in the M different directions.

Assuming that the emergent beams in the M different directions include an emergent beam 1, a reflected beam corresponding to the emergent beam 1 may be a beam that is generated after the emergent beam 1 reaches the target object and is reflected by the target object.

With reference to the first aspect, in some implementations of the first aspect, a distance between the first optical element and the second optical element is less than or equal to 1 cm.

With reference to the first aspect, in some implementations of the first aspect, the first optical element is a rotating mirror component.

With reference to the first aspect, in some implementations of the first aspect, the second optical element is a rotating mirror component.

The rotating mirror component rotates to control an emergent direction of the emergent beam.

With reference to the first aspect, in some implementations of the first aspect, the first optical element is a liquid crystal polarization element.

With reference to the first aspect, in some implementations of the first aspect, the second optical element is a liquid crystal polarization element.

With reference to the first aspect, in some implementations of the first aspect, the first optical element includes a horizontal polarization control sheet, a horizontal liquid crystal polarization grating, a vertical polarization control sheet, and a vertical liquid crystal polarization grating.

With reference to the first aspect, in some implementations of the first aspect, the second optical element includes a horizontal polarization control sheet, a horizontal liquid crystal polarization grating, a vertical polarization control sheet, and a vertical liquid crystal polarization grating.

With reference to the first aspect, in some implementations of the first aspect, in the first optical element or the second optical element, distances between the light source and the horizontal polarization control sheet, the horizontal liquid crystal polarization grating, the vertical polarization control sheet, and the vertical liquid crystal polarization grating are in ascending order of magnitude.

With reference to the first aspect, in some implementations of the first aspect, in the first optical element or the second optical element, distances between the light source and the vertical polarization control sheet, the vertical liquid crystal polarization grating, the horizontal polarization control sheet, and the horizontal liquid crystal polarization grating are in ascending order of magnitude.

With reference to the first aspect, in some implementations of the first aspect, the rotating mirror component is a microelectromechanical system galvanometer or a multifaceted rotating mirror.

With reference to the first aspect, in some implementations of the first aspect, the beam shaper includes a diffusion lens and a rectangular aperture stop.

With reference to the first aspect, in some implementations of the first aspect, the TOF depth sensing module further includes a collimation lens. The collimation lens is located between the light source and the polarization filter. The collimation lens is configured to collimate the beam. The polarization filter is configured to filter a collimated beam of the collimation lens, to obtain a beam in a single polarization state.

With reference to the first aspect, in some implementations of the first aspect, the TOF depth sensing module further includes a collimation lens. The collimation lens is located between the polarization filter and the beam shaper. The collimation lens is configured to collimate the beam in the single polarization state. The beam shaper is configured to adjust a FOV of a collimated beam of the collimation lens, to obtain a first beam.

In the foregoing, the collimation lens collimates the beam, so that an approximately parallel beam can be obtained, thereby improving a power density of the beam, and further improving an effect of scanning by the beam subsequently.

Optionally, a clear aperture of the collimation lens is less than or equal to 5 mm.

Because a size of the collimation lens is small, the TOF depth sensing module including the collimation lens is easily integrated into a terminal device, and a space occupied in the terminal device can be reduced to some extent.

With reference to the first aspect, in some implementations of the first aspect, the light source is a vertical cavity surface emitting laser (vertical cavity surface emitting laser, VCSEL).

Optionally, the light source is a Fabry-Perot laser (which may be referred to as an FP laser for short).

A single FP laser can implement a larger power than a single VCSEL, and has higher electro-optical conversion efficiency than the VCSEL, thereby improving a scanning effect of the TOF depth sensing module.

Optionally, a wavelength of the beam emitted by the light source is greater than 900 nm.

Because intensity of light whose wavelength is greater than 900 nm in sunlight is weak, when the wavelength of the beam is greater than 900 nm, interference caused by the sunlight can be reduced, thereby improving a scanning effect of the TOF depth sensing module.

Optionally, a wavelength of the beam emitted by the light source is 940 nm or 1550 nm.

Because intensity of light whose wavelength is near 940 nm or 1550 nm in sunlight is weak, when the wavelength of the beam is 940 nm or 1550 nm, interference caused by the sunlight can be greatly reduced, thereby improving a scanning effect of the TOF depth sensing module.

With reference to the first aspect, in some implementations of the first aspect, a light emitting area of the light source is less than or equal to $5 \times 5$ mm$^2$.

Because a size of the light source is small, the TOF depth sensing module including the light source is easily integrated into a terminal device, and a space occupied in the terminal device can be reduced to some extent.

With reference to the first aspect, in some implementations of the first aspect, an average output optical power of the TOF depth sensing module is less than 800 mw.

When the average output optical power of the TOF depth sensing module is less than or equal to 800 mw, the TOF depth sensing module has small power consumption, and can be disposed in a device sensitive to power consumption, such as a terminal device.

According to a second aspect, an image generation method is provided. The image generation method is applied to a terminal device including the TOF depth sensing module in the first aspect, and the image generation method includes: controlling the light source to generate a beam; filtering the beam by using the polarization filter to obtain a beam in a single polarization state; adjusting a field of view FOV of the beam in the single polarization state by using the beam shaper to obtain a first beam; controlling the first optical element to respectively control a direction of the first beam from the beam shaper at M different moments, to obtain emergent beams in M different directions; controlling the second optical element to respectively deflect, to the receiving unit, M reflected beams that are obtained by reflecting the emergent beams in the M different directions by a target object; and generating a depth image of the target object based on TOFs respectively corresponding to the emergent beams in the M different directions.

The single polarization state is one of the plurality of polarization states.

For example, the plurality of polarization states may include linear polarization, left-handed circular polarization, and right-handed circular polarization, and the single polarization state may be any one of the linear polarization, the left-handed circular polarization, and the right-handed circular polarization.

The FOV of the first beam meets a first preset range, and a total FOV covered by the emergent beams in the M different directions meets a second preset range.

Optionally, the first preset range may be [$5° \times 5°$, $20° \times 20°$], and the second preset range may be [$50° \times 50°$,

80°×80°].

Optionally, the method further includes: obtaining the TOFs respectively corresponding to the emergent beams in the M different directions.

Optionally, the obtaining the TOFs respectively corresponding to the emergent beams in the M different directions includes: determining, based on moments at which the reflected beams corresponding to the emergent beams in the M different directions are received by the receiving unit and emission moments of the emergent beams in the M different directions, the TOFs respectively corresponding to the emergent beams in the M different directions.

The TOFs corresponding to the emergent beams in the M different directions may specifically refer to time difference information between the moments at which the reflected beams corresponding to the emergent beams in the M different directions are received by the receiving unit and the emission moments of the emergent beams in the M different directions.

In this embodiment of this application, the beam shaper adjusts the FOV of the beam so that the first beam has a large FOV, and scanning is performed in a time division multiplexing manner (the first optical element emits emergent beams in different directions at different moments), thereby improving a spatial resolution of the finally obtained depth image of the target object.

Optionally, the controlling the first optical element to respectively control a direction of the first beam from the beam shaper at M different moments, to obtain emergent beams in M different directions includes: adjusting a birefringence parameter of the first optical element at the M different moments to obtain adjusted birefringence parameters respectively corresponding to the M different moments, so that the first optical element respectively adjusts the direction of the first beam based on the adjusted birefringence parameters at the M different moments, to obtain the emergent beams in the M different directions.

With reference to the second aspect, in some implementations of the second aspect, the generating a depth image of the target object based on TOFs respectively corresponding to the emergent beams in the M different directions includes: determining distances between the TOF depth sensing module and M regions of the target object based on the TOFs respectively corresponding to the emergent beams in the M different directions; generating depth images of the M regions of the target object based on the distances between the TOF depth sensing module and the M regions of the target object; and synthesizing the depth image of the target object based on the depth images of the M regions of the target object.

With reference to the second aspect, in some implementations of the second aspect, the controlling the first optical element to respectively control a direction of the first beam from the beam shaper at M different moments, to obtain emergent beams in M different directions includes: the control unit generates a first voltage signal. The first voltage signal is used to control the first optical element to respectively control the direction of the first beam at the M different moments, to obtain the emergent beams in the M different directions. The controlling the second optical element to respectively deflect, to the receiving unit, M reflected beams that are obtained by reflecting the emergent beams in the M different directions by a target object includes: the control unit generates a second voltage signal. The second voltage signal is used to control the second optical element to respectively deflect, to the receiving unit, the M reflected beams that are obtained by reflecting the emergent beams in the M different directions by the target object.

Voltage values of the first voltage signal and the second voltage signal are the same at a same moment.

With reference to the second aspect, in some implementations of the second aspect, the adjusting a field of view FOV of the beam in the single polarization state by using the beam shaper to obtain a first beam includes: increasing angular intensity distribution of the beam in the single polarization state by using the beam shaper to obtain the first beam.

According to a third aspect, a terminal device is provided. The terminal device includes the TOF depth sensing module in the first aspect.

The terminal device in the third aspect may perform the image generation method in the second aspect.

## BRIEF DESCRIPTION OF DRAWINGS

FIG. 1 is a schematic diagram of a ranging principle of a lidar;

FIG. 2 is a schematic diagram of measuring a distance by using a TOF depth sensing module according to an embodiment of this application;

FIG. 3 is a schematic block diagram of a TOF depth sensing module;

FIG. 4 is a schematic diagram of a VCSEL;

FIG. 5 is a schematic diagram of an array light source;

FIG. 6 is a schematic diagram of splitting, by using a beam splitter, a beam emitted by an array light source;

FIG. 7 is a schematic diagram of a projection region obtained after a beam emitted by an array light source is split by using a beam splitter;

FIG. 8 is a schematic diagram of a projection region obtained after a beam emitted by an array light source is split by using a beam splitter;

FIG. 9 is a schematic diagram of a projection region obtained after a beam emitted by an array light source is split by using a beam splitter;

FIG. 10 is a schematic diagram of a projection region obtained after a beam emitted by an array light source is split by using a beam splitter;

FIG. 11 is a schematic diagram of a structure of a TOF depth sensing module;

FIG. 12 is a schematic diagram of splitting performed by a beam splitter;

FIG. 13 is a schematic diagram of a structure of a TOF depth sensing module;

FIG. 14 is a schematic diagram of a structure of a TOF depth sensing module;

FIG. 15 is a schematic diagram of working of a TOF depth sensing module;

FIG. 16 is a schematic diagram of a light emitting region of an array light source;

FIG. 17 is a schematic diagram of splitting, by using a beam splitter, a beam emitted by the array light source shown in FIG. 16;

FIG. 18 is a schematic flowchart of an image generation method;

FIG. 19 shows depth images of a target object at moments t0 to t3;

FIG. 20 is a schematic flowchart of an image generation method;

FIG. 21 is a schematic flowchart of an image generation method;

FIG. 22 is a schematic flowchart of obtaining a final depth image of a target object in a first working mode;

FIG. 23 is a schematic flowchart of obtaining a final depth image of a target object in a first working mode;

FIG. 24 is a schematic flowchart of obtaining a final depth image of a target object in a second working mode;

FIG. 25 is a schematic flowchart of obtaining a final depth image of a target object in a second working mode;

FIG. 26 is a schematic diagram of measuring a distance by using a TOF depth sensing module;

FIG. 27 is a schematic block diagram of a TOF depth sensing module;

FIG. 28 is a schematic diagram of a space angle of a beam;

FIG. 29 is a schematic block diagram of a TOF depth sensing module;

FIG. 30 is a schematic diagram of scanning a target object by a TOF depth sensing module;

FIG. 31 is a schematic diagram of a scanning track of a TOF depth sensing module;

FIG. 32 is a schematic diagram of a scanning manner of a TOF depth sensing module;

FIG. 33 is a schematic block diagram of a TOF depth sensing module;

FIG. 34 is a schematic block diagram of a TOF depth sensing module;

FIG. 35 is a schematic diagram of a structure of a liquid crystal polarization grating;

FIG. 36 is a schematic diagram of a structure of a TOF depth sensing module;

FIG. 37 is a schematic diagram of changing a physical characteristic of a liquid crystal polarization grating by using a periodic control signal;

FIG. 38 is a schematic diagram of controlling a direction of an input beam by a liquid crystal polarization grating;

FIG. 39 is a schematic diagram of a voltage signal applied to a liquid crystal polarization grating;

FIG. 40 is a schematic diagram of a scanning track of a TOF depth sensing module;

FIG. 41 is a schematic diagram of a to-be-scanned region;

FIG. 42 is a schematic diagram of a to-be-scanned region;

FIG. 43 is a schematic diagram of a structure of a TOF depth sensing module;

FIG. 44 is a schematic diagram of controlling a direction of a beam by an electro-optic crystal;

FIG. 45 is a schematic diagram of a voltage signal applied to an electro-optic crystal;

FIG. 46 is a schematic diagram of a scanning track of a TOF depth sensing module;

FIG. 47 is a schematic diagram of a structure of a TOF depth sensing module;

FIG. 48 is a schematic diagram of controlling a direction of a beam by an acousto-optic component;

FIG. 49 is a schematic diagram of a structure of a TOF depth sensing module;

FIG. 50 is a schematic diagram of controlling a direction of a beam by an OPA component;

FIG. 51 is a schematic diagram of a structure of a TOF depth sensing module;

FIG. 52 is a schematic flowchart of an image generation method;

FIG. 53 is a schematic diagram of measuring a distance by using a TOF depth sensing module according to an embodiment of this application;

FIG. 54 is a schematic diagram of a structure of a TOF depth sensing module according to an embodiment of this application;

FIG. 55 is a schematic block diagram of a TOF depth sensing module according to an embodiment of this application;

FIG. 56 is a schematic block diagram of a TOF depth sensing module according to an embodiment of this application;

FIG. 57 is a schematic flowchart of an image generation method according to an embodiment of this application;

FIG. 58 is a schematic block diagram of a TOF depth sensing module according to an embodiment of this application;

FIG. 59 is a schematic block diagram of a TOF depth sensing module according to an embodiment of this application;

FIG. 60 is a schematic block diagram of a TOF depth sensing module according to an embodiment of this application;

FIG. 61 is a schematic diagram of a structure of a TOF depth sensing module according to an embodiment of this application;

FIG. 62 is a schematic flowchart of an image generation method according to an embodiment of this application;

FIG. 63 is a schematic diagram of a structure of a TOF depth sensing module according to an embodiment of this application;

FIG. 64 is a schematic diagram of a structure of a liquid crystal polarizer according to an embodiment of this application;

FIG. 65 is a schematic diagram of a control timing;

FIG. 66 is a timing diagram of a voltage drive signal;

FIG. 67 is a schematic diagram of scanned regions of a TOF depth sensing module at different moments;

FIG. 68 is a schematic diagram of depth images corresponding to a target object at moments t0 to t3;

FIG. 69 is a schematic diagram of a final depth image of a target object;

FIG. 70 is a schematic diagram of working with a TOF depth sensing module;

FIG. 71 is a schematic diagram of a structure of a TOF depth sensing module;

FIG. 72 is a schematic diagram of a structure of a TOF depth sensing module;

FIG. 73 is a schematic diagram of a structure of a TOF depth sensing module;

FIG. 74 is a schematic diagram of a structure of a TOF depth sensing module;

FIG. 75 is a schematic diagram of a structure of a TOF depth sensing module;

FIG. 76 is a schematic diagram of a structure of a TOF depth sensing module 500;

FIG. 77 is a schematic diagram of a form of a microlens diffuser;

FIG. 78 is a schematic flowchart of an image generation method;

FIG. 79 is a schematic diagram of a structure of a TOF depth sensing module;

FIG. 80 is a schematic diagram of a specific structure of a TOF depth sensing module;

FIG. 81 is a schematic diagram of a specific structure of a TOF depth sensing module;

FIG. 82 is a schematic diagram of a specific structure of a TOF depth sensing module;

FIG. 83 is a schematic diagram of a specific structure of a TOF depth sensing module;

FIG. 84 is a schematic diagram of a structure of a TOF depth sensing module 600 ;

FIG. 85 is a schematic diagram of a structure of a TOF depth sensing module 600 ;

FIG. 86 is a schematic diagram of a structure of a TOF depth sensing module 600 ;

FIG. 87 is a schematic diagram of receiving a polarized beam by a polarization filter;

FIG. 88 is a schematic flowchart of an image generation method ;

FIG. 89 is a schematic diagram of a specific structure of a TOF depth sensing module ;

FIG. 90 is a schematic diagram of a specific structure of a TOF depth sensing module ;

FIG. 91 is a schematic diagram of a specific structure of a TOF depth sensing module ;

FIG. 92 is a schematic diagram of a specific structure of a TOF depth sensing module ;

FIG. 93 is a schematic diagram of a specific structure of a TOF depth sensing module ;

FIG. 94 is a schematic diagram of a drive signal and a received signal of a TOF depth sensing module ;

FIG. 95 is a schematic diagram of an angle and a state of a beam emitted by a TOF depth sensing module ;

FIG. 96 is a schematic diagram of a structure of a TOF depth sensing module ;

FIG. 97 is a schematic diagram of a structure of a TOF depth sensing module ;

FIG. 98 is a schematic diagram of a structure of a TOF depth sensing module ;

FIG. 99 is a schematic diagram of a principle of beam deflection performed by a flat liquid crystal cell;

FIG. 100 is a schematic diagram of a principle of beam deflection performed by a flat liquid crystal cell;

FIG. 101 is a schematic flowchart of an image generation method;

FIG. 102 is a schematic diagram of a FOV of a first beam;

FIG. 103 is a schematic diagram of a total FOV covered by emergent beams in M different directions;

FIG. 104 is a schematic diagram of scanning performed in M different directions by a TOF depth sensing module according to an embodiment of this application; and

FIG. 105 is a schematic flowchart of an overall solution design according to an embodiment of this application.

## DESCRIPTION OF EMBODIMENTS

The following describes technical solutions of this application with reference to accompanying drawings.

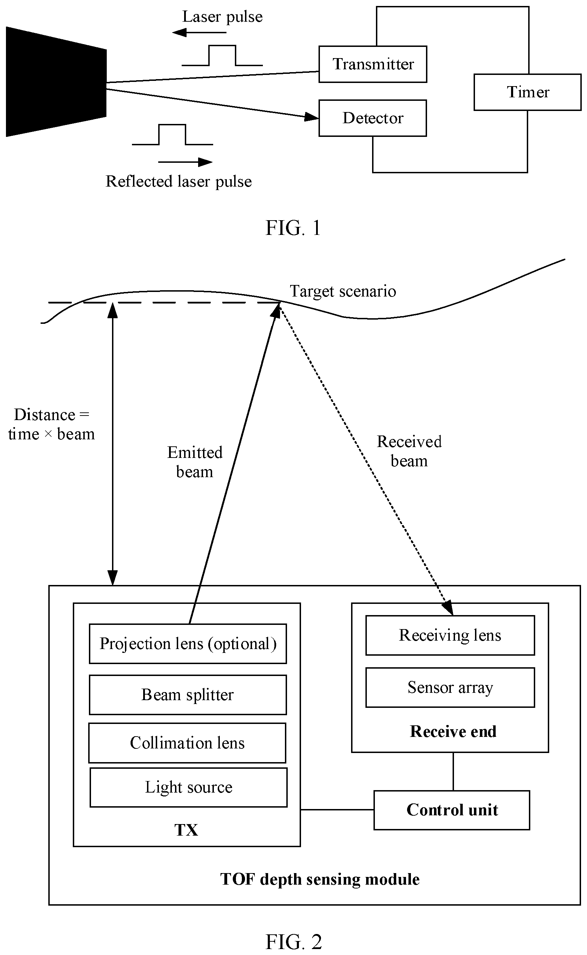

FIG. 1 is a schematic diagram of a ranging principle of a lidar.

As shown in FIG. 1, a transmitter of the lidar emits a laser pulse (a pulse width may be on the order of nanoseconds to picoseconds), and at the same time, a timer starts timing. When the laser pulse irradiates a target region, a reflected laser pulse is generated due to reflection of a surface of the target region. When a detector of the lidar receives the reflected laser pulse, the timer stops timing to obtain a time of flight (time of flight, TOF). Next, a distance between the lidar and the target region may be calculated based on the TOF.

Specifically, the distance between the lidar and the target region may be determined based on a formula (1):

$$L=c*T/2 \tag{1}$$

In the foregoing formula (1), L is the distance between the lidar and the target region, c is a velocity of light, and T is the time of light propagation.

It should be understood that, in a TOF depth sensing module, after emitted by a light source, a beam needs to be processed by another element (for example, a collimation lens or a beam splitter) in the TOF depth sensing module, so that the beam is finally emitted from a transmit end. In this process, a beam from an element in the TOF depth sensing module may also be referred to as a beam emitted by the element.

For example, the light source emits a beam, and the beam is further emitted after collimated by the collimation lens. The beam emitted by the collimation lens actually may also be referred to as a beam from the collimation lens. Herein, the beam emitted by the collimation lens does not represent a beam emitted by the collimation lens itself, but a beam emitted after a beam propagated from a previous element is processed.

Optionally, the light source may be a laser light source, a light emitting diode (light emitting diode, LED) light source, or a light source in another form. This is not exhaustive in the present invention.

Optionally, the light source is a laser light source, and the laser light source may be specifically an array light source.

In addition, in this application, a beam emitted by the laser light source or the array light source may also be referred to as a beam from the laser light source or the array light source. It should be understood that the beam from the laser light source may also be referred to as a laser beam. For ease of description, they are collectively referred to as a beam in this application.

The following first briefly describes the TOF depth sensing module with reference to FIG. 2.

FIG. 2 is a schematic diagram of measuring a distance by using a TOF depth sensing module.

As shown in FIG. 2, the TOF depth sensing module may include a transmit end (which may also be referred to as a projection end), a receive end, and a control unit. The transmit end is configured to generate an emergent beam. The receive end is configured to receive a reflected beam of a target object (the reflected beam is a beam obtained by reflecting the emergent beam by the target object). The control unit may control the transmit end and the receive end to transmit and receive the beam, respectively.

In FIG. 2, the transmit end may generally include a light source, a beam splitter, a collimation lens, and a projection lens (optional), the receive end may generally include a receiving lens and a sensor, and the receiving lens and the sensor may be collectively referred to as a receiving unit.

In FIG. 2, a TOF corresponding to the emergent beam may be recorded by using a timing apparatus, to calculate a distance from the TOF depth sensing module to a target region, to obtain a final depth image of the target object. The TOF corresponding to the emergent beam may refer to time difference information between a moment at which the reflected beam is received by the receiving unit and an emission moment of the emergent beam.

The light source in FIG. 2 may be a laser light source, and the laser light source may be specifically an array light source.

The TOF depth sensing module may be configured to obtain a three-dimensional (3 dimensions, 3D) image. The TOF depth sensing module may be disposed on an intelligent terminal (for example, a mobile phone, a tablet, or a wearable device), to obtain a depth image or a 3D image, which may also provide gesture and limb recognition for a 3D game or a somatic game.

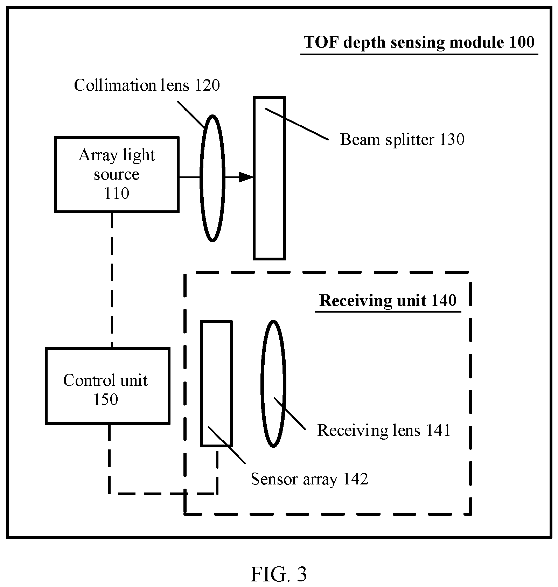

The following describes in detail the TOF depth sensing module with reference to FIG. 3.

FIG. 3 is a schematic block diagram of a TOF depth sensing module.

The TOF depth sensing module 100 shown in FIG. 3 includes an array light source 110, a collimation lens 120, a beam splitter 130, a receiving unit 140, and a control unit 150. The following describes in detail the several modules or units in the TOF depth sensing module 100.

Array light source 110:

The array light source 110 is configured to generate (emit) a beam.

The array light source 110 includes N light emitting regions, each light emitting region can generate a beam separately, and N is a positive integer greater than 1.

The control unit 150 is configured to control M of the N light emitting regions of the array light source 110 to emit light.

The collimation lens 120 is configured to collimate beams emitted by the M light emitting regions.

The beam splitter 130 is configured to split collimated beams of the collimation lens.

The receiving unit 140 is configured to receive reflected beams of a target object.

M is less than or equal to N, M is a positive integer, and N is a positive integer greater than 1. The beam splitter is specifically configured to split each received beam of light into a plurality of beams of light. The reflected beams of the target object are beams obtained by reflecting beams from the beam splitter by the target object. The beams emitted by the M light emitting regions may also be referred to as beams from the M light emitting regions.

Since M is less than or equal to N, the control unit 150 may control some or all light emitting regions in the array light source 110 to emit light.

The N light emitting regions may be N independent light emitting regions, that is, each of the N light emitting regions may emit light independently or separately without being affected by another light emitting region. For each of the N light emitting regions, each light emitting region generally includes a plurality of light emitting units. In the N light emitting regions, different light emitting regions include different light emitting units, that is, a same light emitting unit belongs to only one light emitting region. For each light emitting region, when the light emitting region is controlled to emit light, all light emitting units in the light emitting region may emit light.

A total quantity of light emitting regions of the array light source may be N. When M=N, the control unit may control all the light emitting regions of the array light source to emit light at the same time or at different times.

Optionally, the control unit is configured to control M of the N light emitting regions of the array light source to emit light at the same time.

For example, the control unit may control M of the N light emitting regions of the array light source to emit light at a moment T0.

Optionally, the control unit is configured to control M of the N light emitting regions of the array light source to respectively emit light at M different moments.

For example, if M=3, the control unit may control three light emitting regions of the array light source to respectively emit light at a moment T0, a moment T1, and a moment T2, that is, in the three light emitting regions, a first light emitting region emits light at the moment T0. a second light emitting region emits light at the moment T1, and a third light emitting region emits light at the moment T2.

Optionally, the control unit is configured to control M of the N light emitting regions of the array light source to separately emit light at M0 different moments. M0 is a positive integer greater than 1 and less than M.

For example, if M=3 and M0=2, the control unit may control one of three light emitting regions of the array light source to emit light at a moment T0, and control the other two light emitting regions of the three light emitting regions of the array light source to emit light at a moment T1.

Different light emitting regions of the array light source are controlled to emit light at different times, and the beam splitter is controlled to split beams, so that a quantity of beams emitted by the TOF depth sensing module within a period of time can be increased, thereby implementing a high spatial resolution and a high frame rate in a process of scanning the target object.

Optionally, a light emitting area of the array light source 110 is less than or equal to $5\times5$ mm$^2$.

When the light emitting area of the array light source 110 is less than or equal to $5\times5$ mm$^2$, an area of the array light source 110 is small, so that a space occupied by the TOF depth sensing module 100 can be reduced, and the TOF depth sensing module 100 can be installed in a terminal device with a limited space.

Optionally, the array light source 110 may be a semiconductor laser light source.

The array light source 110 may be a vertical cavity surface emitting laser (vertical cavity surface emitting laser, VCSEL).

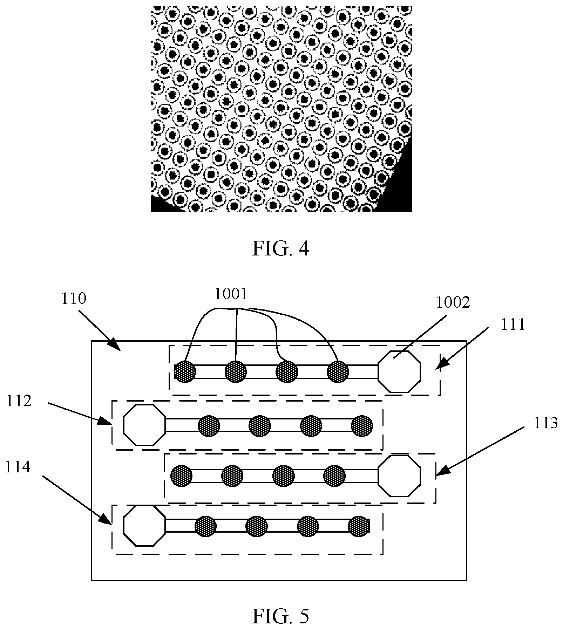

FIG. 5 is a schematic diagram of a VCSEL. As shown in FIG. 5, the VCSEL includes a large quantity of light emitting points (blackspot regions in FIG. 5), and each light emitting point may emit light under the control of the control unit.

Optionally, the light source may be a Fabry-Perot laser (which may be referred to as an FP laser for short).

A single FP laser can implement a larger power than a single VCSEL, and has higher electro-optical conversion efficiency than the VCSEL, thereby improving a scanning effect.

Optionally, a wavelength of the beam emitted by the array light source 110 is greater than 900 nm.

Because intensity of light whose wavelength is greater than 900 nm in sunlight is weak, when the wavelength of the beam is greater than 900 nm, interference caused by the sunlight can be reduced, thereby improving a scanning effect of the TOF depth sensing module.

Optionally, a wavelength of the beam emitted by the array light source 110 is 940 nm or 1550 nm.

Because intensity of light whose wavelength is near 940 nm or 1550 nm in sunlight is weak, when the wavelength of the beam is 940 nm or 1550 nm, interference caused by the sunlight can be greatly reduced, thereby improving a scanning effect of the TOF depth sensing module.

The following describes, in detail with reference to FIG. 5, the array light source 110 including a plurality of independent light emitting regions.

As shown in FIG. 5, the array light source 110 includes light emitting regions 111, 112, 113, and 114 that are independent of each other. There are several light emitting units 1001 in each region, and the several light emitting units 1001 in each region are connected by a common electrode 1002. Light emitting units in different light emitting regions are connected to different electrodes, so that the different regions are independent of each other.

For the array light source 110 shown in FIG. 5, the independent light emitting regions 111, 112, 113 and 114 may be controlled by using the control unit 150 to separately emit light at different moments. For example, the control unit 150 may control the light emitting regions 111, 112, 113 and 114 to respectively emit light at moments t0, t1, t2, and t3.

Optionally, the collimated beam of the collimation lens 120 may be quasi-parallel light whose divergence angle is less than 1 degree.

The collimation lens 120 may include one or more lenses. When the collimation lens 120 includes a plurality of lenses, the collimation lens 120 can effectively reduce an aberration generated in the collimation process.

The collimation lens 120 may be made of a plastic material, or may be made of a glass material, or may be made of a plastic material and a glass material. When the collimation lens 120 is made of a glass material, the collimation lens can reduce impact of a temperature on a back focal length of the collimation lens 120 in a process of collimating a beam.

Specifically, because a coefficient of thermal expansion of the glass material is small, when the collimation lens 120 uses the glass material, impact of a temperature on the back focal length of the collimation lens 120 can be reduced.

Optionally, a clear aperture of the collimation lens 120 is less than or equal to 5 mm.

When the clear aperture of the collimation lens 120 is less than or equal to 5 mm, an area of the collimation lens 120 is small, so that a space occupied by the TOF depth sensing module 100 can be reduced, and the TOF depth sensing module 100 can be installed in a terminal device with a limited space.

As shown in FIG. 3, the receiving unit 140 may include a receiving lens 141 and a sensor 142. The receiving lens 141 is configured to converge the reflected beams to the sensor 142.

The sensor 142 may also be referred to as a sensor array, and the sensor array may be a two-dimensional sensor array.

Optionally, a resolution of the sensor 142 is greater than or equal to $P \times Q$, and a quantity of beams obtained after the beam splitter splits a beam emitted by a light emitting region of the array light source 110 is $P \times Q$. Both P and Q are positive integers.

The resolution of the sensor is greater than or equal to the quantity of beams obtained after the beam splitter 130 splits a beam from a light emitting region of the array light source, so that the sensor 142 can receive reflected beams that are obtained by reflecting beams from the beam splitter by the target object, and the TOF depth sensing module can normally receive the reflected beams.

Optionally, the beam splitter 130 may be a one-dimensional beam splitter, or may be a two-dimensional beam splitter.

In an actual application, a one-dimensional beam splitter or a two-dimensional beam splitter may be selected as required.

Specifically, when the emergent beam needs to be split in only one dimension, a one-dimensional beam splitter may be used. When the emergent beam needs to be split in two dimensions, a two-dimensional beam splitter needs to be used.

When the beam splitter 130 is a one-dimensional beam splitter, the beam splitter 130 may be specifically a cylindrical lens array or a one-dimensional grating.

When the beam splitter 130 is a two-dimensional beam splitter, the beam splitter 130 may be specifically a microlens array or a two-dimensional diffractive optical element (diffractive optical element, DOE).

The beam splitter 130 may be made of a resin material or a glass material, or may be made of a resin material and a glass material.

When a component of the beam splitter 130 includes a glass material, impact of a temperature on performance of the beam splitter 130 can be effectively reduced, so that the beam splitter 130 maintains stable performance. Specifically, when a temperature changes, a coefficient of thermal expansion of glass is lower than that of resin. Therefore, when the beam splitter 130 uses the glass material, performance of the beam splitter is more stable.

Optionally, an area of a beam incident end surface of the beam splitter 130 is less than $5 \times 5$ mm$^2$.

When the area of the beam incident end surface of the beam splitter 130 is less than $5 \times 5$ mm$^2$, an area of the beam splitter 130 is small, so that a space occupied by the TOF depth sensing module 100 can be reduced, and the TOF depth sensing module 100 can be installed in a terminal device with a limited space.

Optionally, a beam receiving surface of the beam splitter 130 is parallel to a beam emitting surface of the array light source 110.

When the beam receiving surface of the beam splitter 130 is parallel to the beam emitting surface of the array light source 110, the beam splitter 130 can more efficiently receive the beam emitted by the array light source 110, thereby improving beam receiving efficiency of the beam splitter 130.

As shown in FIG. 3, the receiving unit 140 may include a receiving lens 141 and a sensor 142. The following describes, by using a specific example, a manner in which the receiving unit receives a beam.

For example, if the array light source 110 includes four light emitting regions, the receiving lens 141 may be respectively configured to receive a reflected beam 1, a reflected beam 2, a reflected beam 3, and a reflected beam 4 that are obtained by reflecting, by the target object, beams respectively generated by the beam splitter 130 at four different moments (t4, t5, t6, and t7), and propagate the reflected beam 1, the reflected beam 2, the reflected beam 3, and the reflected beam 4 to the sensor 142.

Optionally, the receiving lens 141 may include one or more lenses.

When the receiving lens 141 includes a plurality of lenses, an aberration generated when the receiving lens 141 receives a beam can be effectively reduced.

In addition, the receiving lens 141 may be made of a resin material or a glass material, or may be made of a resin material and a glass material.

When the receiving lens 141 includes a glass material, impact of a temperature on a rear focal length of the receiving lens 141 can be effectively reduced.

The sensor 142 may be configured to receive the beam propagated by the receiving lens 141, and perform optical-to-electrical conversion on the beam propagated by the receiving lens 141, to convert an optical signal into an electrical signal. This facilitates subsequent calculation of a time difference (the time difference may be referred to as a time of flight of the beam) between when the transmit end emits the beam and when the receive end receives the beam, and calculation of a distance between the target object and the TOF depth sensing module based on the time difference, to obtain a depth image of the target object.

The sensor 142 may be a single-photon avalanche diode (single-photon avalanche diode, SPAD) array.

The SPAD is an avalanche photodiode working in a Geiger mode (a bias voltage is higher than a breakdown voltage). After a single photon is received, an avalanche effect may occur, and a pulsed current signal is generated instantaneously to detect a time of arrival of the photon. Since the SPAD array used for the TOF depth sensing module requires a complex quench circuit, timing circuit, and storage and reading units, an existing SPAD array used for TOF depth sensing has a limited resolution.

When the distance between the target object and the TOF depth sensing module is far, intensity of reflected light of the target object that is propagated by the receiving lens to the sensor is generally weak, and the sensor needs to have high detection sensitivity. Since the SPAD has single-photon detection sensitivity and a response time on the order of picoseconds, using the SPAD as the sensor 142 in this application can improve sensitivity of the TOF depth sensing module.

The control unit 150 may control the sensor 142 in addition to the array light source 110.

The control unit 150 may be electrically connected to the array light source 110 and the sensor 142, to control the array light source 110 and the sensor 142.

Specifically, the control unit 150 may control a working manner of the sensor 142, so that at M different moments, a corresponding region of the sensor can respectively receive a reflected beam that is obtained by reflecting, by the target object, a beam emitted by a corresponding light emitting region of the array light source 110.

Specifically, a part that is of the reflected beam of the target object and that is located within a numerical aperture of the receiving lens is received by the receiving lens, and propagated to the sensor. With the design of the receiving lens, each pixel of the sensor can receive reflected beams of different regions of the target object.

In this application, the array light source is controlled in regions to emit light, and the beam splitter perform splitting, so that a quantity of beams emitted by the TOF depth sensing module at a same moment can be increased, thereby improving a spatial resolution and a high frame rate of a finally obtained depth image of the target object.

It should be understood that, as shown in FIG. 2, for the TOF depth sensing module, both the projection end and the receive end in the TOF depth sensing module may be located on a same side of the target object.

Optionally, an output optical power of the TOF depth sensing module 100 is less than or equal to 800 mw.

Specifically, a maximum output optical power or an average output power of the TOF depth sensing module 100 is less than or equal to 800 mw.

When the output optical power of the TOF depth sensing module 100 is less than or equal to 800 mw, the TOF depth sensing module 100 has small power consumption, and can be disposed in a device sensitive to power consumption, such as a terminal device.

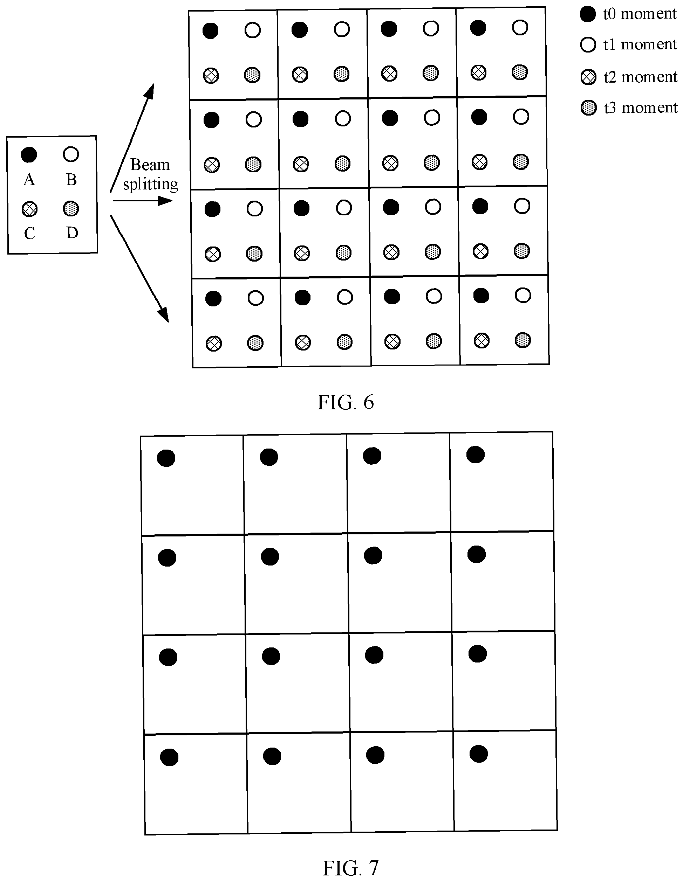

The following describes, in detail with reference to FIG. 6 to FIG. 10, a process in which the TOF depth sensing module 100 obtains a depth image of the target object.

As shown in FIG. 6, a left diagram is a schematic diagram of a light emitting region of the array light source 110. The array light source 110 includes four light emitting regions A, B, C, and D, and the four light emitting regions are respectively turned on at moments t0, t1, t2, and t3. A right diagram is a schematic diagram of a surface of the target object to which a beam generated by the array light source 110 is projected after split by the beam splitter 130. Each spot represents a projected light spot, and a region surrounded by each black solid-line box is a target region corresponding to a pixel in the sensor 142. In FIG. 6, a corresponding replication order of the beam splitter 130 is 4×4, that is, at each moment, a luminous spot generated by a region of the array light source becomes 4×4 spots after replicated by the beam splitter 130. Therefore, with the beam splitter 130, a quantity of light spots projected at a same moment can be greatly increased.

In FIG. 6, depth images of different positions of the target object can be obtained by respectively turning on the four light emitting regions of the array light source 110 at the moments t0, t1, t2, and t3.

Specifically, a schematic diagram of the surface of the target object to which a beam emitted by the light emitting region A of the array light source 110 at the moment t0 is projected after split by the beam splitter 130 is shown in FIG. 7.

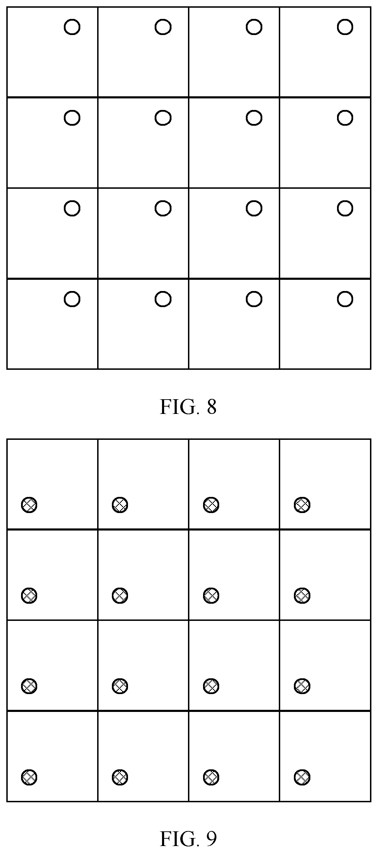

A schematic diagram of the surface of the target object to which a beam emitted by the light emitting region B of the array light source 110 at the moment t1 is projected after split by the beam splitter 130 is shown in FIG. 8.

A schematic diagram of the surface of the target object to which a beam emitted by the light emitting region C of the array light source 110 at the moment t2 is projected after split by the beam splitter 130 is shown in FIG. 9.

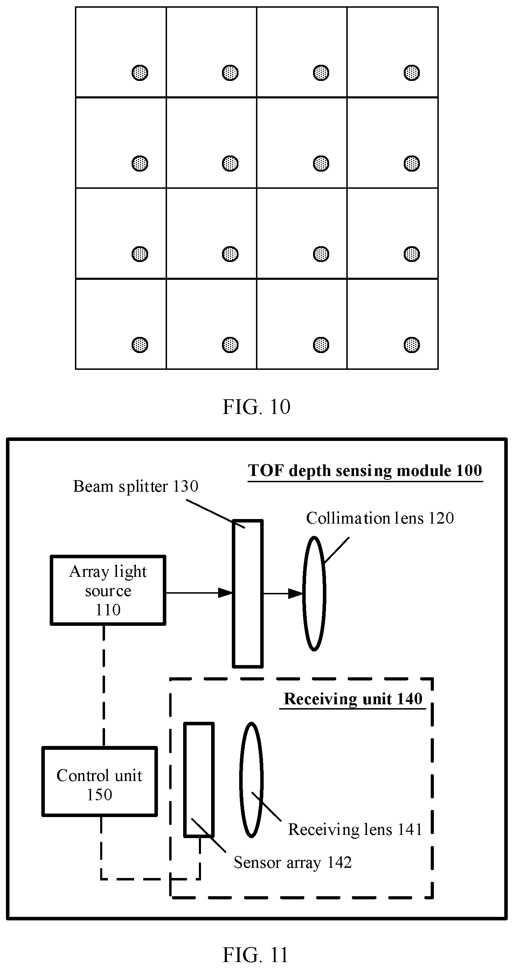

A schematic diagram of the surface of the target object to which a beam emitted by the light emitting region D of the array light source 110 at the moment t3 is projected after split by the beam splitter 130 is shown in FIG. 10.

Depth images corresponding to the target object at the moments t0, t1, t2, and t3 may be obtained based on beam projection shown in FIG. 7 to FIG. 10, and then the depth images corresponding to the target object at the moments t0, t1, t2, and t3 may be superimposed, to obtain a depth image of the target object with a higher resolution.

In the TOF depth sensing module 100 shown in FIG. 3, the collimation lens 120 may be located between the array light source 110 and the beam splitter 130. The beam emitted by the array light source 110 is first collimated by the collimation lens 120, and then a collimated beam is processed by the beam splitter.

Optionally, for the TOF depth sensing module 100, alternatively, the beam splitter 130 may first directly split the beam generated by the array light source 110, and then split beams are collimated by the collimation lens 120.

A detailed description is provided below with reference to FIG. 11. Specific functions of modules or units in a TOF depth sensing module 100 shown in FIG. 11 are as follows:

A control unit 150 is configured to control M of N light emitting regions of an array light source 110 to emit light.

A beam splitter 130 is configured to split beams emitted by the M light emitting regions.

A collimation lens 120 is configured to collimate beams emitted by the beam splitter 130.

A receiving unit 140 is configured to receive reflected beams of a target object.

M is less than or equal to N, M is a positive integer, and N is a positive integer greater than 1. The beam splitter 130 is specifically configured to split each received beam of light into a plurality of beams of light. The reflected beams of the target object are beams obtained by reflecting, by the target object, beams emitted by the collimation lens 120. The beams emitted by the M light emitting regions may also be referred to as beams from the M light emitting regions.

A main difference between the TOF depth sensing module shown in FIG. 11 and the TOF depth sensing module shown in FIG. 3 lies in different positions of the collimation lens. In the TOF depth sensing module shown in FIG. 3, the collimation lens is located between the array light source and the beam splitter, while in the TOF depth sensing module shown in FIG. 11, the beam splitter is located between the array light source and the collimation lens (which is equivalent to that the collimation lens is located in a direction in which the beam splitter emits beams).

Manners in which the TOF depth sensing module 100 shown in FIG. 11 and the TOF depth sensing module 100 shown in FIG. 3 process the beam emitted by the array light source 110 are slightly different. In the TOF depth sensing module 100 shown in FIG. 3, after the array light source 110 emits the beam, the collimation lens 120 and the beam splitter 130 sequentially perform collimation and splitting. In the TOF depth sensing module 100 shown in FIG. 11, after the array light source 110 emits the beam, the beam splitter 130 and the collimation lens 120 sequentially perform splitting and collimation.

The following describes, with reference to an accompanying drawing, splitting performed by the beam splitter 130 on the beam emitted by the array light source.

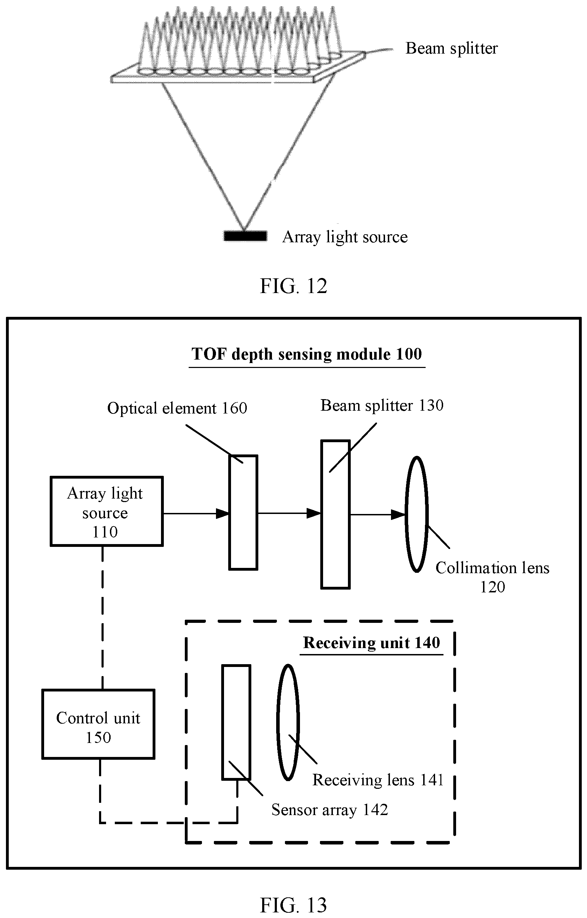

As shown in FIG. 12, after a plurality of beams generated by the array light source 110 are split by the beam splitter 130, each beam generated by the array light source 110 may be split into a plurality of beams. Finally, after the splitting, more beams are obtained.

Based on the TOF depth sensing module shown in FIG. 11, the TOF depth sensing module 100 may further include an optical element. A refractive index of the optical element is controllable. The optical element can adjust a beam in a single polarization state to different directions by using different refractive indexes of the optical element, so that different beams can irradiate in different directions without mechanical rotation and vibration, and a scanned region of interest can be quickly located.

FIG. 13 is a schematic diagram of a structure of a TOF depth sensing module.

Specific functions of modules or units in the TOF depth sensing module 100 shown in FIG. 13 are as follows:

A control unit 150 is configured to control M of N light emitting regions of an array light source 110 to emit light.

The control unit 150 is further configured to control a birefringence parameter of an optical element 160, to change propagation directions of beams emitted by the M light emitting regions.

A beam splitter 130 is configured to receive beams emitted by the optical element 160, and split the beams emitted by the optical element 160.

Optionally, the beam splitter 130 is specifically configured to split each received beam of light into a plurality of beams of light. A quantity of beams obtained after the beam splitter 130 splits a beam emitted by a light emitting region of the array light source 110 may be P×Q.

A collimation lens 120 is configured to collimate beams emitted by the beam splitter 130.

The receiving unit 140 is configured to receive reflected beams of a target object.

The reflected beams of the target object are beams obtained by reflecting, by the target object, the beams emitted by the beam splitter 130. The beams emitted by the M light emitting regions may also be referred to as beams from the M light emitting regions.

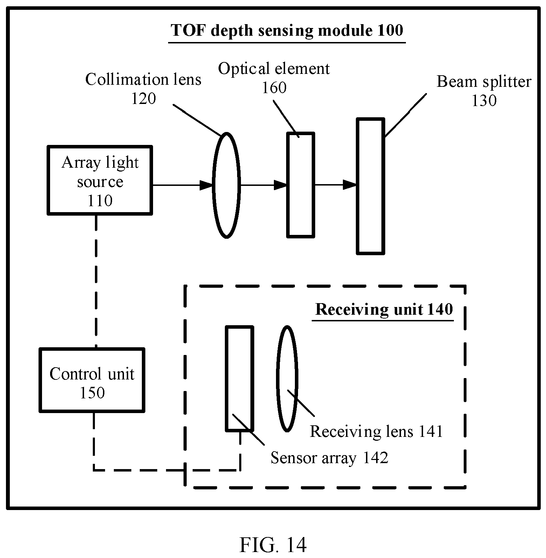

In FIG. 13, the optical element 160 is located between the array light source 110 and the beam splitter 130. Actually, the optical element 160 may alternatively be located between the collimation lens 120 and the beam splitter 130, which is described below with reference to FIG. 14.

FIG. 14 is a schematic diagram of a structure of a TOF depth sensing module.

Specific functions of modules or units in the TOF depth sensing module 100 shown in FIG. 14 are as follows:

A control unit 150 is configured to control M of N light emitting regions of an array light source 110 to emit light.

A collimation lens 120 is configured to collimate beams emitted by the M light emitting regions.

The control unit 150 is further configured to control a birefringence parameter of an optical element 160, to change propagation directions of collimated beams of the collimation lens 120.

A beam splitter 130 is configured to receive beams emitted by the optical element 160, and split the beams emitted by the optical element 160.

Optionally, the beam splitter 130 is specifically configured to split each received beam of light into a plurality of beams of light. A quantity of beams obtained after the beam splitter 130 splits a beam emitted by a light emitting region of the array light source 110 may be P×Q.

The receiving unit 140 is configured to receive reflected beams of a target object.

The reflected beams of the target object are beams obtained by reflecting, by the target object, beams emitted by the beam splitter 130. The beams emitted by the M light emitting regions may also be referred to as beams from the M light emitting regions.

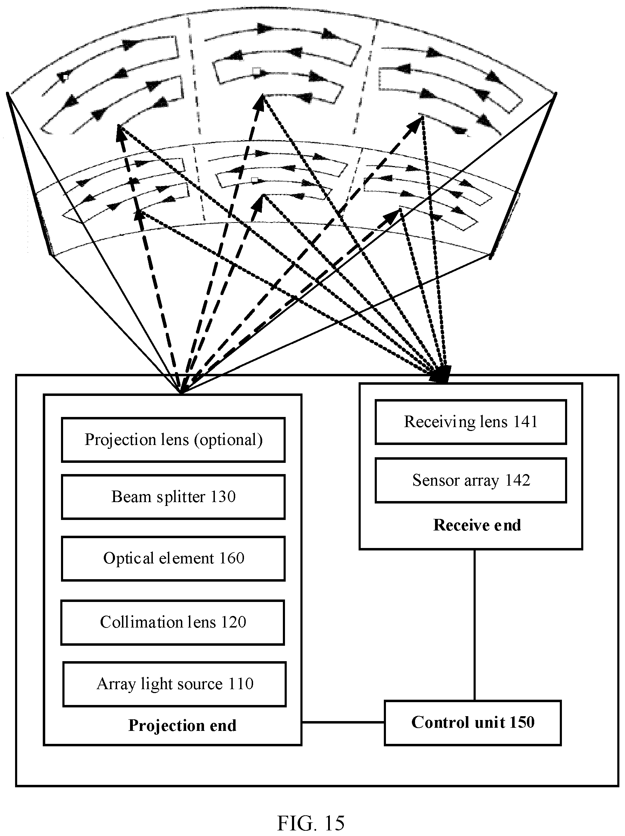

The following describes in detail a working process of the TOF depth sensing module with reference to FIG. 15.

FIG. 15 is a schematic diagram of working of a TOF depth sensing module.

As shown in FIG. 15, the TOF depth sensing module includes a projection end, a receive end, and a control unit. The control unit is configured to control the projection end to emit an emergent beam, to scan a target region. The control unit is further configured to control the receive end to receive a reflected beam obtained through reflection from the scanned target region.

The projection end includes an array light source 110, a collimation lens 120, an optical element 160, a beam splitter 130, and a projection lens (optional). The receive end includes a receiving lens 141 and a sensor 142. The control unit 150 is further configured to control timing synchronization of the array light source 110, the optical element 160, and the sensor 142.

The collimation lens 120 in the TOF depth sensing module shown in FIG. 15 may include one to four lenses, and the collimation lens 140 is configured to convert a beam generated by the array light source 110 into approximately parallel light.

A working procedure of the TOF depth sensing module shown in FIG. 15 is as follows:

(1) After collimated by the collimation lens 120, the beam emitted by the array light source 110 forms a collimated beam, which reaches the optical element 160.
(2) The optical element 160 implements orderly deflection of the beam based on timing control of the control unit, so that emitted deflected beams have angles for two-dimensional scanning.
(3) The emitted deflected beams of the optical element 160 reach the beam splitter 130.
(4) The beam splitter 130 replicates a deflected beam at each angle to obtain emergent beams at a plurality of angles, thereby implementing two-dimensional replication of the beam.
(5) In each scanning period, the receive end can image only a target region illuminated by a spot.
(6) After the optical element completes all S×T scans, the two-dimensional array sensor at the receive end generates S×T images, which are finally spliced into an image with a higher resolution in a processor.

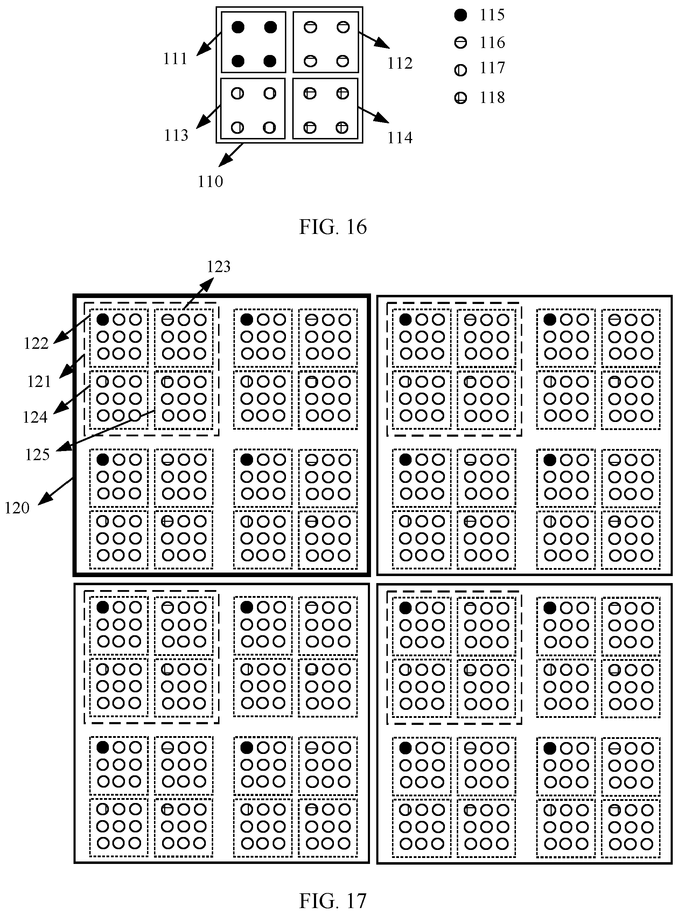

The array light source in the TOF depth sensing module may have a plurality of light emitting regions, and each light emitting region may emit light independently. The following describes, in detail with reference to FIG. 16, a working procedure of the TOF depth sensing module when the array light source of the TOF depth sensing module includes a plurality of light emitting regions.

FIG. 16 is a schematic diagram of a light emitting region of an array light source.

When the array light source 110 includes a plurality of light emitting regions, a working procedure of the TOF depth sensing module is as follows:

(1) Beams emitted by different light emitting regions of the array light source 110 at different times form collimated beams through the collimation lens 120, which reach the beam splitter 130. The beam splitter 130 can be controlled by a timing signal of the control unit to implement orderly deflection of the beams, so that emergent beams can have angles for two-dimensional scanning.
(2) The collimated beams of the collimation lens 120 reach the beam splitter 130. The beam splitter 130 replicates an incident beam at each angle to generate emergent beams at a plurality of angles at the same time, thereby implementing two-dimensional replication of the beam.
(3) In each scanning period, the receive end images only a target region illuminated by a spot.
(4) After the optical element completes all S×T scans, the two-dimensional array sensor at the receive end generates S×T images, which are finally spliced into an image with a higher resolution in a processor.

The following describes in detail a scanning working principle of the TOF depth sensing module with reference to FIG. 16 and FIG. 17.

As shown in FIG. 16, 111, 112, 113, 114 are independent light emitting regions of the array light source, and may be turned on at different times, and 115, 116, 117, 118 are light emitting holes in different independent working regions of the array light source.

FIG. 17 is a schematic diagram of splitting, by using a beam splitter, a beam emitted by the array light source shown in FIG. 16.

As shown in FIG. 17, 120 is a replication order (black solid-line box at an upper left corner of FIG. 17) generated by the beam splitter, 121 is a target region (121 includes 122, 123, 124, and 125) corresponding to a pixel of the two-dimensional array sensor, 122 is a spot generated by the light emitting hole 115 through beam scanning of the beam splitter, 123 is a spot generated by the light emitting hole 116 through beam scanning of the optical element, 124 is a spot generated by the light emitting hole 117 through beam scanning of the optical element, and 125 is a spot generated by the light emitting hole 118 through beam scanning of the optical element.

A specific scanning process of the TOF depth sensing module having the array light source shown in FIG. 16 is as follows:

Only 115 is turned on, and the optical element performs beam scanning respectively to achieve the spot 122.

115 is turned off, 116 is turned on, and the optical element performs beam scanning respectively to achieve the spot 123.

116 is turned off, 117 is turned on, and the optical element performs beam scanning respectively to achieve the spot 124.

117 is turned off, 118 is turned on, and the optical element performs beam scanning respectively to achieve the spot 125.

Spot scanning of a target region corresponding to a pixel of the two-dimensional array sensor may be completed by performing the foregoing four steps.

The optical element 160 in FIG. 13 to FIG. 15 may be any one of components such as a liquid crystal polarization grating, an electro-optic component, an acousto-optic component, and an optical phased array component. For detailed descriptions of the components such as the liquid crystal polarization grating, the electro-optic component, the acousto-optic component, and the optical phased array component, refer to related descriptions in the following first case to fourth case.

The foregoing describes in detail a TOF depth sensing module with reference to accompanying drawings, and the following describes an image generation method with reference to accompanying drawings.

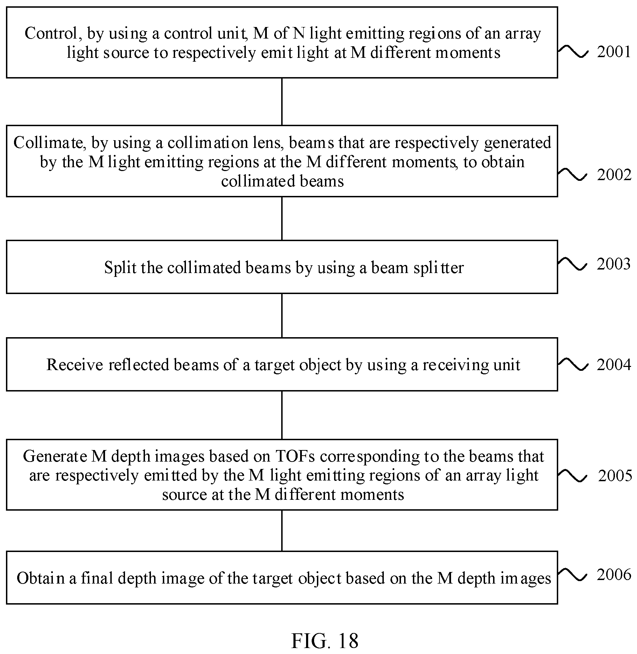

FIG. 18 is a schematic flowchart of an image generation method. The method shown in FIG. 18 may be performed by a terminal device including a TOF depth sensing module. Specifically, the method shown in FIG. 18 may be performed by a terminal device including the TOF depth sensing module shown in FIG. 3. The method shown in FIG. 18 includes steps 2001 to 2006, which are described in detail below.

2001. Control, by using the control unit, M of the N light emitting regions of the array light source to respectively emit light at M different moments.

M is less than or equal to N, M is a positive integer, and N is a positive integer greater than 1.

In step 2001, light emission of the array light source may be controlled by using the control unit.

Specifically, the control unit may respectively send control signals to the M light emitting regions of the array light source at the M moments, to control the M light emitting regions to respectively emit light at the M different moments.

For example, as shown in FIG. 6, the array light source 110 includes four independent light emitting regions A, B, C, and D. In this case, the control unit may respectively send control signals to the four independent light emitting regions A, B, C, and D at moments t0, t1, t2, and t3, so that the four independent light emitting regions A, B, C, and D respectively emit light at the moments t0, t1, t2, and t3.

2002. Collimate, by using the collimation lens, beams that are respectively generated by the M light emitting regions at the M different moments, to obtain collimated beams.

FIG. 6 is still used as an example. When the four independent light emitting regions A, B, C, and D of the array light source respectively emit beams at the moments t0, t1, t2, and t3, the collimation lens may collimate the beams that are respectively emitted by the light emitting regions A, B, C, and D at the moments t0, t1, t2, and t3, to obtain collimated beams.

2003. Split the collimated beams by using the beam splitter.

The beam splitter may specifically split each received beam of light into a plurality of beams of light. A quantity of beams obtained after the beam splitter splits a beam from a light emitting region of the array light source may be P×Q.

As shown in FIG. 6, the light emitting regions A, B, C, and D of the array light source respectively emit beams at the moments t0, t1, t2, and t3. In this case, the beams respectively emitted by the light emitting regions A, B, C, and D at the moments t0, t1, t2, and t3 are processed by the collimation lens, and then incident into the beam splitter for processing. A result of splitting performed for the light emitting regions A, B, C, and D by the beam splitter may be shown on a right side of FIG. 6.

Optionally, the splitting in step 2003 specifically includes: performing one-dimensional or two-dimensional splitting on the collimated beams by using the beam splitter.

2004. Receive reflected beams of a target object by using the receiving unit.

The reflected beams of the target object are beams obtained by reflecting beams from the beam splitter by the target object.

Optionally, the receiving unit in step 2004 includes a receiving lens and a sensor. The receiving reflected beams of a target object by using the receiving unit in step 2004 includes: converging the reflected beams of the target object to the sensor by using the receiving lens. The sensor herein may also be referred to as a sensor array, and the sensor array may be a two-dimensional sensor array.

Optionally, a resolution of the sensor is greater than or equal to $P \times Q$, and a quantity of beams obtained after the beam splitter splits a beam from a light emitting region of the array light source is $P \times Q$.

Both P and Q are positive integers. The resolution of the sensor is greater than or equal to the quantity of beams obtained after the beam splitter splits a beam from a light emitting region of the array light source, so that the sensor can receive reflected beams that are obtained by reflecting beams from the beam splitter by the target object, and the TOF depth sensing module can normally receive the reflected beams.

2005. Generate M depth images based on TOFs corresponding to the beams that are respectively emitted by the M light emitting regions of the array light source at the M different moments.

The TOF corresponding to the beams that are respectively emitted by the M light emitting regions of the array light source at the M different moments may specifically refer to time difference information between emission moments of the beams respectively emitted by the M light emitting regions of the array light source at the M different moments and reception moments of corresponding reflected beams.

For example, the array light source includes three light emitting regions A, B, and C, the light emitting region A emits a beam at a moment T0, the light emitting region B emits a beam at a moment T1, and the light emitting region C emits a beam at a moment T2. In this case, a TOF corresponding to the beam that is emitted by the light emitting region A at the moment T0 may specifically refer to time difference information between the moment T0 and a moment at which the beam emitted by the light emitting region A at the moment T0 finally reaches the receiving unit (or is received by the receiving unit) after collimated by the collimation lens, split by the beam splitter, and reflected by the target object when reaching the target object. A TOF corresponding to the beam that is emitted by the light emitting region B at the moment T1 and a TOF corresponding to the beam that is emitted by the light emitting region C at the moment T2 have similar meanings. Optionally, the M depth images are respectively depth images corresponding to M regions of the target object, and there is a non-overlap region between any two of the M regions.

Optionally, the generating M depth images of the target object in step 2005 specifically includes:

2005a. Determine distances between the TOF depth sensing module and M regions of the target object based on the TOFs corresponding to the beams that are respectively emitted by the M light emitting regions at the M different moments.

2005b. Generate depth images of the M regions of the target object based on the distances between the TOF depth sensing module and the M regions of the target object.

2006. Obtain a final depth image of the target object based on the M depth images.

Specifically, in step 2006, the M depth images may be spliced to obtain the depth image of the target object.

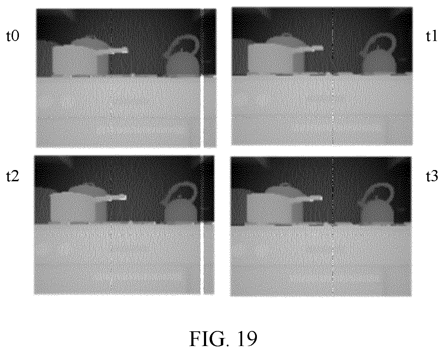

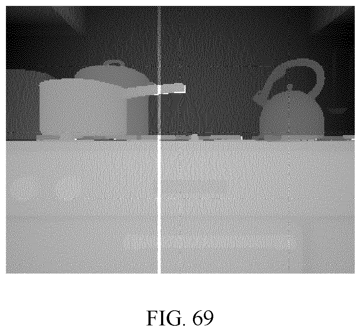

For example, depth images of the target object at the moments t0 to t3 are obtained by performing steps 2001 to 2005. The depth images at the four moments are shown in FIG. 19. The depth images at the moments t0 to t3 shown in FIG. 19 are spliced to obtain a final depth image of the target object, which may be shown in FIG. 69.

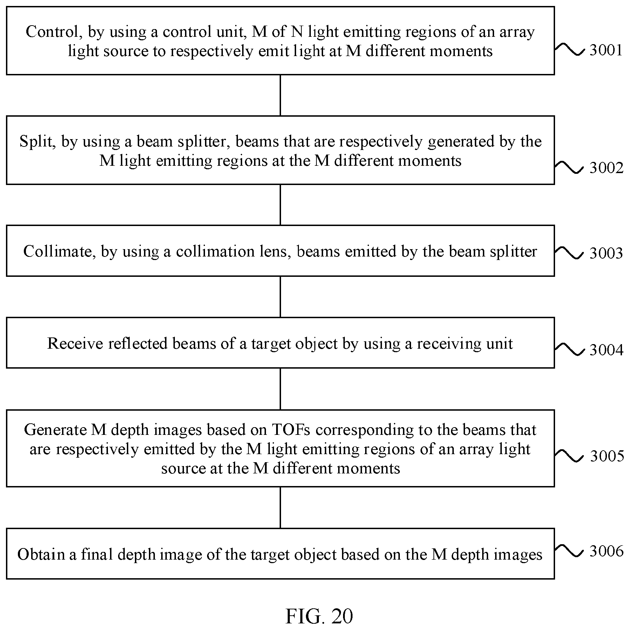

Different structures of the TOF depth sensing module correspond to different processes of the image generation method. The following describes in detail an image generation method with reference to FIG. 20.

FIG. 20 is a schematic flowchart of an image generation method. The method shown in FIG. 20 may be performed by a terminal device including a TOF depth sensing module. Specifically, the method shown in FIG. 20 may be performed by a terminal device including the TOF depth sensing module shown in FIG. 11. The method shown in FIG. 20 includes steps 3001 to 3006, which are described in detail below.

3001. Control, by using the control unit, M of the N light emitting regions of the array light source to respectively emit light at M different moments.

The N light emitting regions do not overlap each other, M is less than or equal to N, M is a positive integer, and N is a positive integer greater than 1.

The controlling, by using the control unit, M of the N light emitting regions of the array light source to respectively emit light at M different moments may be specifically controlling, by using the control unit, the M light emitting regions to sequentially emit light at the M different moments.

For example, as shown in FIG. 16, the array light source includes four light emitting regions 111, 112, 113, and 114. In this case, the control unit may control 111, 112, and 113 to respectively emit light at moments T0, T1, and T2. Alternatively, the control unit may control 111, 112, 113, and 114 to respectively emit light at moments T0, T1, T2, and T3.

3002. Split, by using the beam splitter, beams that are respectively generated by the M light emitting regions at the M different moments.

The beam splitter is specifically configured to split each received beam of light into a plurality of beams of light.

The splitting, by using the beam splitter, beams that are respectively generated by the M light emitting regions at the M different moments may be specifically respectively splitting, by using the beam splitter, the beams that are generated by the M light emitting regions at the M different moments.

For example, as shown in FIG. 16, the array light source includes four light emitting regions 111, 112, 113, and 114, and the control unit may control 111, 112, and 113 to respectively emit light at moments T0, T1, and T2. In this case, the beam splitter may split a beam that is emitted by 111 at the moment T0, split a beam that is emitted by 112 at the moment T1, and split a beam that is emitted by 113 at the moment T2 (it should be understood that, a time required by the beam to reach the beam splitter from the light emitting region is omitted herein).

Optionally, the splitting in step 3002 specifically includes: respectively performing, by using the beam splitter, one-dimensional or two-dimensional splitting on the beams that are generated by the M light emitting regions at the M different moments.

3003. Collimate beams from the beam splitter by using the collimation lens.

For example, FIG. 16 is still used as an example. The beam splitter respectively split the beams that are emitted by 111, 112, and 113 at the moments T0, T1, and T2. In this case, the collimation lens may collimate, at the moment T0, beams obtained after the beam splitter performs splitting for 111, collimate, at the moment T1, beams obtained after the beam splitter performs splitting for 112, and collimate, at the moment T2, beams obtained after the beam splitter performs splitting for 113.

3004. Receive reflected beams of a target object by using the receiving unit.

The reflected beams of the target object are beams obtained by reflecting beams from the collimation lens by the target object.

Optionally, the receiving unit in step 3004 includes a receiving lens and a sensor. The receiving reflected beams of a target object by using the receiving unit in step 3004 includes: converging the reflected beams of the target object to the sensor by using the receiving lens. The sensor herein may also be referred to as a sensor array, and the sensor array may be a two-dimensional sensor array.

Optionally, a resolution of the sensor is greater than or equal to $P \times Q$, and a quantity of beams obtained after the beam splitter splits a beam from a light emitting region of the array light source is $P \times Q$.

Both P and Q are positive integers. The resolution of the sensor is greater than or equal to the quantity of beams obtained after the beam splitter splits a beam from a light emitting region of the array light source, so that the sensor can receive reflected beams that are obtained by reflecting beams from the beam splitter by the target object, and the TOF depth sensing module can normally receive the reflected beams.

3005. Generate M depth images based on TOFs corresponding to the beams that are respectively emitted by the M light emitting regions of the array light source at the M different moments.

The TOF corresponding to the beams that are respectively emitted by the M light emitting regions of the array light source at the M different moments may specifically refer to time difference information between emission moments of the beams respectively emitted by the M light emitting regions of the array light source at the M different moments and reception moments of corresponding reflected beams.

For example, the array light source includes three light emitting regions A, B, and C, the light emitting region A emits a beam at a moment T0, the light emitting region B emits a beam at a moment T1, and the light emitting region C emits a beam at a moment T2. In this case, a TOF corresponding to the beam that is emitted by the light emitting region A at the moment T0 may specifically refer to time difference information between the moment T0 and a moment at which the beam emitted by the light emitting region A at the moment T0 finally reaches the receiving unit (or is received by the receiving unit) after collimated by the collimation lens, split by the beam splitter, and reflected by the target object when reaching the target object. A TOF corresponding to the beam that is emitted by the light emitting region B at the moment T1 and a TOF corresponding to the beam that is emitted by the light emitting region C at the moment T2 have similar meanings.

The M depth images are respectively depth images corresponding to M regions of the target object, and there is a non-overlap region between any two of the M regions.

Optionally, the generating M depth images in step 3005 specifically includes:

3005a. Determine distances between the TOF depth sensing module and M regions of the target object based on the TOFs corresponding to the beams that are respectively emitted by the M light emitting regions at the M different moments.

3005b. Generate depth images of the M regions of the target object based on the distances between the TOF depth sensing module and the M regions of the target object.

3006. Obtain a final depth image of the target object based on the M depth images.

Specifically, the obtaining a final depth image of the target object in step 3006 includes: splicing the M depth images to obtain the depth image of the target object.

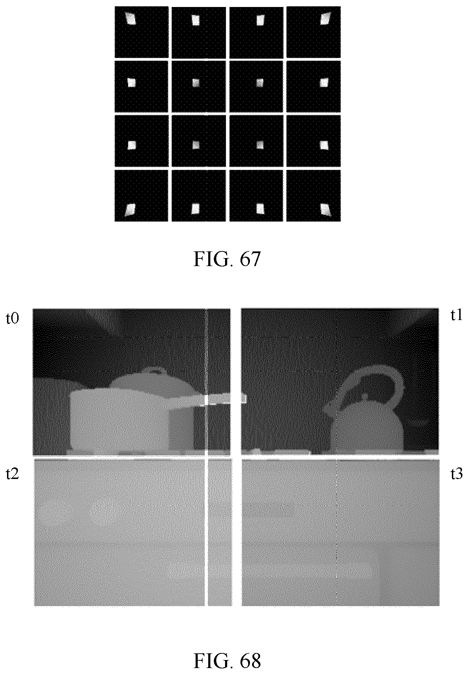

For example, the depth images obtained in the process of steps 3001 to 3005 may be shown in FIG. 68. FIG. 68 shows depth images corresponding to moments t0 to t3. The depth images corresponding to the moments t0 to t3 may be spliced to obtain a final depth image of the target object, as shown in FIG. 69.

Different light emitting regions of the array light source are controlled to emit light at different times, and the beam splitter is controlled to split beams, so that a quantity of beams emitted by the TOF depth sensing module within a period of time can be increased, a plurality of depth images are obtained, and a final depth image obtained by splicing the plurality of depth images has a high spatial resolution and a high frame rate.

A main processing process of the method shown in FIG. 20 is similar to that of the method shown in FIG. 18, and a main difference lies as follows: In the method shown in FIG. 20, the beam splitter is first used to split the beams emitted by the array light source, and then the collimation lens is used to collimate split beams. In the method shown in FIG. 18, the collimation lens is first used to collimate the beams emitted by the array light source, and then the beam splitter is used to split collimated beams.

When the image generation method is performed by a terminal device, the terminal device may have different working modes, and in different working modes, the array light source has different light emitting manners and different manners of subsequently generating a final depth image of the target object. The following describes, in detail with reference to accompanying drawings, how to obtain a final depth image of the target object in different working modes.

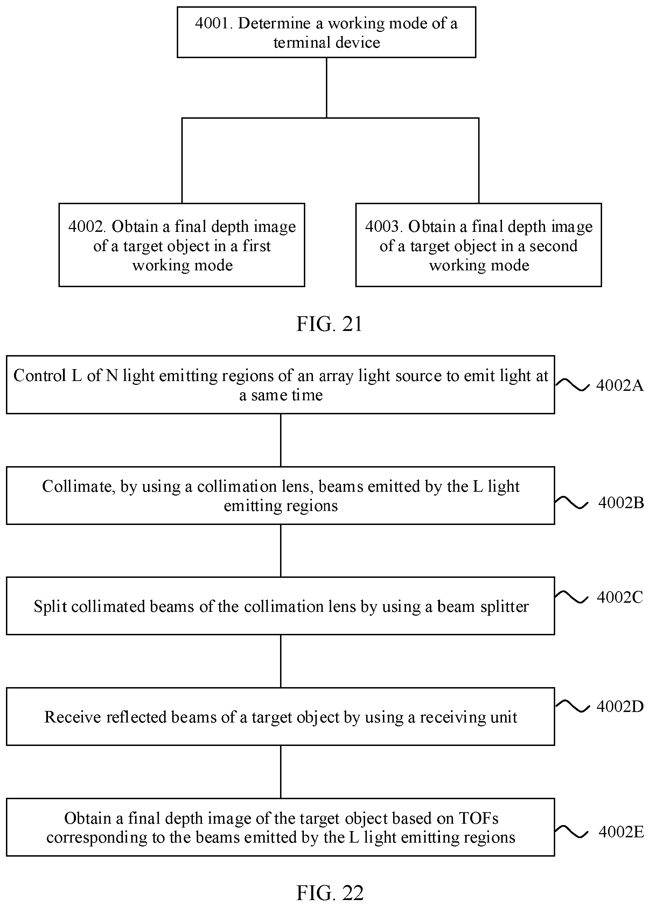

FIG. 21 is a schematic flowchart of an image generation method.

The method shown in FIG. 21 includes steps 4001 to 4003, which are described in detail below.

4001. Determine a working mode of the terminal device.

The terminal device includes a first working mode and a second working mode. In the first working mode, the control unit may control L of the N light emitting regions of the array light source to emit light at the same time. In the second working mode, the control unit may control M of the N light emitting regions of the array light source to emit light at M different moments.

It should be understood that when it is determined in step 4001 that the terminal device works in the first working mode, step 4002 is performed. When it is determined in step 4001 that the terminal device works in the second working mode, step 4003 is performed.

The following describes in detail a specific process of determining a working mode of the terminal device in step 4001.

Optionally, the determining a working mode of the terminal device in step 4001 includes: determining the working mode of the terminal device based on working mode selection information of a user.

The working mode selection information of the user is used to select one of the first working mode and the second working mode as the working mode of the terminal device.

Specifically, when the image generation method is performed by the terminal device, the terminal device may obtain the working mode selection information of the user from the user. For example, the user may input the working mode selection information of the user by using an operation interface of the terminal device.

In the foregoing, the working mode of the terminal device is determined based on the working mode selection information of the user, so that the user can flexibly select and determine the working mode of the terminal device.

Optionally, the determining a working mode of the terminal device in step 4001 includes: determining the working mode of the terminal device based on a distance between the terminal device and the target object.

Specifically, when the distance between the terminal device and the target object is less than or equal to a preset distance, it may be determined that the terminal device works in the first working mode. When the distance between the terminal device and the target object is greater than the preset distance, it may be determined that the terminal device works in the second working mode.

When the distance between the terminal device and the target object is small, the array light source has a sufficient light emitting power to emit a plurality of beams to the target object at the same time. Therefore, when the distance between the terminal device and the target object is small, the first working mode is used so that a plurality of light emitting regions of the array light source can emit light at the same time, to obtain depth information of more regions of the target object subsequently. In this way, a frame rate of a depth image of the target object can be increased at a fixed resolution of the depth image of the target object.

When the distance between the terminal device and the target object is large, because a total power of the array light source is limited, a depth image of the target object may be obtained in the second working mode. Specifically, the array light source is controlled to emit beams at different times, so that the beams emitted by the array light source at different times can also reach the target object. In this way, when the terminal device is far from the target object, depth information of different regions of the target object can still be obtained at different times, to obtain a depth image of the target object.

Optionally, the determining a working mode of the terminal device in step 4001 includes: determining the working mode of the terminal device based on a scene in which the target object is located.

Specifically, when the terminal device is in an indoor scene, it may be determined that the terminal device works in the first working mode. When the terminal device is in an outdoor scene, it may be determined that the terminal device works in the second working mode.

When the terminal device is in an indoor scene, a distance between the terminal device and the target object is small, and external noise is weak. Therefore, the array light source has a sufficient light emitting power to emit a plurality of beams to the target object at the same time. Therefore, when the distance between the terminal device and the target object is small, the first working mode is used so that a plurality of light emitting regions of the array light source can emit light at the same time, to obtain depth information of more regions of the target object subsequently. In this way, a frame rate of a depth image of the target object can be increased at a fixed resolution of the depth image of the target object.

When the terminal device is in an outdoor scene, a distance between the terminal device and the target object is large, external noise is large. Moreover, a total power of the array light source is limited. Therefore, a depth image of the target object may be obtained in the second working mode. Specifically, the array light source is controlled to emit beams at different times, so that the beams emitted by the array light source at different times can also reach the target object. In this way, when the terminal device is far from the target object, depth information of different regions of the target object can still be obtained at different times, to obtain a depth image of the target object.

In the foregoing, the working mode of the terminal device can be flexibly determined based on the distance between the terminal device and the target object or the scene in which the target object is located, so that the terminal device works in an appropriate working mode.

4002. Obtain a final depth image of the target object in the first working mode.

4003. Obtain a final depth image of the target object in the second working mode.

The terminal device has different working modes. Therefore, the first working mode or the second working mode may be selected based on different situations to generate the depth image of the target object, thereby improving flexibility of generating the depth image of the target object. In addition, in both working modes, a high-resolution depth image of the target object can be obtained.

The following describes, in detail with reference to FIG. 22, a process of obtaining a final depth image of the target object in the first working mode.

FIG. 22 is a schematic flowchart of obtaining a final depth image of the target object in the first working mode. A process shown in FIG. 22 includes steps 4002A to 4002E, which are described in detail below.

4002A. Control L of the N light emitting regions of the array light source to emit light at the same time.

L is less than or equal to N, L is a positive integer, and N is a positive integer greater than 1.

In step 4002A, the control unit may control L of the N light emitting regions of the array light source to emit light at the same time. Specifically, the control unit may send a control signal to L of the N light emitting regions of the array light source at a moment T, to control the L light emitting regions to emit light at the moment T.

For example, the array light source includes four independent light emitting regions A, B, C, and D. In this case, the control unit may send a control signal to the four independent light emitting regions A, B, C, and D at the moment T, so that the four independent light emitting regions A, B, C, and D emit light at the moment T.

4002B. Collimate, by using the collimation lens, beams emitted by the L light emitting regions.

Assuming that the array light source includes four independent light emitting regions A, B, C, and D, the collimation lens may collimate beams that are emitted by the light emitting regions A, B, C, and D of the array light source at the moment T, to obtain collimated beams.

In step 4002B, the collimation lens collimates the beams, so that approximately parallel beams can be obtained, thereby improving power densities of the beams, and further improving an effect of scanning by the beams subsequently.

4002C. Split collimated beams of the collimation lens by using the beam splitter.

The beam splitter is specifically configured to split each received beam of light into a plurality of beams of light.

4002D. Receive reflected beams of the target object by using the receiving unit.

The reflected beams of the target object are beams obtained by reflecting beams from the beam splitter by the target object.

4002E. Obtain a final depth image of the target object based on TOFs corresponding to the beams emitted by the L light emitting regions.

The TOFs corresponding to the beams emitted by the L light emitting regions may specifically refer to time difference information between the moment T and reception moments of reflected beams corresponding to the beams that are emitted by the L light emitting regions of the array light source at the moment T.

Optionally, the receiving unit includes a receiving lens and a sensor. The receiving reflected beams of a target object by using the receiving unit in step 4002D includes: converging the reflected beams of the target object to the sensor by using the receiving lens.

The sensor may also be referred to as a sensor array, and the sensor array may be a two-dimensional sensor array.

Optionally, a resolution of the sensor is greater than P×Q, and a quantity of beams obtained after the beam splitter splits a beam from a light emitting region of the array light source is P×Q.

Both P and Q are positive integers. The resolution of the sensor is greater than the quantity of beams obtained after the beam splitter splits a beam from a light emitting region of the array light source, so that the sensor can receive reflected beams that are obtained by reflecting beams from the beam splitter by the target object, and the TOF depth sensing module can normally receive the reflected beams.

Optionally, the obtaining a final depth image of the target object in step 4002E specifically includes:

(1) generating depth images of L regions of the target object based on the TOFs corresponding to the beams emitted by the L light emitting regions; and
(2) synthesizing the depth image of the target object based on the depth images of the L regions of the target object.

The method shown in FIG. 22 may be performed by the TOF depth sensing module shown in FIG. 3 or a terminal device including the TOF depth sensing module shown in FIG. 3.

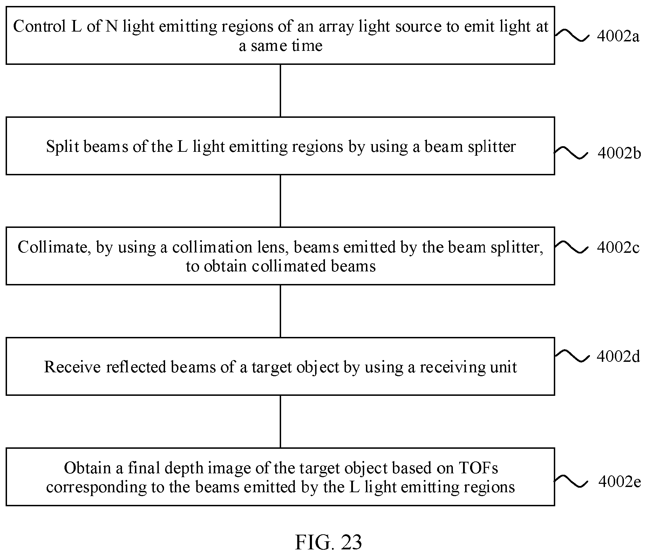

The process of obtaining a final depth image of the target object in the first working mode varies with a relative position relationship between the collimation lens and the beam splitter in the TOF depth sensing module. The following describes, with reference to FIG. 23, a process of obtaining a final depth image of the target object in the first working mode.

FIG. 23 is a schematic flowchart of obtaining a final depth image of the target object in the first working mode. A process shown in FIG. 23 includes steps 4002a to 4002e, which are described in detail below.

4002a. Control L of the N light emitting regions of the array light source to emit light at the same time.

L is less than or equal to N, L is a positive integer, and N is a positive integer greater than 1.

In step 4002a, the control unit may control L of the N light emitting regions of the array light source to emit light at the same time. Specifically, the control unit may send a control signal to L of the N light emitting regions of the array light source at a moment T, to control the L light emitting regions to emit light at the moment T.

For example, the array light source includes four independent light emitting regions A, B, C, and D. In this case, the control unit may send a control signal to the four independent light emitting regions A, B, C, and D at the moment T, so that the four independent light emitting regions A, B, C, and D emit light at the moment T.

4002b. Split beams of the L light emitting regions by using the beam splitter.

The beam splitter is specifically configured to split each received beam of light into a plurality of beams of light.

4002c. Collimate beams from the beam splitter by using the collimation lens, to obtain collimated beams.

4002d. Receive reflected beams of the target object by using the receiving unit.

The reflected beams of the target object are beams obtained by reflecting the collimated beams by the target object.

4002e. Obtain a final depth image of the target object based on TOFs corresponding to the beams emitted by the L light emitting regions.

The TOFs corresponding to the beams emitted by the L light emitting regions may specifically refer to time difference information between the moment T and reception moments of reflected beams corresponding to the beams that are emitted by the L light emitting regions of the array light source at the moment T.

Optionally, the receiving unit includes a receiving lens and a sensor. The receiving reflected beams of a target object by using the receiving unit in step 4002d includes: converging the reflected beams of the target object to the sensor by using the receiving lens.

The sensor may also be referred to as a sensor array, and the sensor array may be a two-dimensional sensor array.

Optionally, a resolution of the sensor is greater than P×Q, and a quantity of beams obtained after the beam splitter splits a beam from a light emitting region of the array light source is P×Q.

Both P and Q are positive integers. The resolution of the sensor is greater than the quantity of beams obtained after the beam splitter splits a beam from a light emitting region of the array light source, so that the sensor can receive reflected beams that are obtained by reflecting beams from the beam splitter by the target object, and the TOF depth sensing module can normally receive the reflected beams.

Optionally, the generating a final depth image of the target object in step 4002e specifically includes:

(1) generating depth images of L regions of the target object based on the TOFs corresponding to the beams emitted by the L light emitting regions; and
(2) synthesizing the depth image of the target object based on the depth images of the L regions of the target object.

The process shown in FIG. 23 and the process shown in FIG. 22 both refer to how to obtain a final depth image of the target object in the first working mode, and a main difference lies as follows: In FIG. 23, the beam splitter is first used to split the beams emitted by the array light source, and then the collimation lens is used to collimate split beams. In FIG. 22, the collimation lens is first used to collimate the beams emitted by the array light source, and then the beam splitter may be used to split collimated beams.

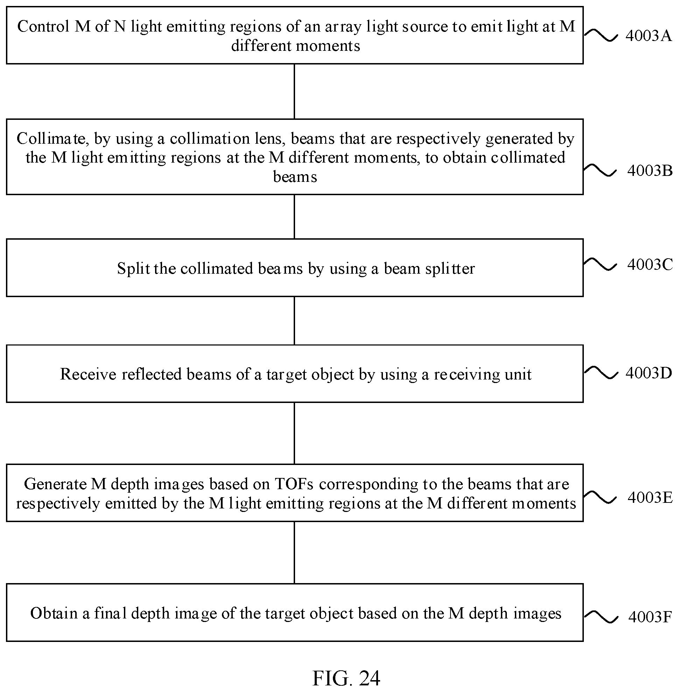

The following describes, in detail with reference to FIG. 24, a process of obtaining a final depth image of the target object in the second working mode.

FIG. 24 is a schematic flowchart of obtaining a final depth image of the target object in the second working mode. A process shown in FIG. 24 includes steps 4003A to 4003E, which are described in detail below.

4003A. Control M of the N light emitting regions of the array light source to emit light at M different moments.

M is less than or equal to N, and both M and N are positive integers.

In step 4003A, light emission of the array light source may be controlled by using the control unit. Specifically, the control unit may respectively send control signals to the M light emitting regions of the array light source at the M moments, to control the M light emitting regions to respectively emit light at the M different moments.

For example, the array light source includes four independent light emitting regions A, B, C, and D. In this case, the control unit may respectively send control signals to three independent light emitting regions A, B, and C at moments t0, t1, and t2, so that the three independent light emitting regions A, B, and C respectively emit light at the moments t0, t1, and t2.

4003B. Collimate, by using the collimation lens, beams that are respectively generated by the M light emitting regions at the M different moments, to obtain collimated beams.

In step 4003B, the collimating, by using the collimation lens, beams that are respectively generated by the M light emitting regions at the M different moments may be specifically respectively collimating, by using the collimation lens, the beams that are generated by the M light emitting regions at the M different moments.

Assuming that the array light source includes four independent light emitting regions A, B, C, and D, and three independent light emitting regions A, B, and C in the array light source emit light at moments t0, t1, and t2 under the control of the control unit, the collimation lens may collimate beams that are respectively emitted by the light emitting regions A, B, and C at the moments t0, t1, and t2.

The collimation lens collimates the beams, so that approximately parallel beams can be obtained, thereby improving power densities of the beams, and further improving an effect of scanning by the beams subsequently.

4003C. Split the collimated beams by using the beam splitter.

4003D. Receive reflected beams of the target object by using the receiving unit.

The beam splitter is specifically configured to split each received beam of light into a plurality of beams of light. The reflected beams of the target object are beams obtained by reflecting beams from the beam splitter by the target object.

4003E. Generate M depth images based on TOFs corresponding to the beams that are respectively emitted by the M light emitting regions at the M different moments.

The TOF corresponding to the beams that are respectively emitted by the M light emitting regions of the array light source at the M different moments may specifically refer to time difference information between emission moments of the beams respectively emitted by the M light emitting regions of the array light source at the M different moments and reception moments of corresponding reflected beams.

4003F. Obtain a final depth image of the target object based on the M depth images.

Optionally, the M depth images are respectively depth images corresponding to M regions of the target object, and there is a non-overlap region between any two of the M regions.

Optionally, the receiving unit includes a receiving lens and a sensor. The receiving reflected beams of a target object by using the receiving unit in step 4003D includes: converging the reflected beams of the target object to the sensor by using the receiving lens.

The sensor may also be referred to as a sensor array, and the sensor array may be a two-dimensional sensor array.

Optionally, a resolution of the sensor is greater than or equal to P×Q, and a quantity of beams obtained after the beam splitter splits a beam from a light emitting region of the array light source is P×Q.

Both P and Q are positive integers. The resolution of the sensor is greater than or equal to the quantity of beams obtained after the beam splitter splits a beam from a light emitting region of the array light source, so that the sensor can receive reflected beams that are obtained by reflecting beams from the beam splitter by the target object, and the TOF depth sensing module can normally receive the reflected beams.

Optionally, the generating M depth images in step 4003E specifically includes:

(1) determining distances between the TOF depth sensing module and M regions of the target object based on the TOFs corresponding to the beams that are respectively emitted by the M light emitting regions at the M different moments;

(2) generating depth images of the M regions of the target object based on the distances between the TOF depth sensing module and the M regions of the target object; and

The method shown in FIG. 24 may be performed by the TOF depth sensing module shown in FIG. 3 or a terminal device including the TOF depth sensing module shown in FIG. 3.

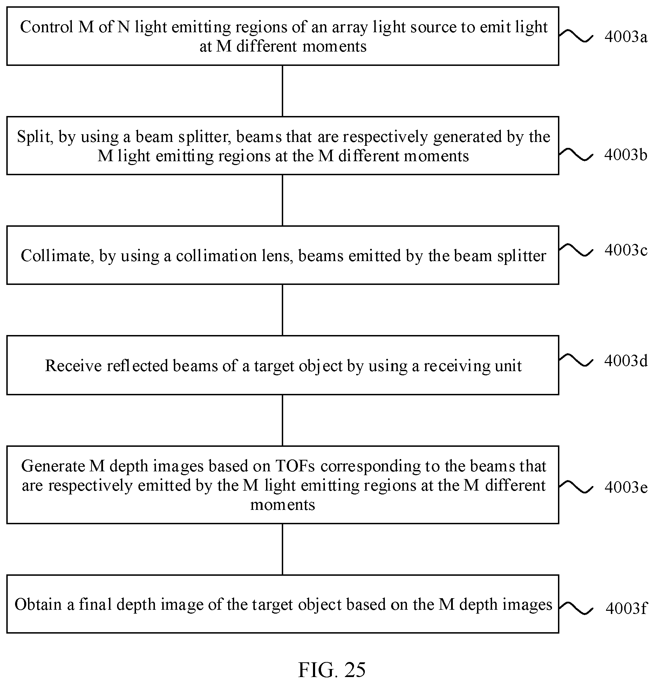

The process of obtaining a final depth image of the target object in the second working mode varies with a relative position relationship between the collimation lens and the beam splitter in the TOF depth sensing module. The following describes, with reference to FIG. 25, a process of obtaining a final depth image of the target object in the second working mode.

FIG. 25 is a schematic flowchart of obtaining a final depth image of the target object in the second working mode. A process shown in FIG. 25 includes steps 4003a to 4003f, which are described in detail below.

4003a. Control M of the N light emitting regions of the array light source to emit light at M different moments.

M is less than or equal to N, and both M and N are positive integers.

In step 4003a, light emission of the array light source may be controlled by using the control unit. Specifically, the control unit may respectively send control signals to the M light emitting regions of the array light source at the M moments, to control the M light emitting regions to respectively emit light at the M different moments.

For example, the array light source includes four independent light emitting regions A, B, C, and D. In this case, the control unit may respectively send control signals to four independent light emitting regions A, B, and C at moments t0, t1, and t2, so that the three independent light emitting regions A, B, and C respectively emit light at the moments t0, t1, and t2.

4003b. Split, by using the beam splitter, beams that are respectively generated by the M light emitting regions at the M different moments.

The beam splitter is specifically configured to split each received beam of light into a plurality of beams of light.

The splitting, by using the beam splitter, beams that are respectively generated by the M light emitting regions at the M different moments may be specifically respectively splitting, by using the beam splitter, the beams that are generated by the M light emitting regions at the M different moments.

For example, the array light source includes four independent light emitting regions A, B, C, and D. Under the control of the control unit, the light emitting region A emits light at a moment T0, the light emitting region B emits light at a moment T1, and the light emitting region C emits light at a moment T2. In this case, the beam splitter may split a beam that is emitted by the light emitting region A at the moment T0, split a beam that is emitted by the light emitting region B at the moment T1, and split a beam that is emitted by the light emitting region C at the moment T2.

4003c. Collimate beams from the beam splitter by using the collimation lens.

The collimation lens collimates the beams, so that approximately parallel beams can be obtained, thereby improving power densities of the beams, and further improving an effect of scanning by the beams subsequently.

4003d. Receive reflected beams of the target object by using the receiving unit.

The reflected beams of the target object are beams obtained by reflecting beams from the collimation lens by the target object.

4003e. Generate M depth images based on TOFs corresponding to the beams that are respectively emitted by the M light emitting regions at the M different moments.

The TOF corresponding to the beams that are respectively emitted by the M light emitting regions of the array light source at the M different moments may specifically refer to time difference information between emission moments of the beams respectively emitted by the M light emitting regions of the array light source at the M different moments and reception moments of corresponding reflected beams.

4003f. Obtain a final depth image of the target object based on the M depth images.

Optionally, the M depth images are respectively depth images corresponding to M regions of the target object, and there is a non-overlap region between any two of the M regions.

Optionally, the receiving unit includes a receiving lens and a sensor. The receiving reflected beams of a target object by using the receiving unit in step 4003d includes: converging the reflected beams of the target object to the sensor by using the receiving lens.

The sensor may also be referred to as a sensor array, and the sensor array may be a two-dimensional sensor array.

Optionally, a resolution of the sensor is greater than or equal to $P \times Q$, and a quantity of beams obtained after the beam splitter splits a beam from a light emitting region of the array light source is $P \times Q$.

Both P and Q are positive integers. The resolution of the sensor is greater than or equal to the quantity of beams obtained after the beam splitter splits a beam from a light emitting region of the array light source, so that the sensor can receive reflected beams that are obtained by reflecting beams from the beam splitter by the target object, and the TOF depth sensing module can normally receive the reflected beams.

Optionally, the generating M depth images in step 4003e specifically includes:

(1) determining distances between the TOF depth sensing module and M regions of the target object based on the TOFs corresponding to the beams that are respectively emitted by the M light emitting regions at the M different moments;

(2) generating depth images of the M regions of the target object based on the distances between the TOF depth sensing module and the M regions of the target object; and

(3) synthesizing the depth image of the target object based on the depth images of the M regions of the target object.

The process shown in FIG. 25 and the process shown in FIG. 24 both refer to how to obtain a final depth image of the target object in the second working mode, and a main difference lies as follows: In FIG. 25, the beam splitter is first used to split the beams emitted by the array light source, and then the collimation lens is used to collimate split beams. In FIG. 24, the collimation lens is first used to collimate the beams emitted by the array light source, and then the beam splitter may be used to split collimated beams.

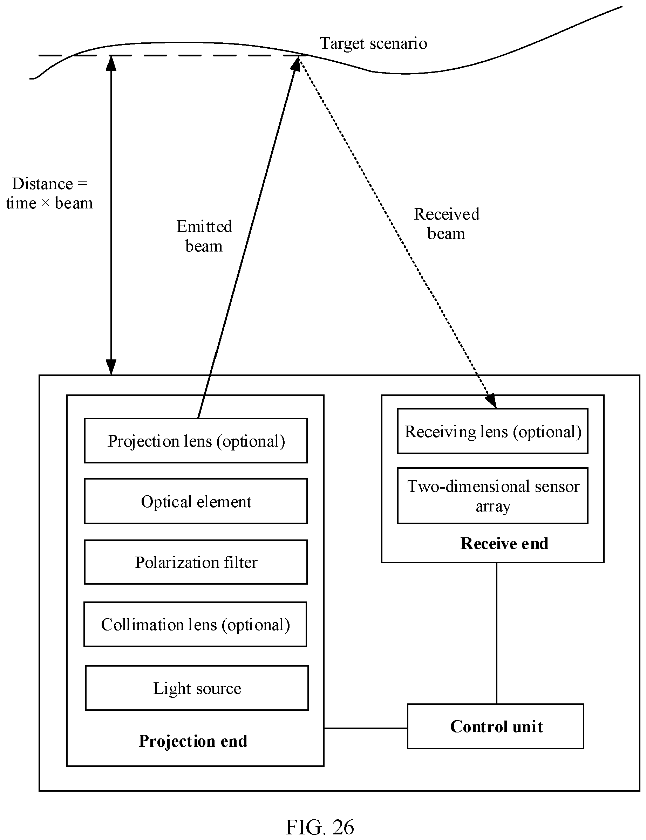

The foregoing describes in detail one TOF depth sensing module and image generation method with reference to FIG. 1 to FIG. 25. The following describes in detail another TOF depth sensing module and image generation method with reference to FIG. 26 to FIG. 52.

A conventional TOF depth sensing modules generally use a mechanical rotating or vibrating component to drive an optical structure (for example, a reflector, a lens, and a prism) or a light emitting source to rotate or vibrate to change a propagation direction of a beam, to scan different regions of a target object. However, the TOF depth sensing module has a large size and is not suitable for installation in some space-limited devices (for example, a mobile terminal). In addition, such a TOF depth sensing module generally performs scanning in a continuous scanning manner, which generally generates a continuous scanning track. As a result, flexibility in scanning the target object is poor, and a region of interest (region of interest, ROI) cannot be quickly located. Therefore, there is provided a TOF depth sensing module, so that different beams can irradiate in different directions without mechanical rotation or vibration, and a scanned region of interest can be quickly located, which is specifically described below with reference to accompanying drawings.

The following first briefly describes the TOF depth sensing module with reference to FIG. 26.

FIG. 26 is a schematic diagram of measuring a distance by using a TOF depth sensing module.

As shown in FIG. 26, the TOF depth sensing module may include a transmit end (which may also be referred to as a projection end), a receive end, and a control unit. The transmit end is configured to emit an emergent beam. The receive end is configured to receive a reflected beam of a target object (the reflected beam is a beam obtained by reflecting the emergent beam by the target object). The control unit may control the transmit end and the receive end to transmit and receive the beam, respectively.

In FIG. 26, the transmit end may generally include a light source, a collimation lens (optional), a polarization filter, an optical element, and a projection lens (optional), the receive end may generally include a receiving lens and a sensor, and the receiving lens and the sensor may be collectively referred to as a receiving unit.

In FIG. 26, a TOF corresponding to the emergent beam may be recorded by using a timing apparatus, to calculate a distance from the TOF depth sensing module to a target region, to obtain a final depth image of the target object. The TOF corresponding to the emergent beam may refer to time difference information between a moment at which the reflected beam is received by the receiving unit and an emission moment of the emergent beam.

The TOF depth sensing module may be configured to obtain a 3D image. The TOF depth sensing module may be disposed on an intelligent terminal (for example, a mobile phone, a tablet, or a wearable device), to obtain a depth image or a 3D image, which may also provide gesture and limb recognition for a 3D game or a somatic game.

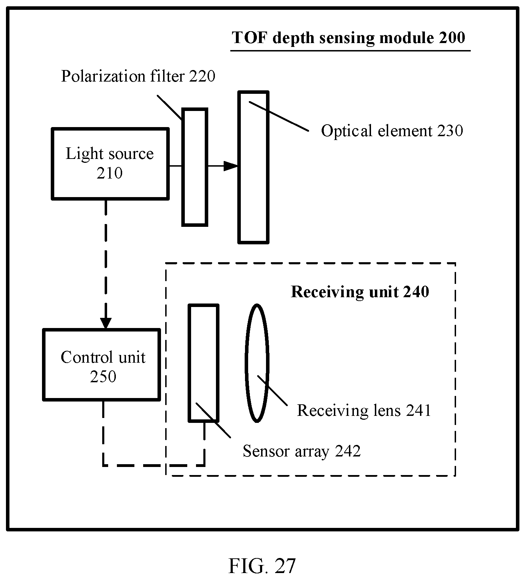

The following describes in detail the TOF depth sensing module with reference to FIG. 27.

FIG. 27 is a schematic block diagram of a TOF depth sensing module.

The TOF depth sensing module 200 shown in FIG. 27 includes a light source 210, a polarization filter 220, an optical element 230, a receiving unit 240, and a control unit 250. The polarization filter 220 is located between the light source 210 and the optical element 230. The following describes in detail the several modules or units in the TOF depth sensing module 200.

Light source 210:

The light source 210 is configured to generate a beam. Specifically, the light source 210 can generate light in a plurality of polarization states.

Optionally, the beam emitted by the light source 210 is a single quasi-parallel beam, and a divergence angle of the beam emitted by the light source 210 is less than 1°.

Optionally, the light source may be a semiconductor laser light source.

The light source may be a vertical cavity surface emitting laser (vertical cavity surface emitting laser, VCSEL).

Optionally, the light source may be a Fabry-Perot laser (which may be referred to as an FP laser for short).

A single FP laser can implement a larger power than a single VCSEL, and has higher electro-optical conversion efficiency than the VCSEL, thereby improving a scanning effect.

Optionally, a wavelength of the beam emitted by the light source 210 is greater than 900 nm.

Because intensity of light whose wavelength is greater than 900 nm in sunlight is weak, when the wavelength of the beam is greater than 900 nm, interference caused by the sunlight can be reduced, thereby improving a scanning effect of the TOF depth sensing module.

Optionally, a wavelength of the beam emitted by the light source 210 is 940 nm or 1550 nm.

Because intensity of light whose wavelength is near 940 nm or 1550 nm in sunlight is weak, when the wavelength of the beam is 940 nm or 1550 nm, interference caused by the sunlight can be greatly reduced, thereby improving a scanning effect of the TOF depth sensing module.

Polarization filter 220:

The polarization filter 220 is configured to filter the beam to obtain a beam in a single polarization state.

The single polarization state of the beam obtained by the polarization filter 220 through filtering is one of the plurality of polarization states of the beam generated by the light source 210.

For example, the beam generated by the light source 210 includes linearly polarized light, left-handed circularly polarized light, and right-handed circularly polarized light in different directions. In this case, the polarization filter 220 may filter out light whose polarization states are the left-handed circularly polarized light and the right-handed circularly polarized light in the beam, to obtain a beam whose polarization state is linearly polarized light in a specific direction.

Optical element 230:

The optical element 230 is configured to adjust a direction of the beam in the single polarization state.

A refractive index parameter of the optical element 230 is controllable. The optical element 230 can adjust the beam in the single polarization state to different directions by using different refractive indexes of the optical element 230.

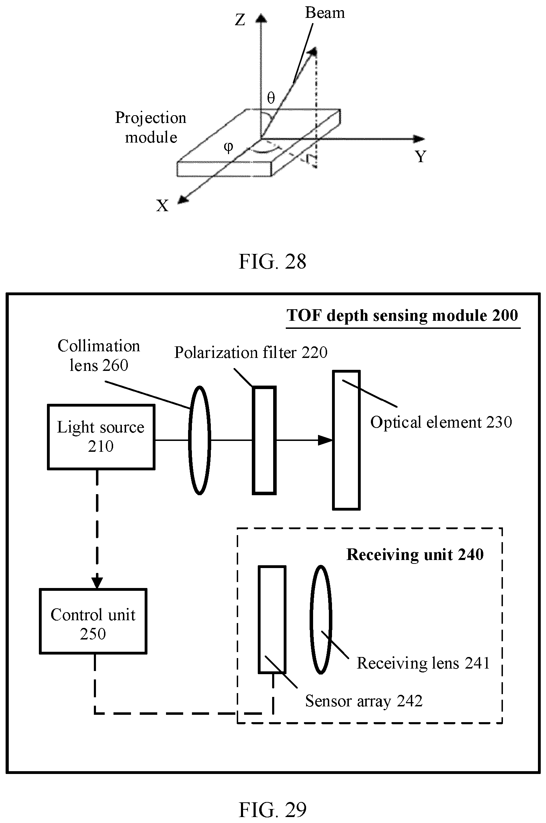

The following describes a propagation direction of a beam with reference to an accompanying drawing. The propagation direction of the beam may be defined by using a space angle. As shown in FIG. 28, a space angle of a beam includes an angle $\theta$ between the beam and a Z axis direction of a right angle coordinate system of an emergent surface and an angle $\varphi$ between a projection of the beam on an XY plane and an X axis direction. The space angle $\theta$ or $\varphi$ of the beam may change when scanning is performed by using the beam.

Control unit 250:

The control unit 250 is configured to control the refractive index parameter of the optical element 230, to change the propagation direction of the beam in the single polarization state.

The control unit 250 may generate a control signal. The control signal may be a voltage signal or a radio frequency drive signal. The refractive index parameter of the optical element 230 may be changed by using the control signal, so that an emergent direction of the beam that is in the single polarization state and that is received by the optical element 20 can be changed.

Receiving unit 240:

The receiving unit 240 is configured to receive a reflected beam of a target object.

The reflected beam of the target object is a beam obtained by reflecting the beam in the single polarization state by the target object.

Specifically, the beam in the single polarization state irradiates a surface of the target object after passing through the optical element 230, a reflected beam is generated due to reflection of the surface of the target object, and the reflected beam may be received by the receiving unit 240.

The receiving unit 240 may specifically include a receiving lens 241 and a sensor 242. The receiving lens 241 is configured to receive the reflected beam, and converge the reflected beam to the sensor 242.

Because the beam can be adjusted to different directions by using different birefringence of the optical element, the propagation direction of the beam can be adjusted by controlling a birefringence parameter of the optical element. In this way, the propagation direction of the beam is adjusted in a non-mechanical-rotation manner, so that discrete scanning of the beam can be implemented, and depth or distance measurement of an ambient environment and a target object can be performed more flexibly.

That is, the space angle of the beam in the single polarization state can be changed by controlling the refractive index parameter of the optical element 230, so that the optical element 230 can deflect the propagation direction of the beam in the single polarization state, to output an emergent beam whose scanning direction and scanning angle meet requirements. In this way, discrete scanning can be implemented, scanning flexibility is high, and an ROI can be quickly located.

Optionally, the control unit 250 is further configured to generate a depth image of the target object based on a TOF corresponding to the beam.

The TOF corresponding to the beam may refer to time difference information between a moment at which the reflected beam corresponding to the beam is received by the receiving unit and a moment at which the light source emits the beam. The reflected beam corresponding to the beam may be specifically a beam that is generated after the beam is processed by the polarization filter and the optical element and is reflected by the target object when reaching the target object.

FIG. 29 is a schematic block diagram of a TOF depth sensing module.

As shown in FIG. 29, the TOF depth sensing module 200 further includes a collimation lens 260. The collimation lens 260 is located between the light source 210 and the polarization filter 220. The collimation lens 260 is configured to collimate the beam. The polarization filter 220 is configured to filter a collimated beam of the collimation lens to obtain a beam in a single polarization state.

Optionally, a light emitting area of the light source 210 is less than or equal to $5 \times 5$ mm$^2$.

Optionally, a clear aperture of the collimation lens is less than or equal to 5 mm.

Because sizes of the light source and the collimation lens are small, the TOF depth sensing module including the components (the light source and the collimation lens) is easily integrated into a terminal device, and a space occupied in the terminal device can be reduced to some extent.

Optionally, an average output optical power of the TOF depth sensing module 200 is less than 800 mw.

When the average output optical power of the TOF depth sensing module is less than or equal to 800 mw, the TOF depth sensing module has small power consumption, and can be disposed in a device sensitive to power consumption, such as a terminal device.

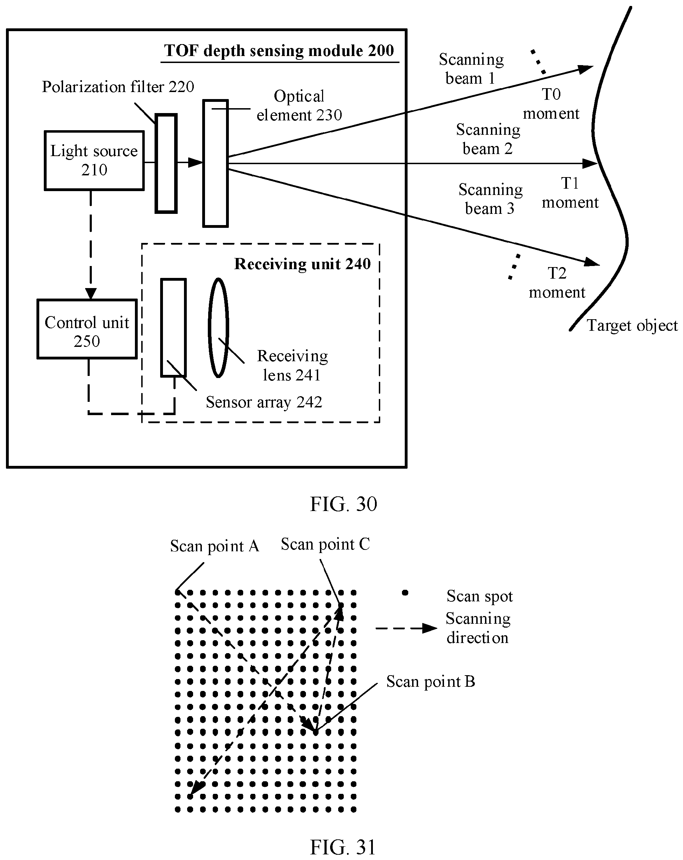

FIG. 30 is a schematic diagram of scanning a target object by a TOF depth sensing module.

As shown in FIG. 30, the optical element 230 may emit an emergent beam 1 at a moment T0. At a moment T1, if a scanning direction and a scanning angle need to be changed, the optical element may be directly controlled to emit an emergent beam 2 at the moment T1. At a next moment T2, if the scanning direction and the scanning angle further need to be changed, a control signal may be sent to control the optical element to emit an emergent beam 3 at the moment T2. The TOF depth sensing module 200 can directly output emergent beams in different directions at different moments, to scan a target object.

The following describes, in detail with reference to FIG. 31, an effect of implementing discrete scanning by the TOF depth sensing module 200.

FIG. 31 is a schematic diagram of a scanning track of a TOF depth sensing module.

As shown in FIG. 31, the TOF depth sensing module may start scanning from a scan point A. When the scanning needs to be switched from the scan point A to a scan point B, the optical element 230 may be directly controlled by using the control unit 250 to emit a beam to directly irradiate the scan point B without gradually moving from scan point A to the scan point B (without moving from A to B along a dashed line between A and B in the figure). Similarly, when the scanning needs to be switched from the scan point B to a scan point C, the optical element 230 may alternatively be controlled by using the control unit 250 to emit a beam to directly irradiate the scan point C without gradually moving from the scan point B to the scan point C (without moving from B to C along a dashed line between B and C in the figure).

Therefore, the TOF depth sensing module 200 can implement discrete scanning, so that scan flexibility is high, and a region that needs to be scanned can be quickly located.

Because the TOF depth sensing module 200 can implement discrete scanning, during scanning, the TOF depth sensing module 200 may scan a region with a plurality of scanning tracks, so that a more flexible scanning manner can be selected, and a timing control design of the TOF depth sensing module 200 is facilitated.

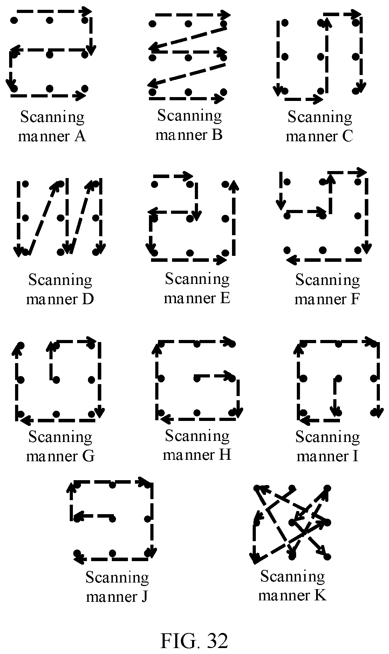

The following describes a scanning manner of the TOF depth sensing module 200 with reference to FIG. 32 by using a $3 \times 3$ two-dimensional lattice as an example.

FIG. 32 is a schematic diagram of a scanning manner of a TOF depth sensing module.

As shown in FIG. 32, the TOF depth sensing module 200 may start scanning at a point at an upper left corner of the two-dimensional lattice, until a point at a lower right corner of the two-dimensional lattice. Such scanning manners include a scanning manner A to a scanning manner F. Other than starting from the point at the upper left corner of the two-dimensional lattice, scanning may start from a central point of the two-dimensional lattice until all points of the two-dimensional lattice are scanned, to completely scan the two-dimensional lattice. Such scanning manners include a scanning manner G to a scanning manner J.

In addition, scanning may alternatively start from any point in the two-dimensional array until all the points of the two-dimensional array are scanned. As shown in a scanning manner K in FIG. 32, scanning may start from a point in the first row and the second column of the two-dimensional array until the central point in the two-dimensional array is scanned, to completely scan the two-dimensional array.

Optionally, the optical element 230 is any one of a liquid crystal polarization grating, an optical phased array, an electro-optic component, and an acousto-optic component.

The following describes in detail specific compositions of the optical element 230 in different cases with reference to accompanying drawings.

First case: The optical element 230 is a liquid crystal polarization grating (liquid crystal polarization grating, LCPG). In the first case, birefringence of the optical element 230 is controllable, and the optical element can adjust a beam in a single polarization state to different directions by using different birefringence of the optical element.

The liquid crystal polarization grating is a new grating component based on a geometric phase principle, which acts on circularly polarized light and has electro-optic tunability and polarization tunability.

The liquid crystal polarization grating is a grating formed by periodic arrangement of liquid crystal molecules, which is generally prepared by controlling, by using a photoalignment technology, directors of liquid crystal molecules (directions of long axes of the liquid crystal molecules) to gradually change linearly and periodically in a direction. Circularly polarized light can be diffracted to a +1 or -1 order by controlling a polarization state of incident light, so that a beam can be deflected through switching between a non-zero diffraction order and a zero order.

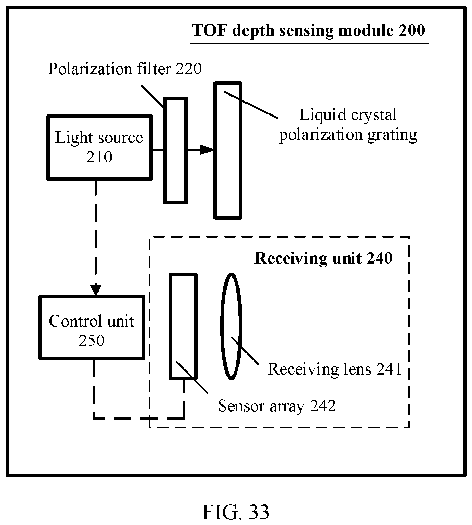

FIG. 33 is a schematic block diagram of a TOF depth sensing module.

As shown in FIG. 33, the optical element 230 is a liquid crystal polarization grating. The control unit 250 can control the light source to emit a beam to the liquid crystal polarization grating, and control, by using a control signal, the liquid crystal polarization grating to deflect a direction of the beam to obtain an emergent beam.

Optionally, the liquid crystal polarization grating includes an LCPG component in a horizontal direction and an LCPG component in a vertical direction.

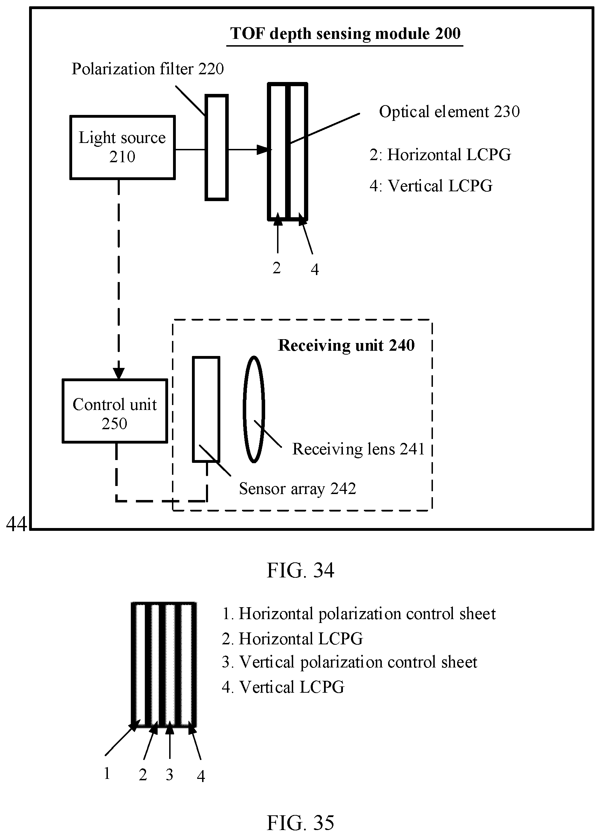

FIG. 34 is a schematic block diagram of a TOF depth sensing module.

As shown in FIG. 34, the liquid crystal polarization grating includes an LCPG component in a horizontal direction and an LCPG component in a vertical direction. Discrete random scanning in the horizontal direction can be implemented by using the LCPG component in the horizontal direction, and discrete random scanning in the vertical direction can be implemented by using the LCPG component in the vertical direction. When the LCPG components in the horizontal direction and the LCPG components in the vertical direction are combined, two-dimensional discrete random scanning in the horizontal direction and the vertical direction can be implemented.

It should be understood that FIG. 34 merely shows that the LCPG in the horizontal direction is in front of the LCPG in the vertical direction (a distance between the LCPG in the horizontal direction and the light source is less than a distance between the LCPG in the vertical direction and the light source). Actually, in this application, the LCPG in the vertical direction may alternatively be in front of the LCPG in the horizontal direction in the liquid crystal polarization grating (the distance between the LCPG in the vertical direction and the light source is less than the distance between the LCPG in the horizontal direction and the light source).

In this application, when the liquid crystal polarization grating includes the LCPG component in the horizontal direction and the LCPG component in the vertical direction, two-dimensional discrete random scanning in the horizontal direction and the vertical direction can be implemented.

Optionally, in the first case, the liquid crystal polarization grating may further include a horizontal polarization control sheet and a vertical polarization control sheet.

When the liquid crystal polarization grating includes a polarization control sheet, a polarization state of a beam can be controlled.

FIG. 35 is a schematic diagram of a structure of a liquid crystal polarization grating.

As shown in FIG. 35, the liquid crystal polarization grating includes not only a horizontal LCPG and a vertical LCPG, but also a horizontal polarization control sheet and a vertical polarization control sheet. In FIG. 35, the horizontal LCPG is located between the horizontal polarization control sheet and the vertical polarization control sheet, and the vertical polarization control sheet is located between the horizontal LCPG and the vertical LCPG.

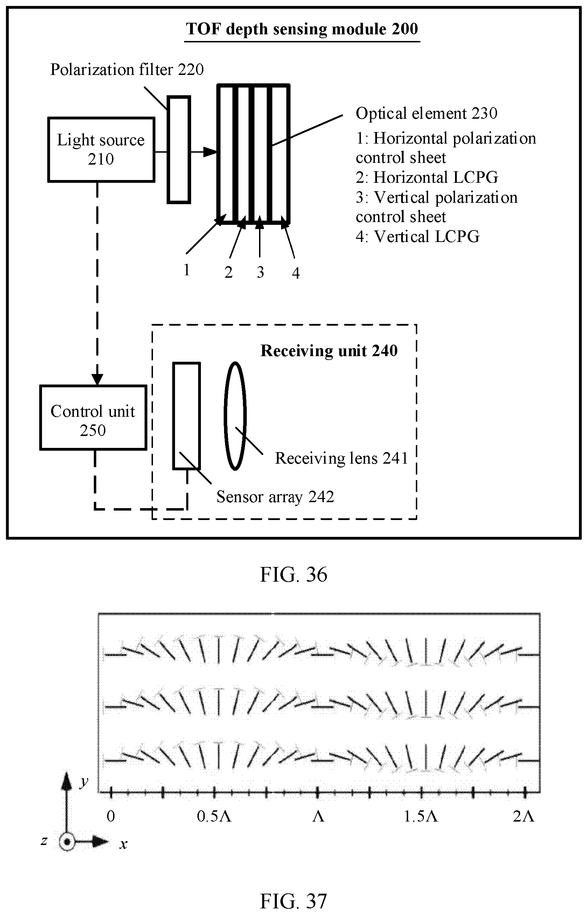

FIG. 36 is a schematic diagram of a structure of a TOF depth sensing module.

As shown in FIG. 36, a structure of a liquid crystal polarization grating in the TOF depth sensing module is shown in FIG. 35, and distances between the light source and the horizontal polarization control sheet, the horizontal LCPG, the vertical polarization control sheet, and the vertical LCPG are in ascending order of magnitude.

Optionally, the components in the liquid crystal polarization grating shown in FIG. 35 may have the following several combination manners.

A combination manner 1 is 124.

A combination manner 2 is 342.

A combination manner 3 is 3412.

In the combination manner 1, 1 may represent the horizontal polarization control sheet and the vertical polarization control sheet that are closely attached. In this case, the two polarization control sheets that are closely attached are equivalent to one polarization control sheet. Therefore, in the combination manner 1, 1 is used to represent the horizontal polarization control sheet and the vertical polarization control sheet that are closely attached. Similarly, in the combination manner 2, 3 may represent the horizontal polarization control sheet and the vertical polarization control sheet that are closely attached. In this case, the two polarization control sheets that are closely attached are equivalent to one polarization control sheet. Therefore, in the combination manner 2, 3 is used to represent the horizontal polarization control sheet and the vertical polarization control sheet that are closely attached.

When the optical element 230 in the combination manner 1 or the combination manner 2 is placed in the TOF depth sensing module, the horizontal polarization control sheet and the vertical polarization control sheet are both located on a side close to the light source, and the horizontal LCPG and the vertical LCPG are both located on a side far from the light source.

When the optical element 230 in the combination manner 3 is placed in the TOF depth sensing module, distances between the light source and the vertical polarization control sheet, the vertical LCPG, the horizontal polarization control sheet, and the horizontal LCPG are in ascending order of magnitude.

It should be understood that the foregoing three combination manners of the liquid crystal polarization grating and the combination manner in FIG. 35 are merely examples. Actually, the components in the optical element in this application may have other different combination manners, provided that a distance between the horizontal polarization control sheet and the light source is less than a distance between the horizontal LCPG and the light source, and a distance between the horizontal polarization control sheet and the light source is less than a distance between the horizontal LCPG and the light source.

As shown in FIG. 37, a physical characteristic of the liquid crystal polarization grating may be periodically changed by inputting a periodic control signal (in FIG. 37, a period of the control signal is A) to the liquid crystal polarization grating. Specifically, an arrangement manner of liquid crystal molecules inside the liquid crystal polarization grating may be changed (the liquid crystal molecules are generally rod-shaped, and directors of the liquid crystal molecules may be changed due to impact of the control signal), to deflect a direction of a beam.

When a liquid crystal polarization grating and a polarization film are combined, a beam can be controlled to different directions.

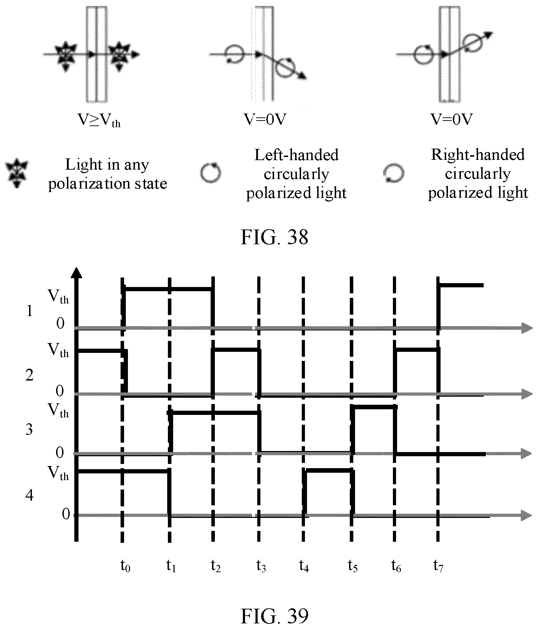

As shown in FIG. 38, incident light is controlled by using voltages of left-handed and right-handed circular polarization films and the LCPG, to implement beam control in three different directions. A deflection angle of emergent light may be determined based on the following diffraction grating equation:

$$\sin \theta_m = (m\frac{\lambda}{\Lambda}) + \sin \theta$$

In the foregoing diffraction grating equation, $\theta_m$ is a direction angle of m-order emergent light, $\lambda$ is a wavelength of a beam, A is a period of the LCPG, and $\theta$ is an incident angle of the incident light. It can be learned from the diffraction grating equation that magnitude of the deflection angle $\theta_m$ depends on magnitude of the period of the LCPG, the wavelength, and the incident angle. Herein, $m$ is only 0 or $\pm 1$. When $m$ is 0, it indicates that the direction is not deflected, and the direction is unchanged. When $m$ is 1, it indicates deflecting to the left or counterclockwise with respect to the incident direction. When $m$ is -1, it indicates deflecting to the right or clockwise with respect to the incident direction (meanings when $m$ is +1 and $m$ is -1 can be reversed).

Deflection to three angles can be implemented by using a single LCPG, to obtain emergent beams at three angles. Therefore, emergent beams at more angles can be obtained by cascading LCPGs in a plurality of layers. Therefore, $3^N$ deflection angles can be theoretically implemented by using a combination of N layers of polarization control sheets (the polarization control sheet is configured to control polarization of incident light to implement conversion of left-handed light and right-handed light) and N layers of LCPGs.

For example, as shown in FIG. 35, the optical element of the TOF depth sensing module includes components 1, 2, 3, and 4. The components 1, 2, 3, and 4 respectively represent a horizontal polarization control sheet, a horizontal LCPG, a vertical polarization control sheet, and a vertical LCPG. A beam deflection direction and angle may be controlled by controlling voltages of the polarization control sheets and the LCPGs.

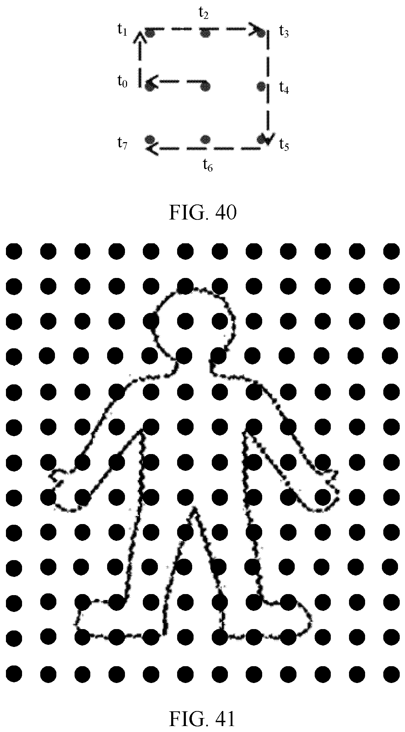

For example, 3x3 points are to be scanned. Voltage signals shown in FIG. 39 are respectively applied to the components 1, 2, 3 and 4 shown in FIG. 36 (1, 2, 3, and 4 in FIG. 39 respectively represent voltage signals applied to the components 1, 2, 3 and 4 shown in FIG. 36), so that a beam emitted by the light source can be controlled to implement a scanning track shown in FIG. 40.

Specifically, it is assumed that incident light is left-handed circularly polarized light, the horizontal LCPG deflects incident left-handed light to the left, and the vertical LCPG deflects incident left-handed light downward. The following describes in detail a beam deflection direction at each moment.

When two ends of the horizontal polarization control sheet are subject to a high voltage signal, a polarization state of a beam passing through the horizontal polarization control sheet is unchanged, and when the two ends of the horizontal polarization control sheet are subject to a low voltage signal, the polarization state of the beam passing through the horizontal polarization control sheet is changed. Similarly, when two ends of the vertical polarization control sheet are subject to a high voltage signal, a polarization state of a beam passing through the vertical polarization control sheet is unchanged, and when the two ends of the vertical polarization control sheet are subject to a low voltage signal, the polarization state of the beam passing through the vertical polarization control sheet is changed.

At a moment 0, incident light of the component 1 is the left-handed circularly polarized light. Because a low voltage is applied to the component 1, the component 1 emits right-handed circularly polarized light. Incident light of the component 2 is the right-handed circularly polarized light. Because a high voltage is applied to the component 2, the component 2 still emits the right-handed circularly polarized light. Incident light of the component 3 is the right-handed circularly polarized light. Because a low voltage is applied to the component 3, the component 3 emits left-handed circularly polarized light. Incident light of the component 4 is the left-handed circularly polarized light. Because a high voltage is applied to the component 4, the component 4 still emits the left-handed circularly polarized light. Therefore, at the moment 0, after the incident light passes through the component 1 to the component 4, the direction of the incident light is unchanged, and the polarization state is unchanged. As shown in FIG. 40, a scan point corresponding to the moment 0 is a position shown as a center of FIG. 40.

At a moment t0, incident light of the component 1 is the left-handed circularly polarized light. Because a high voltage is applied to the component 1, the component 1 still emits the left-handed circularly polarized light. Incident light of the component 2 is the left-handed circularly polarized light. Because a low voltage is applied to the component 2, the component 2 emits right-handed circularly polarized light that is deflected to the left. Incident light of the component 3 is the right-handed circularly polarized light that is deflected to the left. Because a low voltage is applied to the component 3, the component 3 emits left-handed circularly polarized light that is deflected to the left. Incident light of the component 4 is the left-handed circularly polarized light that is deflected to the left. Because a high voltage is applied to the component 4, the component 4 still emits the left-handed circularly polarized light that is deflected to the left. That is, the beam emitted by the component 4 at the moment t0 is deflected to the left with respect to that at the moment 0, and a corresponding scan point in FIG. 40 is a position shown as t0.

At a moment t1, incident light of the component 1 is the left-handed circularly polarized light. Because a high voltage is applied to the component 1, the component 1 still emits the left-handed circularly polarized light. Incident light of the component 2 is the left-handed circularly polarized light. Because a low voltage is applied to the component 2, the component 2 emits right-handed circularly polarized light that is deflected to the left. Incident light of the component 3 is the right-handed circularly polarized light that is deflected to the left. Because a high voltage is applied to the component 3, the component 3 emits right-handed circularly polarized light that is deflected to the left. Incident light of the component 4 is the right-handed circularly polarized light that is deflected to the left. Because a low voltage is applied to the component 4, the component 4 emits left-handed circularly polarized light that is deflected to the left and deflected upward. That is, the beam emitted by the component 4 at the moment t1 is deflected to the left and deflected upward with respect to that at the moment 0, and a corresponding scan point in FIG. 40 is a position shown as t1.

At a moment t2, incident light of the component 1 is the left-handed circularly polarized light. Because a low voltage is applied to the component 1, the component 1 emits right-handed circularly polarized light. Incident light of the component 2 is the right-handed circularly polarized light. Because a high voltage is applied to the component 2, the component 2 still emits the right-handed circularly polarized light. Incident light of the component 3 is the right-handed circularly polarized light. Because a high voltage is applied to the component 3, the component 3 still emits the right-handed circularly polarized light. Incident light of the component 4 is the right-handed circularly polarized light. Because a low voltage is applied to the component 4, the component 4 emits left-handed circularly polarized light that is deflected upward. That is, the beam emitted by the component 4 at the moment t2 is deflected upward with respect to that at the moment 0, and a corresponding scan point in FIG. 40 is a position shown as t2.

At a moment t3, incident light of the component 1 is the left-handed circularly polarized light. Because a low voltage is applied to the component 1, the component 1 emits right-handed circularly polarized light. Incident light of the component 2 is the right-handed circularly polarized light. Because a low voltage is applied to the component 2, the component 2 emits right-handed circularly polarized light that is deflected to the right. Incident light of the component 3 is the right-handed circularly polarized light that is deflected to the right. Because a low voltage is applied to the component 3, the component 3 emits left-handed circularly polarized light that is deflected to the right. Incident light of the component 4 is the left-handed circularly polarized light that is deflected to the right. Because a low voltage is applied to the component 4, the component 4 emits left-handed circularly polarized light that is deflected to the right and deflected upward. That is, the beam emitted by the component 4 at the moment t3 is deflected to the right and deflected upward with respect to that at the moment 0, and a corresponding scan point in FIG. 40 is a position shown as t3.

At a moment t4, incident light of the component 1 is the left-handed circularly polarized light. Because a low voltage is applied to the component 1, the component 1 emits right-handed circularly polarized light. Incident light of the component 2 is the right-handed circularly polarized light. Because a low voltage is applied to the component 2, the component 2 emits left-handed circularly polarized light that is deflected to the right. Incident light of the component 3 is the left-handed circularly polarized light that is deflected to the right. Because a low voltage is applied to the component 3, the component 3 emits right-handed circularly polarized light that is deflected to the right. Incident light of the component 4 is the right-handed circularly polarized light that is deflected to the right. Because a high voltage is applied to the component 4, the component 4 still emits right-handed circularly polarized light that is deflected to the right. That is, the beam emitted by the component 4 at the moment t4 is deflected to the right with respect to that at the moment 0, and a corresponding scan point in FIG. 40 is a position shown as t4.

At a moment t5, incident light of the component 1 is the left-handed circularly polarized light. Because a low voltage is applied to the component 1, the component 1 emits right-handed circularly polarized light. Incident light of the component 2 is the right-handed circularly polarized light. Because a low voltage is applied to the component 2, the component 2 emits right-handed circularly polarized light that is deflected to the right. Incident light of the component 3 is the right-handed circularly polarized light that is deflected to the right. Because a high voltage is applied to the component 3, the component 3 still emits right-handed circularly polarized light that is deflected to the right. Incident light of the component 4 is the right-handed circularly polarized light that is deflected to the right. Because a low voltage is applied to the component 4, the component 4 emits left-handed circularly polarized light that is deflected to the right and deflected downward. That is, the beam emitted by the component 4 at the moment t5 is deflected to the right and deflected downward with respect to that at the moment 0, and a corresponding scan point in FIG. 40 is a position shown as t5.

At a moment t6, incident light of the component 1 is the left-handed circularly polarized light. Because a low voltage is applied to the component 1, the component 1 emits right-handed circularly polarized light. Incident light of the component 2 is the right-handed circularly polarized light. Because a high voltage is applied to the component 2, the component 2 still emits the right-handed circularly polarized light. Incident light of the component 3 is the right-handed circularly polarized light. Because a low voltage is applied to the component 3, the component 3 emits left-handed circularly polarized light. Incident light of the component 4 is the left-handed circularly polarized light. Because a low voltage is applied to the component 4, the component 4 emits right-handed circularly polarized light that is deflected downward. That is, the beam emitted by the component 4 at the moment t6 is deflected downward with respect to that at the moment 0, and a corresponding scan point in FIG. 40 is a position shown as t6.

At a moment t7, incident light of the component 1 is the left-handed circularly polarized light. Because a high voltage is applied to the component 1, the component 1 still emits the left-handed circularly polarized light. Incident light of the component 2 is the left-handed circularly polarized light. Because a low voltage is applied to the component 2, the component 2 emits right-handed circularly polarized light that is deflected to the left. Incident light of the component 3 is the right-handed circularly polarized light that is deflected to the left. Because a low voltage is applied to the component 3, the component 3 emits left-handed circularly polarized light that is deflected to the left. Incident light of the component 4 is the left-handed circularly polarized light that is deflected to the left. Because a low voltage is applied to the component 4, the component 4 emits right-handed circularly polarized light that is deflected to the left and deflected downward. That is, the beam emitted by the component 4 at the moment t7 is deflected to the left and deflected upward with respect to that at the moment 0, and a corresponding scan point in FIG. 40 is a position shown as t7.

It should be understood that the foregoing merely describes a possible scanning track of the TOF depth sensing module with reference to FIG. 39 and FIG. 40, and any discrete random scanning may be implemented by changing the voltages controlling the polarization control sheets and the LCPGs.

For example, various scanning tracks shown in FIG. 32 may be implemented by changing the voltages controlling the polarization control sheets and LCPGs.

When a conventional lidar is used to scan a target object, it is usually necessary to first perform a coarse scan (Coarse scan) on a target region, and then perform a fine scan (Fine scan) at a higher resolution after a region of interest (ROI) is found. Because the TOF depth sensing module can implement discrete scanning, a region of interest can be directly located for a fine scan, thereby greatly reducing a time required for the fine scan.

For example, as shown in FIG. 41, a total quantity of points of a to-be-scanned region (an entire rectangular region including a human body contour) is M, and an ROI (image region within a human body contour image in FIG. 41) accounts for 1/N of a total area of the to-be-scanned region.

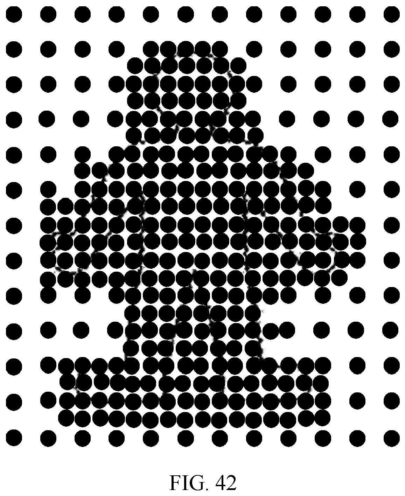

When the to-be-scanned region shown in FIG. 41 is scanned, it is assumed that the conventional lidar and the laser scanning radar both have a point scanning rate of K points/second, and when the ROI is scanned, a fine scan needs to be performed, and a resolution of the fine scan needs to be increased to four times (that is, 4K points/second) of an original resolution. In this case, a time required to complete the fine scan on the ROI by using the TOF depth sensing module is $t_1$, and a time required to complete the fine scan on the ROI by using the conventional lidar is $t_2$. Because the TOF depth sensing module can implement discrete scanning, the ROI can be directly located and finely scanned, which requires a shorter scan time. However, the conventional lidar performs linear scanning, it is difficult to accurately locate the ROI. Therefore, the conventional lidar needs to finely scan the entire to-be-scanned region, which greatly increases a scanning time. As shown in FIG. 42, the TOF depth sensing module can directly locate the ROI and finely scan the ROI (it can be learned from FIG. 42 that, a density of scan points in the ROI is significantly greater than a density of scan points outside the ROI).

In addition, $t_1$ and $t_2$ may be respectively calculated by using the following two formulas (2) and (3):

$$t_1 = \frac{4 \times M}{N \square K} \tag{2}$$

$$t_2 = \frac{4 \times M}{K} \tag{3}$$

It can be learned from the foregoing formula (2) and formula (3) that, the time required by the TOF depth sensing module to perform a fine scan on the ROI is only 1/N of the time required by the conventional lidar to perform a fine scan, which greatly reduces the time required for the fine scan on the ROI.

Because the TOF depth sensing module can implement discrete scanning, the TOF depth sensing module can implement a fine scan on an ROI (a vehicle, a human, a building, and a random patch) in any shape, especially some asymmetric regions and discrete ROI blocks. In addition, the TOF depth sensing module can also implement uniform or non-uniform point density distribution of a scanned region.

Second case: The optical element 230 is an electro-optic component.

In the second case, when the optical element 230 is an electro-optic component, a control signal may be a voltage signal. The voltage signal may be used to change a refractive index of the electro-optic component, so that the electro-optic component deflects a beam to different directions while a position relative to the light source is unchanged, to obtain an emergent beam whose scanning direction matches the control signal.

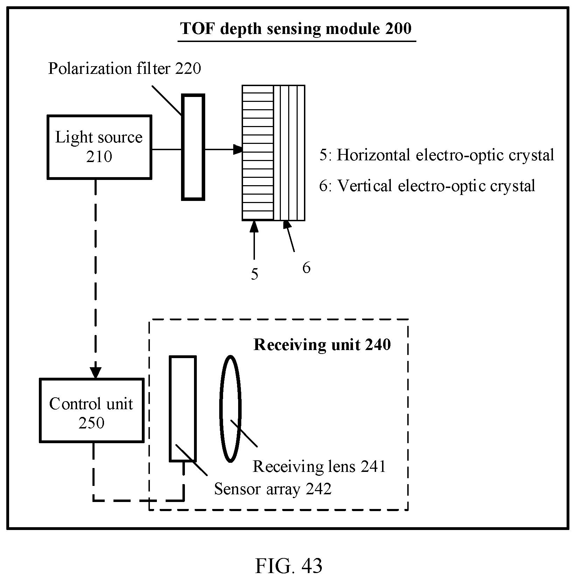

Optionally, as shown in FIG. 43, the electro-optic component may include a horizontal electro-optic crystal (electro-optic crystal for horizontal deflection) and a vertical electro-optic crystal (electro-optic crystal for vertical deflection). The horizontal electro-optic crystal can deflect a beam in a horizontal direction, and the vertical electro-optic crystal can deflect a beam in a vertical direction.

Optionally, the electro-optic crystal may be specifically any one of a potassium tantalate niobate (potassium tantalate niobate, KTN) crystal, a deuterated potassium dihydrogen phosphate (deuterated potassium dihydrogen phosphate, DKDP) crystal, and a lithium niobate (lithium niobate, LN) crystal.

The following briefly describes a working principle of the electro-optic crystal with reference to an accompanying drawing.

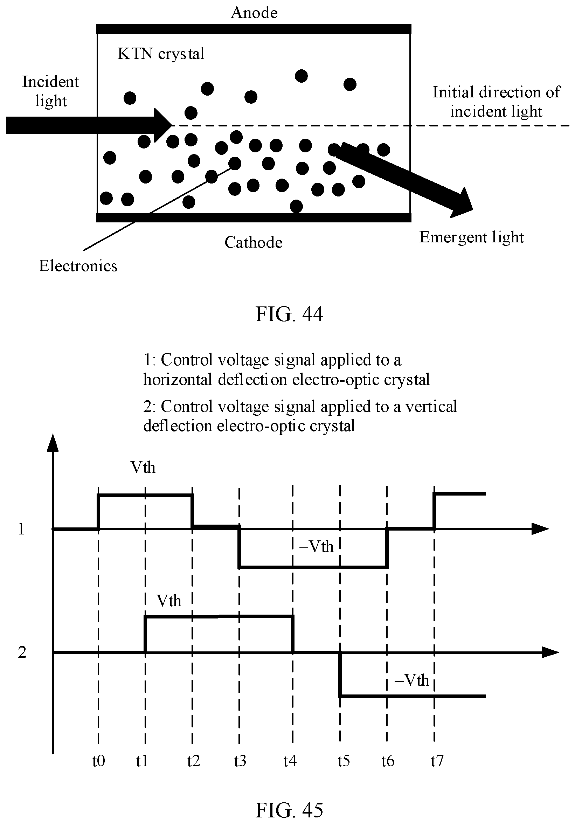

As shown in FIG. 44, when a voltage signal is applied to the electro-optic crystal, due to a second-order photo-electric effect of the electro-optic crystal, a refractive index difference occurs in the electro-optic crystal (that is, refractive indexes of different regions in the electro-optic crystal are different), so that an incident beam is deflected. As shown in FIG. 44, an emergent beam is deflected relative to a direction of the incident beam to some extent.

A deflection angle of the emergent beam relative to the incident beam may be calculated based on the following formula (4):

$$\theta_{\max} = -\frac{1}{2} n^3 E_{\max}^2 L \frac{dg_{11y}}{dy} \tag{4}$$

In the foregoing formula (4), $\theta_{\max}$ represents a maximum deflection angle of the emergent beam relative to the incident beam, n is a refractive index of the electro-optic crystal, $g_{11y}$ is a second-order electro-optic coefficient, $E_{\max}$ represents intensity of a maximum electric field that can be applied to the electro-optic crystal, and $\frac{dg_{11y}}{dy}$ is a second-order electro-optic coefficient gradient in a y direction.

It can be learned from the formula (4) that, a beam deflection angle can be controlled by adjusting intensity of an applied electric field (that is, adjusting a voltage applied to the electro-optic crystal), to scan a target region. In addition, to implement a larger deflection angle, a plurality of electro-optic crystals may be cascaded.

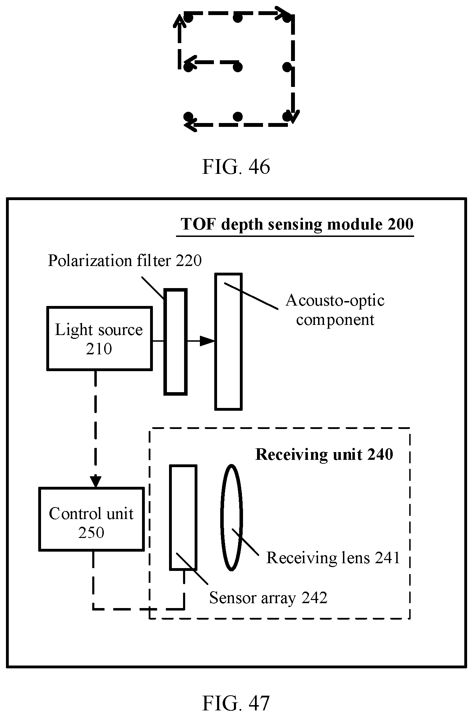

As shown in FIG. 43, the optical element includes a horizontal deflection electro-optic crystal and a vertical deflection electro-optic crystal. The two electro-optic crystals are respectively responsible for beam deflection in the horizontal direction and the vertical direction. After control voltage signals shown in FIG. 45 are applied, a 3x3 scan shown in FIG. 46 can be implemented. Specifically, in FIG. 45, 1 and 2 respectively represent control voltage signals applied to the horizontal deflection electro-optic crystal and the vertical deflection electro-optic crystal.

Third case: The optical element 230 is an acousto-optic component.

As shown in FIG. 47, the optical element 230 is an acousto-optic component. The acousto-optic component may include a transducer. When the optical element 230 is an acousto-optic component, the control signal may be specifically a radio frequency control signal. The radio frequency control signal may be used to control the transducer to generate acoustic waves at different frequencies, to change a refractive index of the acousto-optic component, so that the acousto-optic component deflects a beam to different directions while a position relative to the light source is unchanged, to obtain an emergent beam whose scanning direction matches the control signal.

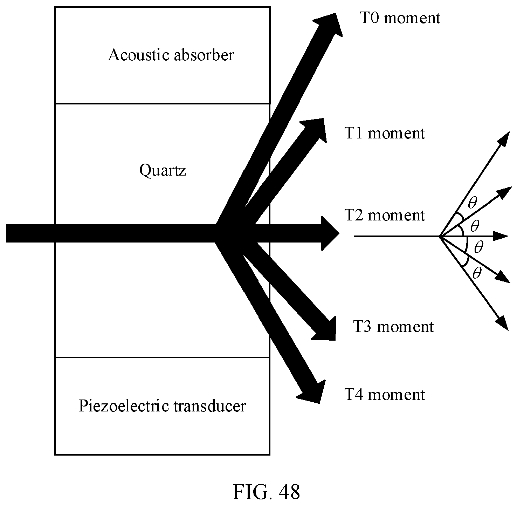

As shown in FIG. 48, the acousto-optic component includes an acoustic absorber, quartz, and a piezoelectric transducer. After the acousto-optic component receives an electrical signal, the piezoelectric transducer can generate an acoustic signal under the action of the electrical signal. The acoustic signal changes refractive index distribution of the quartz when transmitted in the acousto-optic component, to form a grating, so that the quartz can deflect an incident beam to a specific angle. The acousto-optic component can generate beams in different directions at different moments when different control signals are input at the different moments. As shown in FIG. 48, emergent beams of the quartz at different moments (T0, T1, T2, T3, and T4) may have different deflection directions.

When the electrical signal incident into the acousto-optic component is a periodic signal, because the refractive index distribution of the quartz in the acousto-optic component is periodically changed, a periodic grating is formed, and an incident beam can be periodically deflected by using the periodic grating.

In addition, intensity of the emergent light of the acousto-optic component is directly related to a power of a radio frequency control signal input to the acousto-optic component, and a diffraction angle of the incident beam is directly related to a frequency of the radio frequency control signal. An angle of the emergent beam can also be correspondingly adjusted by changing the frequency of the radio frequency control signal. Specifically, a deflection angle of the emergent beam relative to the incident beam may be determined based on the following formula (5):

$$\theta = \arcsin \frac{\lambda}{v_s} f_s \qquad\qquad (5)$$

In the foregoing formula (5), $\theta$ is the deflection angle of the emergent beam relative to the incident beam, $\lambda$ is a wavelength of the incident beam, $f_s$ is the frequency of the radio frequency control signal, and $v_s$ is a velocity of an acoustic wave. Therefore, the acousto-optic omonent can enable a beam to perform scanning within a large angle range, and can accurately control an emergent angle of the beam.

Fourth case: The optical element 230 is an optical phased array (optical phased array, OPA) component.

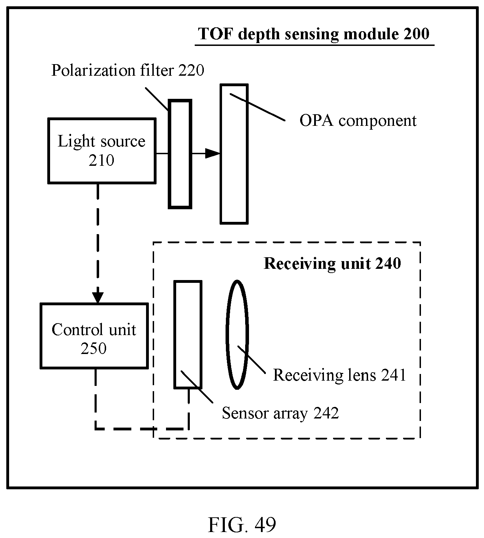

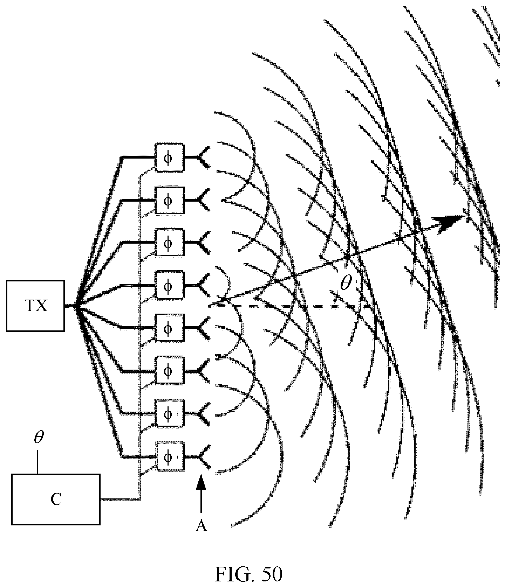

The following describes, in detail with reference to FIG. 49 and FIG. 50, the optical element 230 that is an OPA component.

As shown in FIG. 49, the optical element 230 is an OPA component, and an incident beam can be deflected by using the OPA component, to obtain an emergent beam whose scanning direction matches the control signal.

The OPA component generally includes a one-dimensional or two-dimensional phase shifter array. When there is no phase difference between phase shifters, light reaches an equiphase surface at the same time, and the light is propagated forward without interference. Therefore, no beam deflection occurs.

After a phase difference is added to each phase shifter (for example, a uniform phase difference is assigned to each optical signal, where a phase difference between a second waveguide and a first waveguide is $\Delta$, a phase difference between a third waveguide and the first waveguide is $2\Delta$, and so on), in this case, the equiphase surface is not perpendicular to a waveguide direction, but is deflected to some extent. Beams that meet an equiphase relationship are coherent and constructive, and beams that do not meet the equiphase condition cancel each other. Therefore, directions of beams are always perpendicular to the equiphase surface.

As shown in FIG. 50, assuming that a spacing between adjacent waveguides is d, an optical path difference between beams that are output by the adjacent waveguides and reach the equiphase surface is $\Delta R = d \cdot \sin\theta$. $\theta$ represents a beam deflection angle. Because the optical path difference is caused by a phase difference between array elements, $\Delta R = \Delta \cdot \lambda / 2\pi$. Therefore, a beam may be deflected by introducing a phase difference to array elements. This is how the OPA deflects a beam.

Therefore, the deflection angle is $\theta = \arcsin(\Delta \cdot \lambda / (2\pi^* d))$. If phase differences between adjacent phase shifters are controlled to, for example, $\pi/12$ and $\pi/6$, beam deflection angles are $\arcsin(\lambda/(24d))$ and $\arcsin(\lambda/(12d))$. In this way, deflection in any two-dimensional direction can be implemented by controlling a phase of the phase shifter array. The phase shifters may be made of a liquid crystal material, and different phase differences between liquid crystals are generated by applying different voltages.

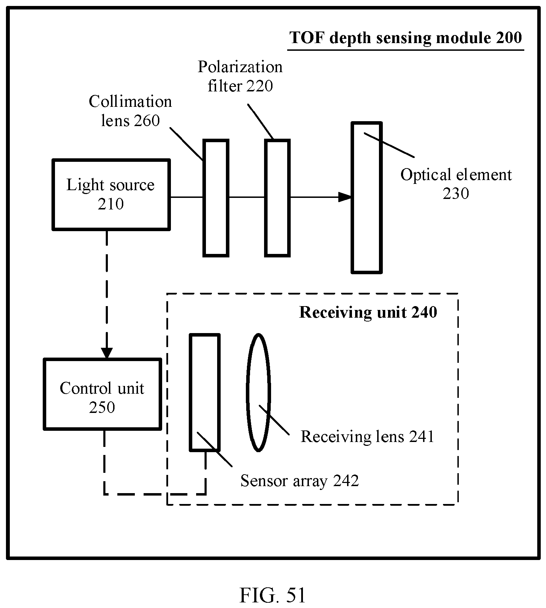

Optionally, as shown in FIG. 51, the TOF depth sensing module 200 further includes:

a collimation lens 260. The collimation lens 260 is located between the light source 210 and the polarization filter 220. The collimation lens 260 is configured to collimate the beam. The polarization filter 220 is configured to filter a processed beam of the collimation lens 260, to obtain a beam in a single polarization state.

In addition, the collimation lens 260 may alternatively be located between the polarization filter 220 and the optical element 230. In this case, the polarization filter 220 first performs polarization filtering on the beam generated by the light source, to obtain a beam in a single polarization state, and the collimation lens 260 then collimates the beam in the single polarization state.

Optionally, the collimation lens 260 may alternatively be located on a right side of the optical element 230 (a distance between the collimation lens 260 and the light source 210 is greater than a distance between the optical element 230 and the light source 210). In this case, after the optical element 230 adjusts a direction of the beam in the single polarization state, the collimation lens 260 collimates the beam that is in the single polarization state and whose direction is adjusted.

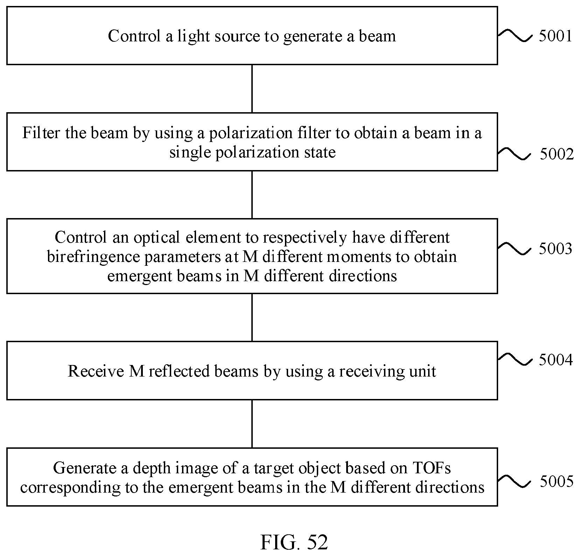

The foregoing describes in detail a TOF depth sensing module 200 with reference to FIG. 26 to FIG. 51, and the following describes an image generation method with reference to FIG. 52.

FIG. 52 is a schematic flowchart of an image generation method.

The method shown in FIG. 52 may be performed by a TOF depth sensing module in an embodiment of this application or a terminal device including a TOF depth sensing module in an embodiment of this application. Specifically, the method shown in FIG. 52 may be performed by the TOF depth sensing module 200 shown in FIG. 27 or a terminal device including the TOF depth sensing module 200 shown in FIG. 27. The method shown in FIG. 52 includes steps 4001 to 4005, which are described in detail below.

5001. Control the light source to generate a beam.

The light source can generate light in a plurality of polarization states.

For example, the light source may generate light in a plurality of polarization states such as linear polarization, left-handed circular polarization, and right-handed circular polarization.

5002. Filter the beam by using the polarization filter to obtain a beam in a single polarization state.

The single polarization state may be any one of the linear polarization, the left-handed circular polarization, and the right-handed circular polarization.

For example, in step 5001, the beam generated by the light source includes linearly polarized light, left-handed circularly polarized light, and right-handed circularly polarized light. Then, in step 5002, light whose polarization states are the left-handed circularly polarized light and the right-handed circularly polarized light in the beam may be filtered out, and only linearly polarized light in a specific direction is retained. Optionally, the polarization filter may further include a 1/4 wave plate, so that the retained linearly polarized light is converted into left-handed circularly polarized light (or right-handed circularly polarized light).

5003. Control the optical element to respectively have different birefringence parameters at M different moments to obtain emergent beams in M different directions.

The birefringence parameter of the optical element is controllable, and the optical element can adjust the beam in the single polarization state to different directions by using different birefringence of the optical element. M a positive integer greater than 1. The M reflected beams are beams obtained by reflecting the emergent beams in the M different directions by a target object.

In this case, the optical element may be a liquid crystal polarization grating. For specific details of the liquid crystal polarization grating, refer to the description of the first case above.

Optionally, that the optical element has different birefringence parameters at M moments may specifically include the following two cases:

Case 1: Birefringence parameters of the optical element at any two of the M moments are different.

Case 2: The optical element has at least two moments in the M moments, and birefringence parameters of the optical element at the at least two moments are different.

In case 1, assuming that M=5, the optical element respectively corresponds to five different birefringence parameters at five moments.

In case 2, assuming that M=5, the optical element may correspond to different birefringence parameters at two of five moments.

5004. Receive M reflected beams by using the receiving unit.

5005. Generate a depth image of the target object based on TOFs corresponding to the emergent beams in the M different directions.

The TOFs corresponding to the emergent beams in the M different directions may specifically refer to time difference information between moments at which the reflected beams corresponding to the emergent beams in the M different directions are received by the receiving unit and emission moments of the emergent beams in the M different directions.

Assuming that the emergent beams in the M different directions include an emergent beam 1, a reflected beam corresponding to the emergent beam 1 may be a beam that is generated after the emergent beam 1 reaches the target object and is reflected by the target object.

**[0531]** , because the beam can be adjusted to different directions by using different birefringence of the optical element, the propagation direction of the beam can be adjusted by controlling the birefringence parameter of the optical element. In this way, the propagation direction of the beam is adjusted in a non-mechanical-rotation manner, so that discrete scanning of the beam can be implemented, and depth or distance measurement of an ambient environment and a target object can be performed more flexibly.

Optionally, the generating a depth image of the target object in step 5005 specifically includes:

5005a. Determine distances between the TOF depth sensing module and M regions of the target object based on the TOFs corresponding to the emergent beams in the M different directions.

5005b. Generate depth images of the M regions of the target object based on the distances between the TOF depth sensing module and the M regions of the target object; and synthesize the depth image of the target object based on the depth images of the M regions of the target object.

In the method shown in FIG. 52, the beam may be further collimated.

Optionally, before step 5002, the method shown in FIG. 52 further includes:

5006. Collimate the beam to obtain a collimated beam.

After the beam is collimated, the obtaining a beam in a single polarization state in step 5002 specifically includes: filtering the collimated beam by using the polarization filter to obtain a light in a single polarization state.

Before the polarization filter is used to filter the beam to obtain the beam in the single polarization state, the beam is collimated, so that an approximately parallel beam can be obtained, thereby improving a power density of the beam, and further improving an effect of scanning by the beam subsequently.

The collimated beam may be quasi-parallel light whose divergence angle is less than 1 degree.

It should be understood that, in the method shown in FIG. 52, the beam in the single polarization state may be further collimated. Specifically, the method shown in FIG. 52 further includes:

5007. Collimate the beam in the single polarization state to obtain a collimated beam.

Step 5007 may be performed between step 5002 and step 5003, or step 5007 may be performed between step 5003 and step 5004.

When step 5007 is performed between step 5002 and step 5003, after the polarization filter filters the beam generated by the light source, the beam in the single polarization state is obtained, and then the beam in the single polarization state is collimated by using the collimation lens to obtain a collimated beam. Next, the propagation direction of the beam in the single polarization state is controlled by using the optical element.

When step 5007 is performed between step 5003 and step 5004, after the optical element changes the propagation direction of the beam in the single polarization state, the collimation lens collimates the beam in the single polarization state, to obtain a collimated beam.

It should be understood that, in the method shown in FIG. 52, step 5006 and step 5007 are optional steps, and either step 5006 or step 5007 may be selected to be performed.

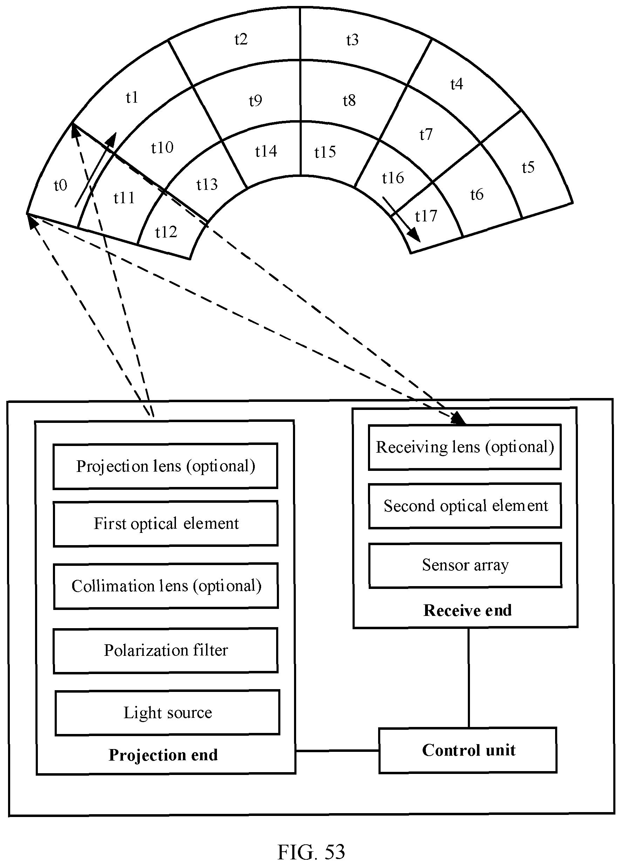

The foregoing describes in detail one TOF depth sensing module and image generation method with reference to FIG. 26 to FIG. 52. The following describes in detail another TOF depth sensing module and image generation method with reference to FIG. 53 to FIG. 69.

A conventional TOF depth sensing module usually uses a pulsed TOF technology for scanning. However, the pulsed TOF technology requires high sensitivity of a photodetector to detect a single photon. A common photodetector is a single-photon avalanche diode (SPAD). Due to a complex interface and processing circuit of the SPAD, a resolution of a common SPAD sensor is low, which cannot meet a high spatial resolution requirement of depth sensing. Therefore, an embodiment of this application provides a TOF depth sensing module and an image generation method, to improve a spatial resolution of depth sensing through block illumination and time-division multiplexing. The following describes in detail such a TOF depth sensing module and image generation method with reference to accompanying drawings.

The following first briefly describes the TOF depth sensing module with reference to FIG. 53.

FIG. 53 is a schematic diagram of measuring a distance by using a TOF depth sensing module according to an embodiment of this application.

As shown in FIG. 53, the TOF depth sensing module includes a transmit end (which may also be referred to as a projection end), a receive end, and a control unit. The transmit end is configured to emit an emergent beam. The receive end is configured to receive a reflected beam of a target object (the reflected beam is a beam obtained by reflecting the emergent beam by the target object). The control unit controls the transmit end and the receive end to transmit and receive the beam, respectively.

In FIG. 53, the transmit end generally includes a light source, a polarization filter, a collimation lens (optional), a first optical element, and a projection lens (optional), and the receive end generally includes a receiving lens, a second optical element, and a sensor. In FIG. 53, a TOF corresponding to the emergent beam may be recorded by using a timing apparatus, to calculate a distance from the TOF depth sensing module to a target region, to obtain a final depth image of the target object. The TOF corresponding to the emergent beam may refer to time difference information between a moment at which the reflected beam is received by the receiving unit and an emission moment of the emergent beam.

As shown in FIG. 53, a FOV of a beam is adjusted by using a beam shaper and the first optical element, so that different scanning beams can be emitted at moments t0 to t17. A target FOV can be achieved by splicing FOVs of the beams emitted at the moments t0 to t17, so that a resolution of the TOF depth sensing module can be improved.

The TOF depth sensing module in this embodiment of this application is configured to obtain a 3D image. The TOF depth sensing module in this embodiment of this application may be disposed on an intelligent terminal (for example, a mobile phone, a tablet, or a wearable device), to obtain a depth image or a 3D image, which may also provide gesture and limb recognition for a 3D game or a somatic game.

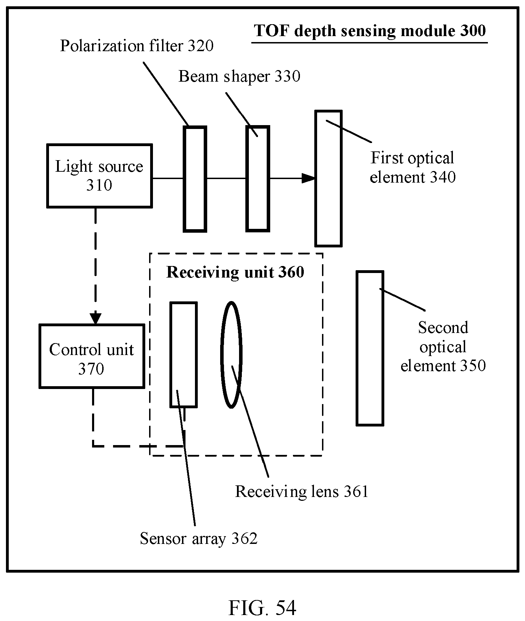

The following describes in detail the TOF depth sensing module in this embodiment of this application with reference to FIG. 54.

FIG. 54 is a schematic block diagram of a TOF depth sensing module according to an embodiment of this application.

The TOF depth sensing module 300 shown in FIG. 54 includes a light source 310, a polarization filter 320, a beam shaper 330, a first optical element 340, a second optical element 350, a receiving unit 360, and a control unit 370. As shown in FIG. 54, a transmit end of the TOF depth sensing module 300 includes the light source 310, the polarization filter 320, the beam shaper 330, and the first optical element 340. A receive end of the TOF depth sensing module 300 includes the second optical element 350 and the receiving unit 360. The first optical element 340 and the second optical element 350 are elements located at the transmit end and the receive end of the TOF depth sensing module 300, respectively. The first optical element mainly controls a direction of a beam at the transmit end to obtain an emergent beam. The second optical element mainly controls a direction of a reflected beam, to deflect the reflected beam to the receiving unit.

The following describes in detail the several modules or units in the TOF depth sensing module 300.

Light source 310:

The light source 310 is configured to generate a beam. Specifically, the light source 310 can generate light in a plurality of polarization states.

Optionally, the light source 310 may be a laser light source, a light emitting diode (light emitting diode, LED) light source, or a light source in another form. This is not exhaustive in the present invention.

Optionally, the light source 310 is a laser light source. It should be understood that the beam from the laser light source may also be referred to as a laser beam. For ease of description, they are collectively referred to as a beam in this embodiment of this application.

Optionally, the beam emitted by the light source 310 is a single quasi-parallel beam, and a divergence angle of the beam emitted by the light source 310 is less than 1°.

Optionally, the light source 310 may be a semiconductor laser light source.

The light source may be a vertical cavity surface emitting laser (vertical cavity surface emitting laser, VCSEL).

Optionally, the light source 310 is a Fabry-Perot laser (which may be referred to as an FP laser for short).

A single FP laser can implement a larger power than a single VCSEL, and has higher electro-optical conversion efficiency than the VCSEL, thereby improving a scanning effect.

Optionally, a wavelength of the beam emitted by the light source 310 is greater than 900 nm.

Because intensity of light whose wavelength is greater than 900 nm in sunlight is weak, when the wavelength of the beam is greater than 900 nm, interference caused by the sunlight can be reduced, thereby improving a scanning effect of the TOF depth sensing module. Optionally, a wavelength of the beam emitted by the light source 310 is 940 nm or 1550 nm.

Because intensity of light whose wavelength is near 940 nm or 1550 nm in sunlight is weak, when the wavelength of the beam is 940 nm or 1550 nm, interference caused by the sunlight can be greatly reduced, thereby improving a scanning effect of the TOF depth sensing module.

A light emitting area of the light source 310 is less than or equal to $5\times5$ mm$^2$.

Because a size of the light source is small, the TOF depth sensing module 300 including the light source is easily integrated into a terminal device, and a space occupied in the terminal device can be reduced to some extent.

Optionally, an average output optical power of the TOF depth sensing module is less than 800 mw.

When the average output optical power of the TOF depth sensing module is less than or equal to 800 mw, the TOF depth sensing module has small power consumption, and can be disposed in a device sensitive to power consumption, such as a terminal device.

Polarization filter 320:

The polarization filter 320 is configured to filter the beam to obtain a beam in a single polarization state.

The single polarization state of the beam obtained by the polarization filter 320 through filtering is one of the plurality of polarization states of the beam generated by the light source 310.

For example, the beam generated by the light source 310 includes linearly polarized light, left-handed circularly polarized light, and right-handed circularly polarized light. In this case, the polarization filter 320 may filter out light whose polarization states are the left-handed circularly polarized light and the right-handed circularly polarized light in the beam, and retain only linearly polarized light in a specific direction. Optionally, the polarization filter may further include a 1/4 wave plate, so that the retained linearly polarized light is converted into left-handed circularly polarized light (or right-handed circularly polarized light).

Beam shaper 330:

The beam shaper 330 is configured to adjust the beam to obtain a first beam.

It should be understood that, in this embodiment of this application, the beam shaper 330 is specifically configured to increase a field of view FOV of the beam.

A FOV of the first beam meets a first preset range.

Optionally, the first preset range may be [5°×5°, 20°×20°]. It should be understood that a FOV in a horizontal direction of the FOV of the first beam may range from 5° to 20° (including 5° and 20°), and a FOV in a vertical direction of the FOV of the first beam may range from 5° to 20° (including 5° and 20°).

It should be further understood that other ranges less than 5°×5° or greater than 20°×20° fall within the protection scope of this application provided that the inventive concept of this application can be met. However, for ease of description, exhaustive descriptions are not provided herein. Control unit 370:

The control unit 370 is configured to control the first optical element to respectively control a direction of the first beam at M different moments, to obtain emergent beams in M different directions.

A total FOV covered by the emergent beams in the M different directions meets a second preset range.

Optionally, the second preset range may be [50°×50°, 80°×80°].

Similarly, other ranges less than 50°×50° or greater than 80°×80° fall within the protection scope of this application provided that the inventive concept of this application can be met. However, for ease of description, exhaustive descriptions are not provided herein.

The control unit 370 is further configured to control the second optical element to respectively deflect, to the receiving unit, M reflected beams that are obtained by reflecting the emergent beams in the M different directions by a target object.

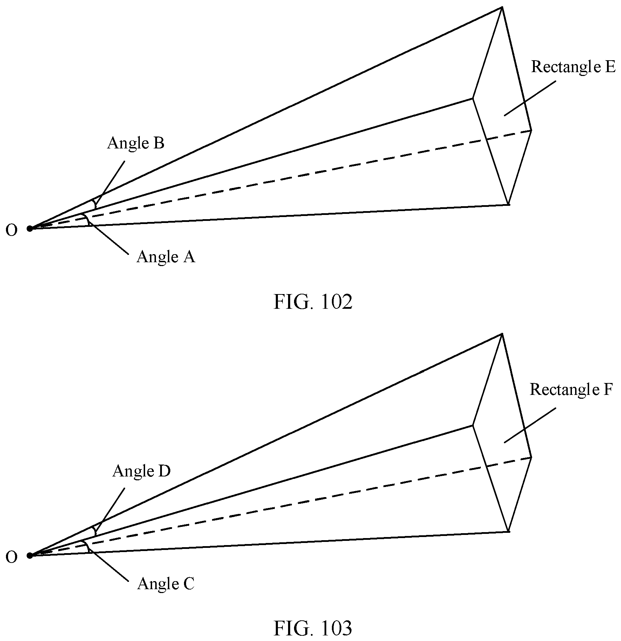

It should be understood that the FOV of the first beam obtained through processing by the beam shaper in the TOF depth sensing module 300 and the total FOV obtained through scanning in the M different directions are described below with reference to FIG. 102 to FIG. 104. Details are not described herein.

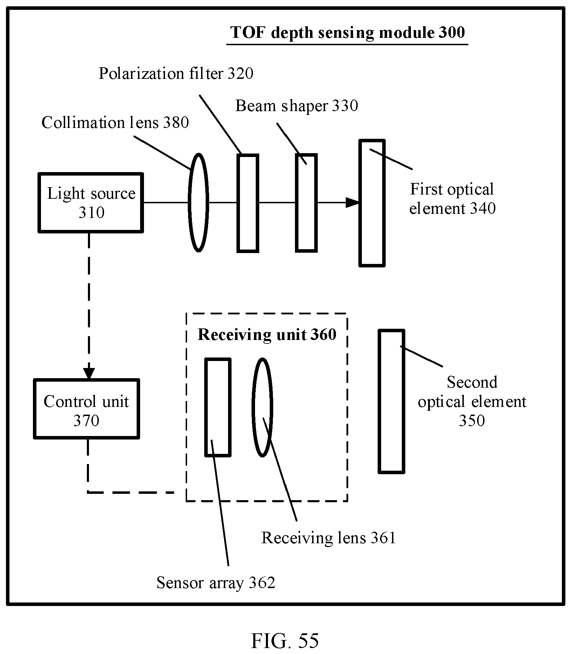

In this embodiment of this application, the beam shaper adjusts the FOV of the beam so that the first beam has a large FOV, and scanning is performed in a time division multiplexing manner (the first optical element emits emergent beams in different directions at different moments), thereby improving a spatial resolution of the finally obtained depth image of the target object. FIG. 55 is a schematic block diagram of a TOF depth sensing module according to an embodiment of this application.

As shown in FIG. 55, the TOF depth sensing module further includes a collimation lens 380. The collimation lens 380 is located between the light source 310 and the polarization filter 320. The collimation lens 380 is configured to collimate the beam. The polarization filter 320 is configured to filter a collimated beam of the collimation lens 380, to obtain a beam in a single polarization state.

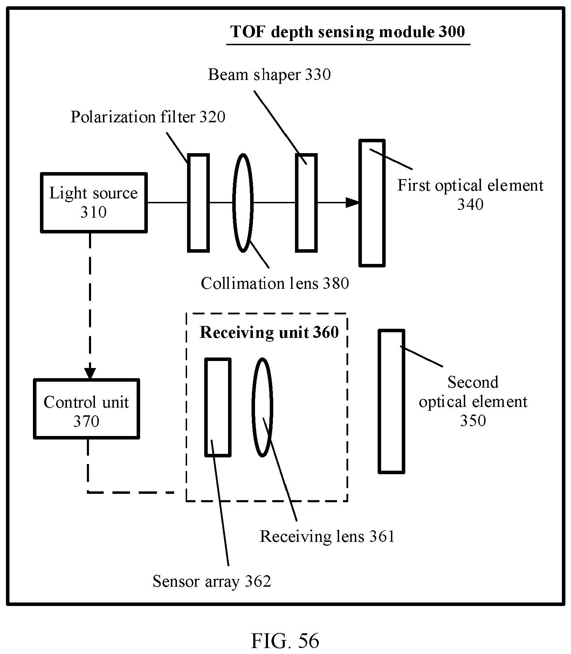

FIG. 56 is a schematic block diagram of a TOF depth sensing module according to an embodiment of this application. In FIG. 56, the collimation lens 380 may alternatively be located between the polarization filter 320 and the beam shaper 330. The collimation lens 380 is configured to collimate the beam in the single polarization state. The beam shaper 330 is configured to adjust a FOV of a collimated beam of the collimation lens 380, to obtain a first beam.

In the foregoing, the collimation lens collimates the beam, so that an approximately parallel beam can be obtained, thereby improving a power density of the beam, and further improving an effect of scanning by the beam subsequently.

Optionally, a clear aperture of the collimation lens is less than or equal to 5 mm.

Because a size of the collimation lens is small, the TOF depth sensing module including the collimation lens is easily integrated into a terminal device, and a space occupied in the terminal device can be reduced to some extent.

It should be understood that the collimation lens may alternatively be located between the beam shaper 330 and the first optical element 340. In this case, the collimation lens collimates a shaped beam of the beam shaper 330, and a collimated beam is then processed by the first optical element.

In addition, the collimation lens 380 may be located at any possible position in the TOF depth sensing module 300 and collimate a beam in any possible process.

Optionally, a horizontal distance between the first optical element and the second optical element is less than or equal to 1 cm.

Optionally, the first optical element and/or the second optical element is a rotating mirror component.

The rotating mirror component rotates to control emergent directions of the emergent beams.

The rotating mirror component may be specifically a microelectromechanical system galvanometer or a multifaceted rotating mirror.

The first optical element may be any one of components such as a liquid crystal polarization grating, an electro-optic component, an acousto-optic component, and an optical phased array component. The second optical element may alternatively be any one of components such as a liquid crystal polarization grating, an electro-optic component, an acousto-optic component, and an optical phased array component. For specific content of the components such as the liquid crystal polarization grating, the electro-optic component, the acousto-optic component, and the optical phased array component, refer to the descriptions in the first case to the fourth case above.

As shown in FIG. 35, the liquid crystal polarization grating includes not only a horizontal LCPG and a vertical LCPG, but also a horizontal polarization control sheet and a vertical polarization control sheet. In FIG. 35, the horizontal LCPG is located between the horizontal polarization control sheet and the vertical polarization control sheet, and the vertical polarization control sheet is located between the horizontal LCPG and the vertical LCPG.

Optionally, the components in the liquid crystal polarization grating shown in FIG. 35 may have the following several combination manners.

A combination manner 1 is 124.

A combination manner 2 is 342.

A combination manner 3 is 3412.

In the combination manner 1, 1 may represent the horizontal polarization control sheet and the vertical polarization control sheet that are closely attached. In the combination manner 2, 3 may represent the horizontal polarization control sheet and the vertical polarization control sheet that are closely attached.

When the first optical element 340 or the second optical element 350 in the combination manner 1 or the combination manner 2 is placed in the TOF depth sensing module, the horizontal polarization control sheet and the vertical polarization control sheet are both located on a side close to the light source, and the horizontal LCPG and the vertical LCPG are both located on a side far from the light source.

When the first optical element 340 or the second optical element 350 in the combination manner 3 is placed in the TOF depth sensing module, distances between the light source and the vertical polarization control sheet, the vertical LCPG, the horizontal polarization control sheet, and the horizontal LCPG are in ascending order of magnitude.

It should be understood that the foregoing three combination manners of the liquid crystal polarization grating and the combination manner in FIG. 35 are merely examples. Actually, the components in the optical element in this application may have other different combination manners, provided that a distance between the horizontal polarization control sheet and the light source is less than a distance between the horizontal LCPG and the light source, and a distance between the horizontal polarization control sheet and the light source is less than a distance between the horizontal LCPG and the light source.

Optionally, the second optical element includes: a horizontal polarization control sheet, a horizontal liquid crystal polarization grating, a vertical polarization control sheet, and a vertical liquid crystal polarization grating, and distances between the sensor and them are in ascending order of magnitude.

Optionally, the beam shaper includes a diffusion lens and a rectangular aperture stop.

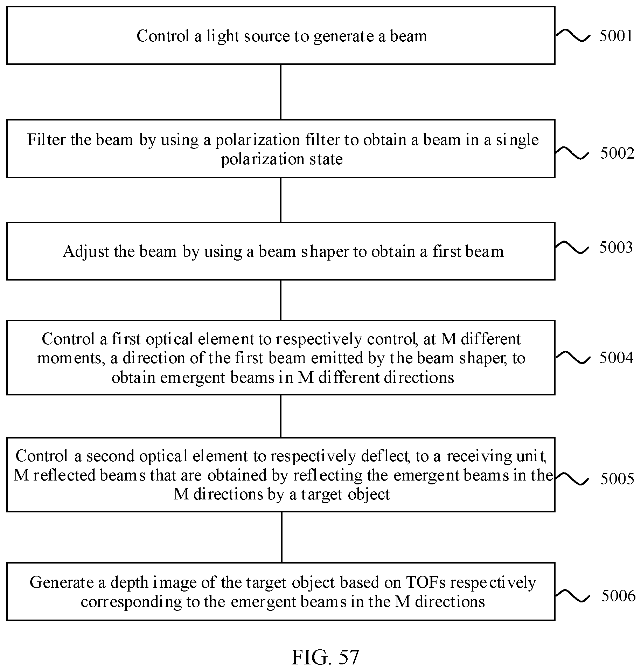

The foregoing describes a TOF depth sensing module in an embodiment of this application with reference to FIG. 53 to FIG. 56, and the following describes in detail an image generation method in an embodiment of this application with reference to FIG. 57.

FIG. 57 is a schematic flowchart of an image generation method according to an embodiment of this application.

The method shown in FIG. 57 may be performed by a TOF depth sensing module or a terminal device including a TOF depth sensing module in an embodiment of this application. Specifically, the method shown in FIG. 57 may be performed by the TOF depth sensing module shown in FIG. 54 or a terminal device including the TOF depth sensing module shown in FIG. 54. The method shown in FIG. 57 includes steps 5001 to 5006, which are described in detail below.

5001. Control the light source to generate a beam.

5002. Filter the beam by using the polarization filter to obtain a beam in a single polarization state.

The single polarization state is one of the plurality of polarization states.

For example, the plurality of polarization states may include linear polarization, left-handed circular polarization, and right-handed circular polarization, and the single polarization state may be any one of the linear polarization, the left-handed circular polarization, and the right-handed circular polarization.

5003. Adjust the beam by using the beam shaper to obtain a first beam.

Optionally, step 5003 specifically includes: adjusting angular intensity distribution of the beam in the single polarization state by using the beam shaper to obtain the first beam.

It should be understood that, in this embodiment of this application, the adjusting the beam by using the beam shaper is specifically increasing a field angle FOV of the beam by using the beam shaper.

That is, step 5003 may alternatively specifically include: increasing angular intensity distribution of the beam in the single polarization state by using the beam shaper to obtain the first beam.

A FOV of the first beam meets a first preset range.

Optionally, the first preset range may be [5°×5°, 20°×20°].

5004. Control the first optical element to respectively control a direction of the first beam from the beam shaper at M different moments, to obtain emergent beams in M different directions.

A total FOV covered by the emergent beams in the M different directions meets a second preset range.

Optionally, the second preset range may be [50°×50°, 80°×80°].

5005. Control the second optical element to respectively deflect, to the receiving unit, M reflected beams that are obtained by reflecting the emergent beams in the M different directions by a target object.

5006. Generate a depth image of the target object based on TOFs respectively corresponding to the emergent beams in the M different directions.

In this embodiment of this application, the beam shaper adjusts the FOV of the beam so that the first beam has a large FOV, and scanning is performed in a time division multiplexing manner (the first optical element emits emergent beams in different directions at different moments), thereby improving a spatial resolution of the finally obtained depth image of the target object.

Optionally, step 5006 specifically includes: generating depth images of the M regions of the target object based on the distances between the TOF depth sensing module and the M regions of the target object; and synthesizing the depth image of the target object based on the depth images of the M regions of the target object.

Optionally, step 5004 specifically includes: the control unit generates a first voltage signal. The first voltage signal is used to control the first optical element to respectively control the direction of the first beam at the M different moments, to obtain the emergent beams in the M different directions. Step 5005 includes: the control unit generates a second voltage signal. The second voltage signal is used to control the second optical element to respectively deflect, to the receiving unit, the M reflected beams that are obtained by reflecting the emergent beams in the M different directions by the target object.

Voltage values of the first voltage signal and the second voltage signal are the same at a same moment.

In the TOF depth sensing module 300 shown in FIG. 54, the transmit end and the receive end respectively use different optical elements to control beam emission and reception.

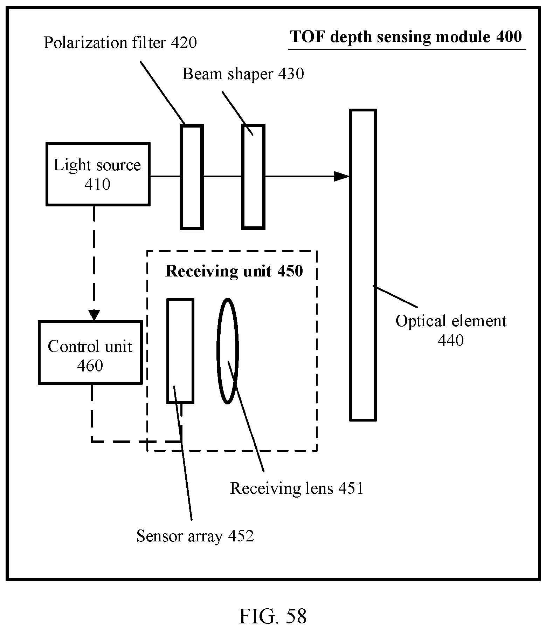

The following describes, in detail with reference to FIG. 58, beam emission and reception when the transmit end and the receive end shares a same optical element.

FIG. 58 is a schematic block diagram of a TOF depth sensing module according to an embodiment of this application.

The TOF depth sensing module 400 shown in FIG. 58 includes a light source 410, a polarization filter 420, a beam shaper 430, an optical element 440, a receiving unit 450, and a control unit 460. As shown in FIG. 58, a transmit end of the TOF depth sensing module 400 includes the light source 410, the polarization filter 420, the beam shaper 430, and the optical element 440, and a receive end of the TOF depth sensing module 400 includes the optical element 440 and the receiving unit 450. The transmit end and the receive end of the TOF depth sensing module 400 share the optical element 440. The optical element 440 can control a beam at the transmit end to obtain an emergent beam, and can control a reflected beam to deflect the reflected beam to the receiving unit 450.

The following describes in detail the several modules or units in the TOF depth sensing module 400.

Light source 410:

The light source 410 is configured to generate a beam.

Optionally, the beam emitted by the light source 410 is a single quasi-parallel beam, and a divergence angle of the beam emitted by the light source 410 is less than 1°.

Optionally, the light source 410 is a semiconductor laser light source.

The light source 410 may be a vertical cavity surface emitting laser (vertical cavity surface emitting laser, VCSEL).

Optionally, the light source 410 may alternatively be a Fabry-Perot laser (which may be referred to as an FP laser for short).

A single FP laser can implement a larger power than a single VCSEL, and has higher electro-optical conversion efficiency than the VCSEL, thereby improving a scanning effect.

Optionally, a wavelength of the beam emitted by the light source 410 is greater than 900 nm.

Because intensity of light whose wavelength is greater than 900 nm in sunlight is weak, when the wavelength of the beam is greater than 900 nm, interference caused by the sunlight can be reduced, thereby improving a scanning effect of the TOF depth sensing module.

Optionally, a wavelength of the beam emitted by the light source 410 is 940 nm or 1550 nm.

Because intensity of light whose wavelength is near 940 nm or 1550 nm in sunlight is weak, when the wavelength of the beam is 940 nm or 1550 nm, interference caused by the sunlight can be greatly reduced, thereby improving a scanning effect of the TOF depth sensing module.

A light emitting area of the light source 410 is less than or equal to $5 \times 5$ mm$^2$.

Because a size of the light source is small, the TOF depth sensing module 400 including the light source is easily integrated into a terminal device, and a space occupied in the terminal device can be reduced to some extent.

Optionally, an average output optical power of the TOF depth sensing module 400 is less than 800 mw.

When the average output optical power of the TOF depth sensing module is less than or equal to 800 mw, the TOF depth sensing module has small power consumption, and can be disposed in a device sensitive to power consumption, such as a terminal device.

The polarization filter 420 is configured to filter the beam to obtain a beam in a single polarization state.

The beam shaper 430 is configured to increase a FOV of the beam in the single polarization state to obtain a first beam.

The control unit 460 is configured to control the optical element 440 to respectively control a direction of the first beam at M different moments, to obtain emergent beams in M different directions.

The control unit 460 is further configured to control the optical element 440 to respectively deflect, to the receiving unit 450, M reflected beams that are obtained by reflecting the emergent beams in the M different directions by a target object.

The single polarization state is one of the plurality of polarization states.

For example, the plurality of polarization states may include linear polarization, left-handed circular polarization, and right-handed circular polarization, and the single polarization state may be any one of the linear polarization, the left-handed circular polarization, and the right-handed circular polarization.

The FOV of the first beam meets a first preset range, and a total FOV covered by the emergent beams in the M different directions meets a second preset range. More specifically, the second preset range is greater than the first preset range. More generally, a FOV within the first preset range is A°, and may cover a view within A°*A°, and a range of A is not less than 3 and not greater than 40. A FOV within the second preset range is B°, and may cover a view within B°*B°, and a range of B is not less than 50 and not greater than 120. It should be understood that components in the art may have appropriate deviations in a specific manufacturing process.

Optionally, the first preset range may include [5°×5°, 20°×20°], that is, A is not less than 5, and is not greater than 20. The second preset range may include [50°×50°, 80°×80°], that is, B is not less than 50, and is not greater than 80.

In this embodiment of this application, the beam shaper adjusts the FOV of the beam so that the first beam has a large FOV, and scanning is performed in a time division multiplexing manner (the optical element emits emergent beams in different directions at different moments), thereby improving a spatial resolution of the finally obtained depth image of the target object.

Optionally, the control unit 460 is further configured to generate a depth image of the target object based on TOFs respectively corresponding to the emergent beams in the M different directions.

The TOFs corresponding to the emergent beams in the M different directions may specifically refer to time difference information between moments at which the reflected beams corresponding to the emergent beams in the M different directions are received by the receiving unit and emission moments of the emergent beams in the M different directions.

Assuming that the emergent beams in the M different directions include an emergent beam 1, a reflected beam corresponding to the emergent beam 1 may be a beam that is generated after the emergent beam 1 reaches the target object and is reflected by the target object.

Optionally, the definitions of the light source 310, the polarization filter 320, and the beam shaper 330 in the TOF depth sensing module 300 above are also applicable to the light source 410, the polarization filter 420, and the beam shaper 430 in the TOF depth sensing module 400.

Optionally, the optical element is a rotating mirror component.

The rotating mirror component rotates to control an emergent direction of the emergent beam.

Optionally, the rotating mirror component is a microelectromechanical system galvanometer or a multifaceted rotating mirror.

The following describes, in detail with reference to accompanying drawings, the optical element that is a rotating mirror component.

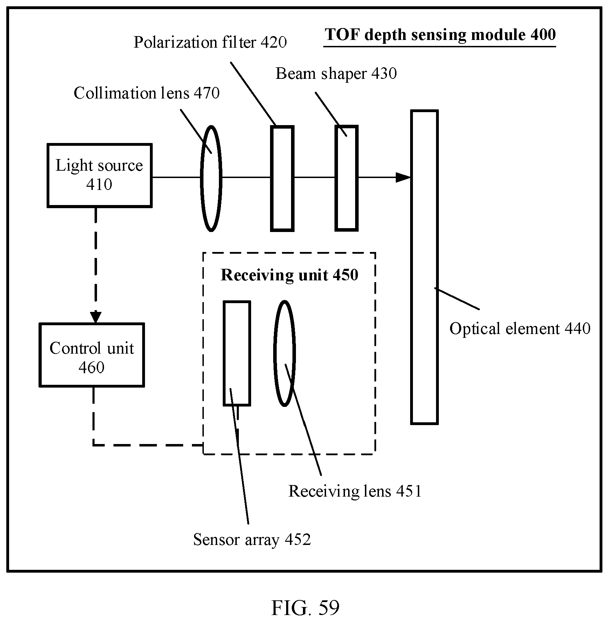

FIG. 59 is a schematic block diagram of a TOF depth sensing module according to an embodiment of this application.

As shown in FIG. 59, the TOF depth sensing module further includes a collimation lens 470. The collimation lens 470 is located between the light source 410 and the polarization filter 420. The collimation lens 470 is configured to collimate the beam. The polarization filter 420 is configured to filter a collimated beam of the collimation lens 470, to obtain a beam in a single polarization state.

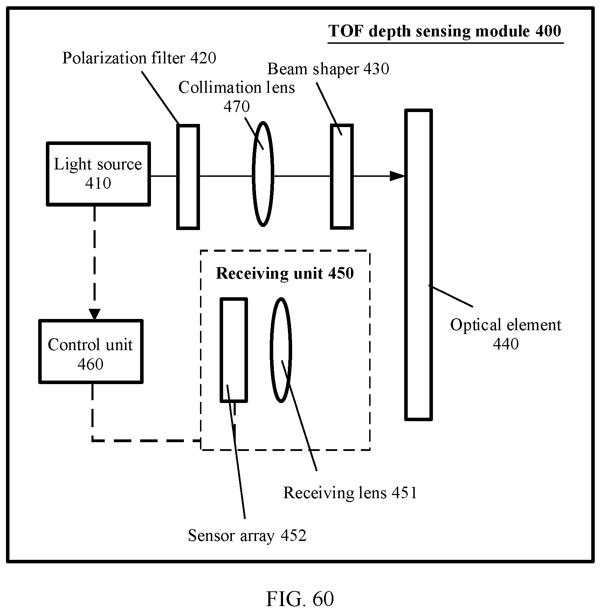

FIG. 60 is a schematic block diagram of a TOF depth sensing module according to an embodiment of this application. In FIG. 60, the collimation lens 470 may alternatively be located between the polarization filter 420 and the beam shaper 430. The collimation lens 470 is configured to collimate the beam in the single polarization state. The beam shaper 430 is configured to adjust a FOV of a collimated beam of the collimation lens 470, to obtain a first beam.

In the foregoing, the collimation lens collimates the beam, so that an approximately parallel beam can be obtained, thereby improving a power density of the beam, and further improving an effect of scanning by the beam subsequently.

Optionally, a clear aperture of the collimation lens is less than or equal to 5 mm.

Because a size of the collimation lens is small, the TOF depth sensing module including the collimation lens is easily integrated into a terminal device, and a space occupied in the terminal device can be reduced to some extent.

It should be understood that the collimation lens may alternatively be located between the beam shaper 430 and the optical element 440. In this case, the collimation lens collimates a shaped beam of the beam shaper 430, and a collimated beam is then processed by the optical element 440.

In addition, the collimation lens 470 may be located at any possible position in the TOF depth sensing module 400 and collimate a beam in any possible process.

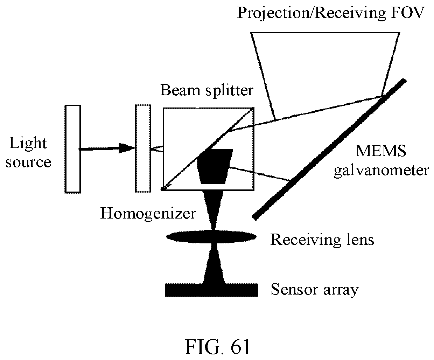

As shown in FIG. 61, the TOF depth sensing module includes a light source, a homogenizer, a beam splitter, a microelectromechanical system (microelectromechanical system, MEMS) galvanometer, a receiving lens, and a sensor. The MEMS in the figure includes an electrostatic galvanometer, an electromagnetic galvanometer, a multifaceted rotating mirror, and the like. Because rotating mirror components all work in a reflective manner, an optical path in the TOF depth sensing module is a reflective optical path, an emission path and a reception path are coaxial optical paths, and a polarizer and a lens may be shared through the beam splitter. In FIG. 61, the polarizer is specifically the MEMS galvanometer.

Optionally, the optical element 440 is a liquid crystal polarization element.

Optionally, the optical element 440 includes a horizontal polarization control sheet, a horizontal liquid crystal polarization grating, a vertical polarization control sheet, and a vertical liquid crystal polarization grating.

Optionally, in the optical element 440, distances between the light source and the horizontal polarization control sheet, the horizontal liquid crystal polarization grating, the vertical polarization control sheet, and the vertical liquid crystal polarization grating are in ascending order of magnitude. Alternatively, distances between the light source and the vertical polarization control sheet, the vertical liquid crystal polarization grating, the horizontal polarization control sheet, and the horizontal liquid crystal polarization grating are in ascending order of magnitude.

Optionally, the beam shaper 430 includes a diffusion lens and a rectangular aperture stop.

The optical element may be any one of components such as a liquid crystal polarization grating, an electro-optic component, an acousto-optic component, and an optical phased array component. For specific content of the components such as the liquid crystal polarization grating, the electro-optic component, the acousto-optic component, and the optical phased array component, refer to the descriptions in the first case to the fourth case above.

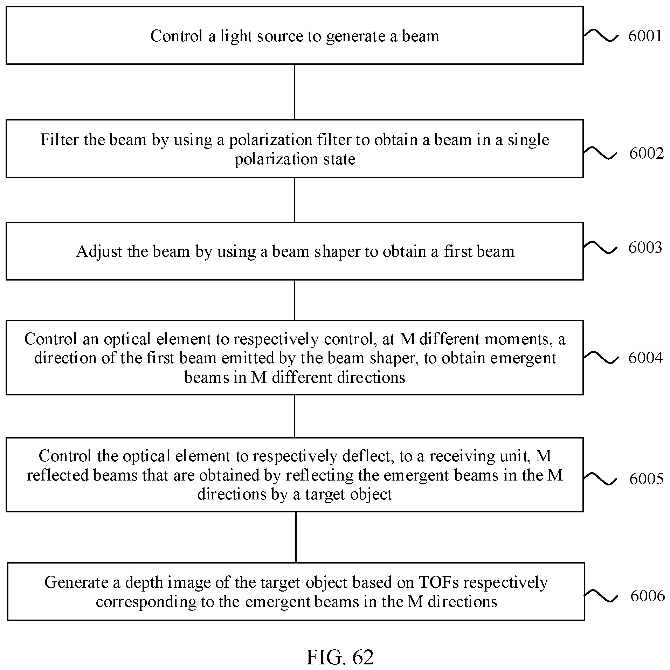

FIG. 62 is a schematic flowchart of an image generation method according to an embodiment of this application.

The method shown in FIG. 62 may be performed by a TOF depth sensing module or a terminal device including a TOF depth sensing module in an embodiment of this application. Specifically, the method shown in FIG. 62 may be performed by the TOF depth sensing module shown in FIG. 58 or a terminal device including the TOF depth sensing module shown in FIG. 58. The method shown in FIG. 62 includes steps 6001 to 6006, which are described in detail below.

6001. Control the light source to generate a beam.

6002. Filter the beam by using the polarization filter to obtain a beam in a single polarization state.

The single polarization state is one of the plurality of polarization states.

For example, the plurality of polarization states may include linear polarization, left-handed circular polarization, and right-handed circular polarization, and the single polarization state may be any one of the linear polarization, the left-handed circular polarization, and the right-handed circular polarization.

6003. Adjust the beam in the single polarization state by using the beam shaper to obtain a first beam.

It should be understood that, in this embodiment of this application, the adjusting the beam by using the beam shaper is specifically increasing a field angle FOV of the beam by using the beam shaper.

Optionally, a FOV of the first beam meets a first preset range.

Optionally, the first preset range may include [5°×5°, 20°×20°].

6004. Control the optical element to respectively control a direction of the first beam from the beam shaper at M different moments, to obtain emergent beams in M different directions.

A total FOV covered by the emergent beams in the M different directions meets a second preset range.

Optionally, the second preset range may include [50°×50°, 80°×80°].

6005. Control the optical element to respectively deflect, to the receiving unit, M reflected beams that are obtained by reflecting the emergent beams in the M different directions by a target object.

6006. Generate a depth image of the target object based on TOFs respectively corresponding to the emergent beams in the M different directions.

In this embodiment of this application, the beam shaper adjusts the FOV of the beam so that the first beam has a large FOV, and scanning is performed in a time division multiplexing manner (the optical element emits emergent beams in different directions at different moments), thereby improving a spatial resolution of the finally obtained depth image of the target object.

Optionally, step 6006 specifically includes: determining distances between the TOF depth sensing module and M regions of the target object based on the TOFs respectively corresponding to the emergent beams in the M different directions; generating depth images of the M regions of the target object based on the distances between the TOF depth sensing module and the M regions of the target object; and synthesizing the depth image of the target object based on the depth images of the M regions of the target object.

Optionally, step 6003 specifically includes: adjusting angular intensity distribution of the beam in the single polarization state by using the beam shaper to obtain the first beam.

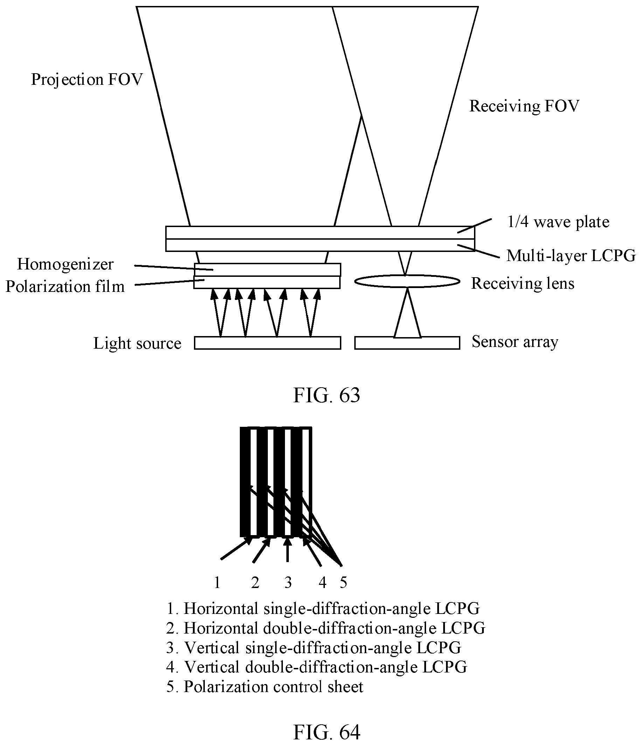

The following describes in detail a specific working process of the TOF depth sensing module 400 in this embodiment of this application with reference to FIG. 63.

FIG. 63 is a schematic diagram of a structure of a TOF depth sensing module according to an embodiment of this application.

Specific implementations and functions of components of the TOF depth sensing module shown in FIG. 63 are as follows:

> (1) A light source is a VCSEL array.
> The VCSEL light source can emit a beam array with good directivity.
> (2) A polarization film is a polarization filter, and the polarization film may be located in front (below) or rear (above) of a homogenizer.
> (3) The homogenizer may be a diffractive optical element (diffractive optical element, DOE) or an optical diffuser (which may be referred to as a diffuser).

The beam array forms a substantially homogeneous beam block after processed by the homogenizer.

(3) An optical element is a plurality of layers of LCPGs (liquid crystal polarization gratings).

It should be understood that, FIG. 63 merely shows that the polarization film is located below the homogenizer. Actually, the polarization film may alternatively be located above the homogenizer.

For a specific principle of controlling a direction of a beam by the liquid crystal polarization grating, refer to related content described in FIG. 37 and FIG. 38.

In FIG. 63, through cooperation of the plurality of layers of liquid crystal polarization gratings and a 1/4 wave plate, emitted light just passes through a 1/2 extra optical path after reflected by a target and returning to the polarization film. This design enables the polarization film to deflect a direction of return light just oppositely to that of the emitted light. Under quasi-coaxial approximation, obliquely emitted light returns along an original path after reflected, and is deflected to a direction parallel to that of the emitted light, to reach a receiving lens. A receive end can image, on an entire receiver (SPAD array) by using the beam deflector, a target block selectively illuminated by the emitted light. When a target is illuminated in blocks, each block is received by the entire receiver, and a complete image may be obtained by splicing images at different moments. In this way, time division multiplexing of the receiver is implemented, thereby achieving multiplication of a resolution.

(4) The receiving lens is implemented by a common lens, which images received light on the receiver.

(5) The receiver is a SPAD array.

The SPAD can detect a single photon, and a time at which a single photon pulse is detected by the SPAD can be recorded accurately. Each time the VCSEL emits light, the SPAD is started. The VCSEL periodically emits a beam, and the SPAD array can collect statistics on a moment at which each pixel receives reflected light in each period. A reflected signal pulse may be obtained through fitting by collecting statistics on time distribution of reflected signals, to calculate a delay time.

A key component in this embodiment is the beam deflector shared by the projection end and the receive end, that is, a liquid crystal polarizer. In this embodiment, the beam deflector includes a plurality of layers of LCPGs, which is also referred to as an electrically controlled liquid crystal polarizer.

FIG. 64 is a schematic diagram of a structure of a liquid crystal polarizer according to an embodiment of this application.

An optional specific structure of the liquid crystal polarizer is shown in FIG. 64. In FIG. 64, 1 represents a horizontal single-diffraction-angle LCPG, 2 represents a horizontal double-diffraction-angle LCPG, 3 represents a vertical single-diffraction-angle LCPG, 4 represents a vertical double-diffraction-angle LCPG, and 5 represents a polarization control sheet. There are five polarization control sheets, which are respectively located on left sides of the four LCPGs shown in FIG. 64, and are respectively numbered 5.1, 5.2, 5.3, and 5.4.

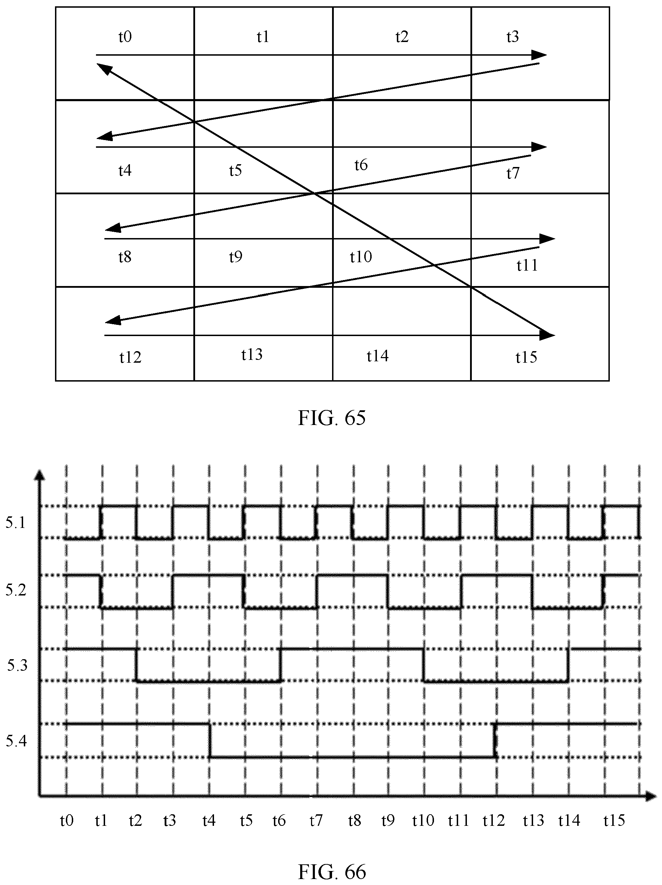

The liquid crystal polarizer shown in FIG. 64 may be controlled by using the control unit, and a control timing may be shown in FIG. 65 (scanning starts at a moment t0 and continues until a moment t15). A timing diagram of a drive signal generated by the control unit is shown in FIG. 66.

FIG. 66 shows voltage drive signals of the polarization control sheets 5.1, 5.2, 5.3, and 5.4 of the liquid crystal polarizer at the moment t0 to the moment t15. The voltage drive signals include two types of signals: a low level and a high level, the low level is represented by 0, and the high level is represented by 1. In this case, the voltage drive signals of the polarization control sheets 5.1, 5.2, 5.3, and 5.4 at the moment t0 to the moment t15 are specifically shown in Table 1.

Table 1

| Timing | Voltage |
|---|---|
| t0 | 0111 |
| t1 | 1011 |
| t2 | 0001 |
| t3 | 1101 |
| t4 | 0100 |
| t5 | 1000 |
| t6 | 0010 |
| t7 | 1110 |
| t8 | 0110 |
| t9 | 1010 |
| t10 | 0000 |
| t11 | 1100 |
| t12 | 0101 |
| t13 | 1001 |
| t14 | 0011 |
| t15 | 1111 |

For example, in Table 1, a voltage drive signal of the polarization control sheet 5.1 is a low-level signal and voltage drive signals of the polarization control sheets 5.2 to 5.4 are high-level signals in a time interval t0. Therefore, a voltage signal corresponding to the moment t0 is 0111.

As shown in FIG. 64, the electrically controlled liquid crystal polarizer includes LCPGs and polarization control sheets. Voltage drive signals for a 4*4 scan are shown in FIG. 66. 5.1, 5.2, 5.3, and 5.4 respectively represent voltage drive signals applied to the four polarization control sheets, an entire FOV is divided into 4*4 blocks, and t0 to t15 are time intervals for illuminating the blocks, respectively. When the voltage drive signals shown in FIG. 66 are applied, states of beams passing through the components of the liquid crystal polarizer are shown in Table 2.

Table 2

| Through 5.1 | Through 1 | Through 5.2 | Through 2 | Through 5.3 | Through 3 | Through 5.4 | Through 4 | Voltage | Timing | Position |
|---|---|---|---|---|---|---|---|---|---|---|
| L00 (0) | R-10 (0) | R-10 (00) | L10 (00) | L10 (000) | R1-1 (000) | R1-1 | L11 | 0000 | t10 | 11 |
| | | | | | | L1-1 | R1-3 | 0001 | t2 | 1-3 |
| | | | | R10 (001) | L11 (001) | L11 | R1-1 | 0010 | t6 | 1-1 |
| | | | | | | R11 | L13 | 0011 | t14 | 13 |
| | | L-10 (01) | R-30 (01) | R-30 (010) | L-31 (010) | L-31 | R-3-1 | 0100 | t4 | -3-1 |
| | | | | | | R-31 | L-33 | 0101 | t12 | -33 |
| | | | | L-30 (011) | R-3-1 (011) | R-3-1 | L-31 | 0110 | t8 | -31 |
| | | | | | | L-3-1 | R-33 | 0111 | t0 | -3-3 |

(continued)

| Through 5.1 | Through 1 | Through 5.2 | Through 2 | Through 5.3 | Through 3 | Through 5.4 | Through 4 | Voltage | Timing | Position |
|---|---|---|---|---|---|---|---|---|---|---|
| R00 (1) | L-10 (1) | L-10 (10) | R-10 (10) | R-10 (100) | L-11 (100) | L-1-1 | R-1-1 | 1000 | t5 | -1-1 |
| | | | | | | R-1-1 | L-13 | 1001 | t13 | -13 |
| | | | | L-10 (101) | R-1-1 (101) | R-1-1 | L-11 | 1010 | t9 | -11 |
| | | | | | | L-1-1 | R-1-1 | 1011 | t1 | -1-3 |
| | | R-10 (11) | L30 (11) | L30 (11) | R3-1 (11) | R3-1 | L31 | 1100 | t11 | 31 |
| | | | | | | L3-1 | R3-3 | 1101 | t3 | 3-3 |
| | | | | R30 | L31 | L31 | R3-1 | 1110 | t7 | 3-1 |
| | | | | (111) | (111) | R31 | L33 | 1111 | t15 | 33 |

The following describes meanings represented in Table 2. In each item in Table 2, a value in parentheses is a voltage signal, L represents left-handed, R represents right-handed, values such as 1 and 3 represent angles of beam deflection, and a deflection angle represented by 3 is greater than a deflection angle represented by 1.

For example, for R1-1, R represents right-handed, the first value 1 represents left (it represents right if the first value is -1), and the second value -1 represents upper (it represents lower if the second value is 1).

For another example, for L3-3, L represents left-handed, the first value 3 represents rightmost (it represents leftmost if the first value is -3), and the second value -3 represents topmost (it represents bottommost if the second value is 3).

When the voltage drive signals shown in FIG. 66 are applied to the liquid crystal polarizer, scanned regions of the TOF depth sensing module at different moments are shown in FIG. 67.

The following describes, with reference to accompanying drawings, the depth image obtained in this embodiment of this application. As shown in FIG. 68, it is assumed that depth images corresponding to the target object at a moment t0 to a moment t3 can be obtained through time division scanning. A resolution of the depth images corresponding to the moment t0 to the moment t3 is 160×120. The depth images corresponding to the moment t0 to the moment t3 may be spliced, to obtain a final depth image of the target object shown in FIG. 69. A resolution of the final depth image of the target object is 320×240. It can be learned from FIG. 68 and FIG. 69 that, a resolution of a finally obtained depth image can be improved by splicing depth images obtained at different moments.

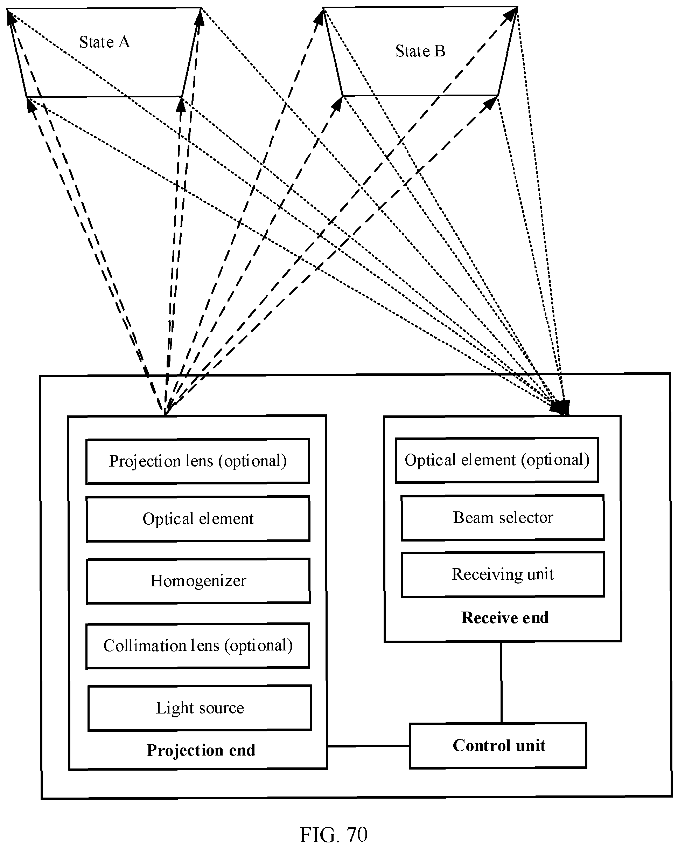

The foregoing describes in detail one TOF depth sensing module and image generation method in embodiments of this application with reference to FIG. 53 to FIG. 69. The following describes in detail another TOF depth sensing module and image generation method with reference to FIG. 70 to FIG. 78.

In a TOF depth sensing module, a liquid crystal component may be used to adjust a direction of a beam, and a polarization film is generally added at a transmit end in the TOF depth sensing module to emit polarized light. However, in a process of emitting the polarized light, due to a polarization selection function of the polarization film, half of energy is lost during beam emission, and the lost energy is absorbed or scattered and converted into heat by the polarization film, which increases a temperature of the TOF depth sensing module, and affects stability of the TOF depth sensing module. Therefore, how to reduce the heat loss of the TOF depth sensing module is a problem that needs to be resolved.

Specifically, in the TOF depth sensing module , the heat loss of the TOF depth sensing module may be reduced by transferring the polarization film from the transmit end to a receive end. The following describes in detail the TOF depth sensing module with reference to accompanying drawings.

The following first briefly describes the TOF depth sensing module with reference to FIG. 70.

FIG. 70 is a schematic diagram of working with a TOF depth sensing module. As shown in FIG. 70, the TOF depth sensing module may include a transmit end (which may also be referred to as a projection end), a receive end, and a control unit. The transmit end is configured to emit an emergent beam. The receive end is configured to receive a reflected beam of a target object (the reflected beam is a beam obtained by reflecting the emergent beam by the target object). The control unit may control the transmit end and the receive end to transmit and receive the beam, respectively.

In FIG. 70, the transmit end may generally include a light source, a collimation lens (optional), a homogenizer, an optical element, and a projection lens (optional), the receive end generally includes a beam selector and a receiving unit, and the receiving unit may specifically include a receiving lens and a sensor.

The TOF depth sensing module shown in FIG. 70 projects projected light in two or more different states (a state A and a state B) at a same moment. After the projected light in the two different states is reflected and reaches the receive end, the beam selector chooses, in a time division manner according to an instruction, to allow reflected light in a state to enter the sensor, to perform depth imaging for light in a specific state. Then, the beam deflector may perform scanning in a different direction to cover a target FOV.

The TOF depth sensing module shown in FIG. 70 may be configured to obtain a 3D image. The TOF depth sensing module may be disposed on an intelligent terminal (for example, a mobile phone, a tablet, or a wearable device), to obtain a depth image or a 3D image, which may also provide gesture and limb recognition for a 3D game or a somatic game.

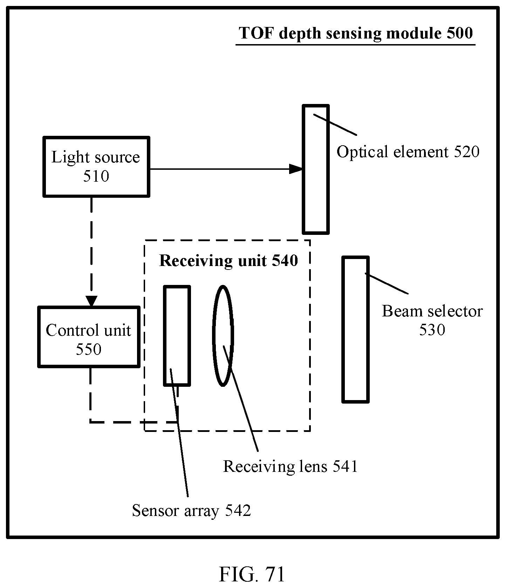

The following describes in detail the TOF depth sensing module with reference to FIG. 71.

The TOF depth sensing module 500 shown in FIG. 71 includes a light source 510, an optical element 520, a beam selector 530, a receiving unit 540, and a control unit 550.

The following describes in detail the several modules or units in the TOF depth sensing module 500.

Light source 510:

The light source 510 is configured to generate a beam.

Optionally, the light source may be a semiconductor laser light source.

The light source may be a vertical cavity surface emitting laser (vertical cavity surface emitting laser, VCSEL).

Optionally, the light source may be a Fabry-Perot laser (which may be referred to as an FP laser for short).

A single FP laser can implement a larger power than a single VCSEL, and has higher electro-optical conversion efficiency than the VCSEL, thereby improving a scanning effect.

Optionally, a wavelength of the beam emitted by the light source 510 is greater than 900 nm.

Because intensity of light whose wavelength is greater than 900 nm in sunlight is weak, when the wavelength of the beam is greater than 900 nm, interference caused by the sunlight can be reduced, thereby improving a scanning effect of the TOF depth sensing module.

Optionally, a wavelength of the beam emitted by the light source 510 is 940 nm or 1550 nm.

Because intensity of light whose wavelength is near 940 nm or 1550 nm in sunlight is weak, when the wavelength of the beam is 940 nm or 1550 nm, interference caused by the sunlight can be greatly reduced, thereby improving a scanning effect of the TOF depth sensing module.

Optionally, a light emitting area of the light source 510 is less than or equal to $5 \times 5$ mm$^2$.

Because a size of the light source is small, the TOF depth sensing module including the light source is easily integrated into a terminal device, and a space occupied in the terminal device can be reduced to some extent.

Optionally, an average output optical power of the TOF depth sensing module is less than 800 mw.

When the average output optical power of the TOF depth sensing module is less than or equal to 800 mw, the TOF depth sensing module has small power consumption, and can be disposed in a device sensitive to power consumption, such as a terminal device.

Optical element 520:

The optical element 520 is disposed in an emergent direction of the beam, and the optical element 520 is configured to control a direction of the beam to obtain a first emergent beam and a second emergent beam. An emergent direction of the first emergent beam and an emergent direction of the second emergent beam are different, and a polarization direction of the first emergent beam and a polarization direction of the second emergent beam are orthogonal.

Optionally, as shown in FIG. 35, the optical element 520 may include a horizontal polarization control sheet, a horizontal liquid crystal polarization grating, a vertical polarization control sheet, and a vertical liquid crystal polarization grating. Distances between the light source and the horizontal polarization control sheet, the horizontal liquid crystal polarization grating, the vertical polarization control sheet, and the vertical liquid crystal polarization grating are in ascending order of magnitude.

Alternatively, in the optical element 520, distances between the light source and the vertical polarization control sheet, the vertical liquid crystal polarization grating, the horizontal polarization control sheet, and the horizontal liquid crystal polarization grating are in ascending order of magnitude.

Receiving unit 540:

The receiving unit 540 may include a receiving lens 541 and a sensor 542.

Control unit 550 and beam selector 530:

The control unit 550 is configured to control working of the beam selector 530 by using a control signal. Specifically, the control unit 550 may generate a control signal. The control signal is used to control the beam selector 530 to respectively propagate a third reflected beam and a fourth reflected beam to the sensor in different time intervals. The third reflected beam is a beam obtained by reflecting the first emergent beam by a target object. The fourth reflected beam is a beam obtained by reflecting the second emergent beam by the target object.

The beam selector 530 can respectively propagate beams in different polarization states to the receiving unit at different moments under the control of the control unit 550. The beam selector 530 herein propagates the received reflected beams to the receiving unit 540 in a time division mode, which can more fully utilize a receiving resolution of the receiving unit 540 and achieve a higher resolution of a finally obtained depth image than a beam splitter 630 in a TOF depth sensing module 600 below.

Optionally, the control signal generated by the control unit 550 is used to control the beam selector 530 to respectively propagate the third reflected beam and the fourth reflected beam to the sensor in different time intervals.

In other words, the beam selector may respectively propagate the third reflected beam and the fourth reflected beam to the receiving unit at different times under the control of the control signal generated by the control unit 550.

Optionally, the beam selector 530 includes a 1/4 wave plate + a half wave plate + a polarization film.

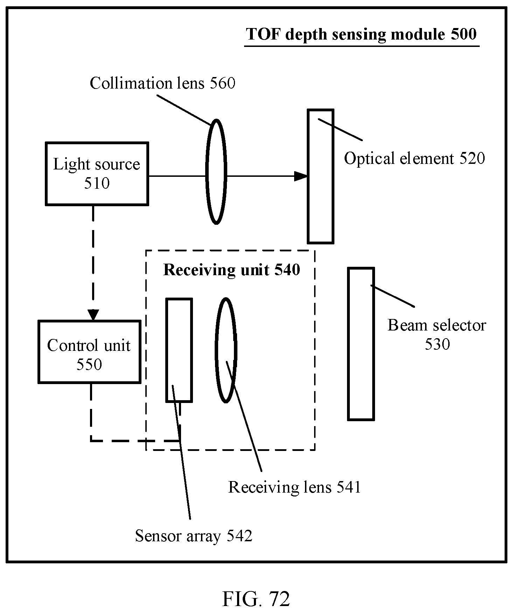

As shown in FIG. 72, the TOF depth sensing module 500 may further include:

a collimation lens 560. The collimation lens 560 is disposed in the emergent direction of the beam, and the collimation lens is disposed between the light source and the optical element. The collimation lens 560 is configured to collimate the beam to obtain a collimated beam. The optical element 520 is configured to control a direction of the collimated beam to obtain a first emergent beam and a second emergent beam.

In the foregoing, the collimation lens collimates the beam, so that an approximately parallel beam can be obtained, thereby improving a power density of the beam, and further improving an effect of scanning by the beam subsequently.

Optionally, a clear aperture of the collimation lens is less than or equal to 5 mm.

Because a size of the collimation lens is small, the TOF depth sensing module including the collimation lens is easily integrated into a terminal device, and a space occupied in the terminal device can be reduced to some extent.

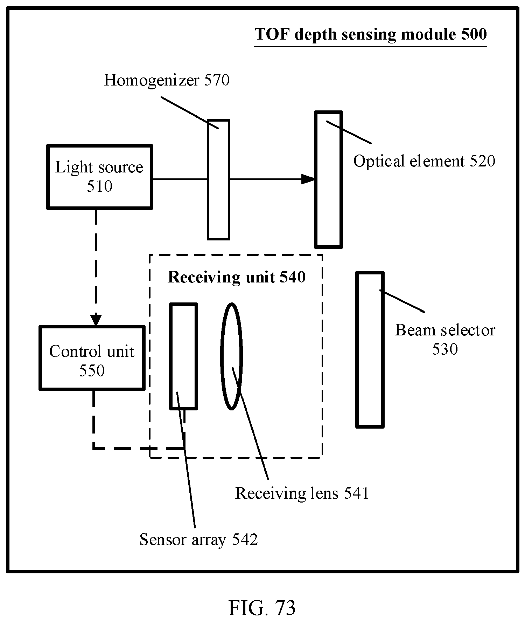

As shown in FIG. 73, the TOF depth sensing module 500 may further include:

a homogenizer 570. The homogenizer 570 is disposed in the emergent direction of the beam, and the homogenizer is disposed between the light source 510 and the optical element 520. The homogenizer 570 is configured to adjust energy distribution of the beam to obtain a homogenized beam. The optical element is configured to control a direction of the homogenized beam to obtain a first emergent beam and a second emergent beam.

Optionally, the homogenizer is a microlens diffuser or a diffractive optical element diffuser (DOE Diffuser).

It should be understood that the TOF depth sensing module 500 may include both the collimation lens 560 and the homogenizer 570, and the collimation lens 560 and the homogenizer 570 are both located between the light source 510 and the optical element 520. For the collimation lens 560 and the homogenizer 570, the collimation lens 560 may be closer to the light source, or the homogenizer 570 may be closer to the light source.

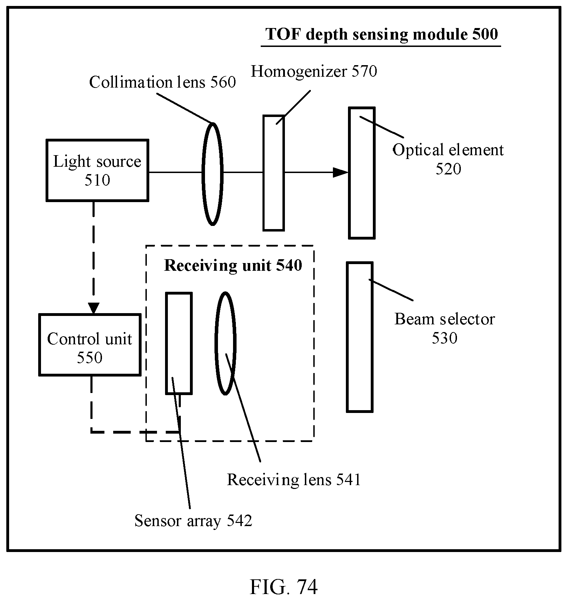

As shown in FIG. 74, a distance between the collimation lens 560 and the light source 510 is less than a distance between the homogenizer 570 and the light source 510.

In the TOF depth sensing module 500 shown in FIG. 74, the beam emitted by the light source 510 is first collimated by the collimation lens 560, then homogenized by the homogenizer 570, and subsequently propagated to the optical element 520 for processing.

Through homogenization, an optical power of the beam can be more uniform in an angular space, or distributed based on a specific rule, to prevent an excessively low local optical power, thereby avoiding a blind spot in a finally obtained depth image of the target object.

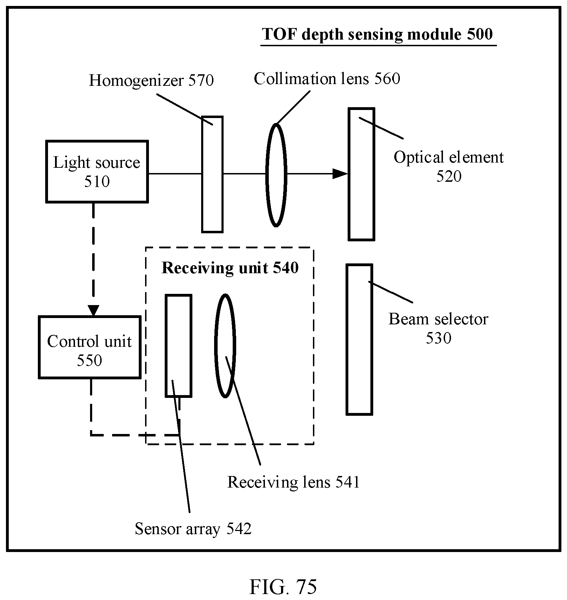

As shown in FIG. 75, the distance between the collimation lens 560 and the light source 510 is greater than the distance between the homogenizer 570 and the light source 510.

In the TOF depth sensing module 500 shown in FIG. 75, the beam emitted by the light source 510 is first homogenized by the homogenizer 570, then collimated by the collimation lens 560, and subsequently propagated to the optical element 520 for processing.

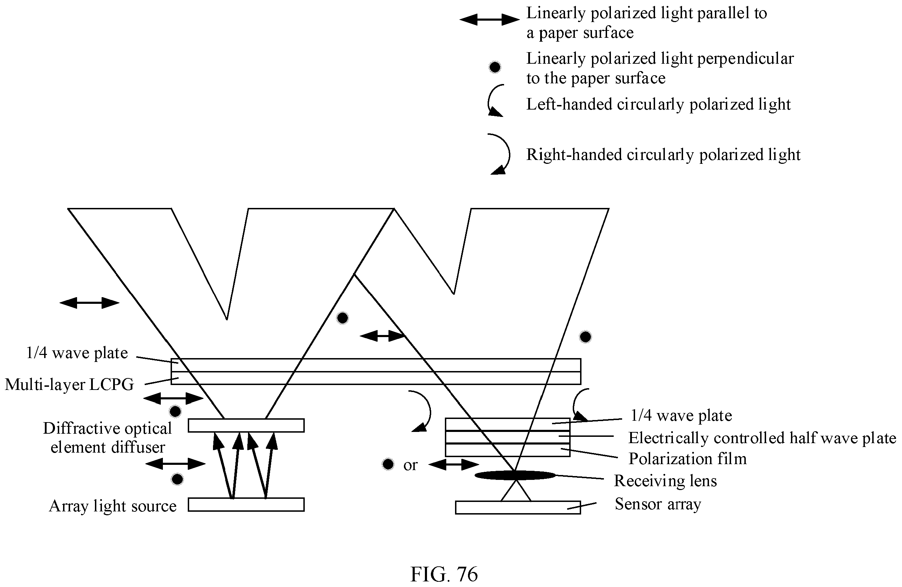

The following describes in detail a specific structure of the TOF depth sensing module 500 with reference to FIG. 76.

FIG. 76 is a schematic diagram of the specific structure of the TOF depth sensing module 500.

As shown in FIG. 76, the TOF depth sensing module 500 includes a projection end, a control unit, and a receive end. The projection end includes a light source, a homogenizer, and a beam deflector. The receive end includes the beam deflector, a beam (dynamic) selector, a receiving lens, and a two-dimensional sensor. The control unit is configured to control the projection end and the receive end to complete beam scanning. In addition, the beam deflector in FIG. 76 corresponds to the optical element in FIG. 71, and the beam (dynamic) selector in FIG. 76 corresponds to the beam selector in FIG. 71.

The following describes in detail components specifically used in the modules or units.

The light source may be a vertical cavity surface emitting laser (VCSEL) array light source.

The homogenizer may be a diffractive optical element diffuser.

The beam deflector may be a plurality of layers of LCPGs and a 1/4 wave plate.

An electrically controlled LCPG includes an LCPG component electrically controlled in a horizontal direction and an LCPG component electrically controlled in a vertical direction.

Two-dimensional block scanning in the horizontal direction and the vertical direction can be implemented by using a plurality of layers of electrically controlled LCPGs that are cascaded. The 1/4 wave plate is configured to convert circularly polarized light from the LCPGs into linearly polarized light, to achieve a quasi-coaxial effect between the transmit end and the receive end.

A wavelength of the VCSEL array light source may be greater than 900 nm. Specifically, the wavelength of the VCSEL array light source may be 940 nm or 1550 nm.

Solar spectral intensity in a 940 nm band is weak. This helps reduce noise caused by sunlight in an outdoor scene. In addition, laser light emitted by the VCSEL array light source may be continuous-wave light or pulsed light. The VCSEL array light source may be divided into several blocks to implement time division control of turning on different regions at different times.

A function of the diffractive optical element diffuser is to shape the beam emitted by the VCSEL array light source into a uniform square or rectangular light source with a specific FOV (for example, a 5°x5° FOV).

A function of the plurality of layers of LCPGs and the 1/4 wave plate is to implement beam scanning.

The receive end and the transmit end share the plurality of layers of LCPGs and the 1/4 wave plate. The beam selector at the receive end includes a 1/4 wave plate + an electrically controlled half wave plate + a polarization film. The receiving lens at the receive end may be a single lens or a combination of a plurality of lenses. The sensor at the receive end is a single-photon avalanche diode (SPAD) array, which can increase a detection distance of the TOF depth sensing module because of sensitivity of the SPAD to detect a single photon.

For the TOF depth sensing module 500, a polarization selector at the transmit end is moved to the receive end. As shown in FIG. 76, laser light emitted by an ordinary VCSEL array light source has no fixed polarization state, which may be decomposed into linearly polarized laser light parallel to a paper surface and linearly polarized laser light perpendicular to the paper surface. After passing through the LCPGs, the linearly polarized laser light is split into two laser beams in different polarization states (left-handed circular polarization and right-handed circular polarization), which respectively have different emergent angles. After the two laser beams pass through the 1/4 wave plate, corresponding polarization states are converted into linearly polarized light parallel to the paper surface and linearly polarized light perpendicular to the paper surface. Reflected beams generated after the two laser beams in the different polarization states irradiate an object in a target region are received by the LCPGs and the 1/4 wave plate that are shared at the transmit end and the receive end, and then become laser light having a same divergence angle but in different polarization states: left-handed circularly polarized light and right-handed circularly polarized light. The beam selector at the receive end includes the 1/4 wave plate + the electrically controlled half wave plate + the polarization film. After the received light passes through the 1/4 wave plate, the polarization states are converted into linearly polarized light parallel to the paper surface and linearly polarized light perpendicular to the paper surface. In this way, through time division control, the electrically controlled half wave plate rotates a polarization state of linearly polarized light by 90 degrees or does not change a polarization state passing through the half wave plate, so that the linearly polarized light parallel to the paper surface and the linearly polarized light perpendicular to the paper surface are transmitted at different times, and light in the other polarization state is absorbed or scattered by the polarization film.

Compared with an existing TOF depth sensing module with a polarization selector located at a transmit end, because the polarization selector in this application is located at the receive end, energy absorbed or scattered by the polarization film is significantly reduced. It is assumed that a detection distance is R meters, the target object has a reflective index of $\rho$, and an entrance pupil diameter of a receiving system is D. In a case of a same receiving FOV, incident energy $P_t$ of the polarization selector of the TOF depth sensing module 500 is:

$$P_t = \frac{\pi D^2 \rho}{2\pi R^2} P$$

P is energy emitted by the transmit end, and at a distance of 1 m, the energy can be reduced by about $10^4$ times.

In addition, it is assumed that the TOF depth sensing module 500 and a conventional TOF depth sensing module patent use non-polarized light sources at a same power. Since outdoor light in the TOF depth sensing module 500 is non-polarized, half of light entering a receiving detector is absorbed or scattered, while all outdoor light in the TOF depth sensing module in the conventional solution enters a detector. Therefore, a signal-to-noise ratio is increased by about one time in a same case.

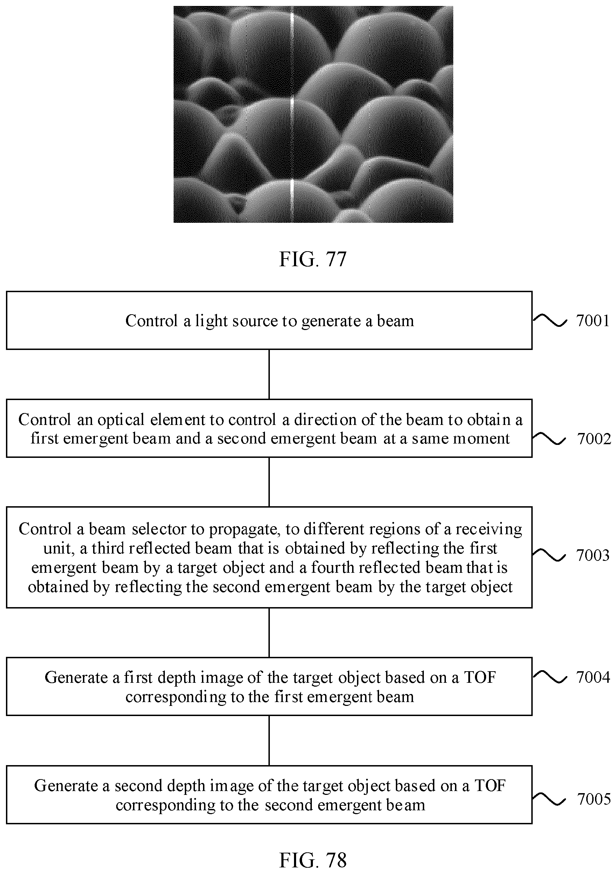

Based on the TOF depth sensing module 500 shown in FIG. 76, the diffractive optical element diffuser (DOE Diffuser) in rear of the VCSEL array light source may be changed to a microlens diffuser (Diffuser). The microlens diffuser implements homogenization based on geometrical optics, and therefore has high transmission efficiency that can reach more than 80%, while transmission efficiency of a conventional diffractive optical element diffuser (DOE Diffuser) is only about 70%. A form of the microlens diffuser is shown in FIG. 77. The microlens diffuser includes a series of randomly distributed microlenses. A position and a form of each microlens are designed and optimized through simulation, so that a shaped beam is as uniform as possible and transmission efficiency is high.

FIG. 78 is a schematic flowchart of an image generation method.

The method shown in FIG. 78 may be performed by a TOF depth sensing module or a terminal device including a TOF depth sensing module in an embodiment of this application. Specifically, the method shown in FIG. 78 may be performed by the TOF depth sensing module shown in FIG. 71 or a terminal device including the TOF depth sensing module shown in FIG. 71. The method shown in FIG. 78 includes steps 7001 to 7006, which are described in detail below.

7001. Control the light source to generate a beam.

7002. Control the optical element to control a direction of the beam to obtain a first emergent beam and a second emergent beam.

7003. Control the beam selector to propagate, to different regions of the receiving unit, a third reflected beam that is obtained by reflecting the first emergent beam by a target object and a fourth reflected beam that is obtained by reflecting the second emergent beam by the target object.

7004. Generate a first depth image of the target object based on a TOF corresponding to the first emergent beam.

7005. Generate a second depth image of the target object based on a TOF corresponding to the second emergent beam.

An emergent direction of the first emergent beam and an emergent direction of the second emergent beam are different, and a polarization direction of the first emergent beam and a polarization direction of the second emergent beam are orthogonal.

Because the transmit end does not have a polarization filter, the beam emitted by the light source may reach the optical element almost without a loss (the polarization filter generally absorbs much light energy, leading to a heat loss), so that a heat loss of the terminal device can be reduced.

Optionally, the method shown in FIG. 78 further includes: splicing the first depth image and the second depth image to obtain a depth image of the target object.

It should be understood that, in the method shown in FIG. 78, a third depth image, a fourth depth image, and the like may be further generated in a similar manner. Next, all depth images may be spliced or combined, to obtain a final depth image of the target object.

Optionally, the terminal device further includes a collimation lens. The collimation lens is disposed between the light source and the optical element. The method shown in FIG. 78 further includes:

7006. Collimate the beam by using the collimation lens to obtain a collimated beam.

Step 7002 specifically includes: controlling the optical element to control a direction of the collimated beam, to obtain a first emergent beam and a second emergent beam.

In addition, in the foregoing, the collimation lens collimates the beam, so that an approximately parallel beam can be obtained, thereby improving a power density of the beam, and further improving an effect of scanning by the beam subsequently.

Optionally, the terminal device further includes a homogenizer. The homogenizer is disposed between the light source and the optical element. The method shown in FIG. 78 further includes:

7007. Adjust energy distribution of the beam by using the homogenizer to obtain a homogenized beam.

Step 7002 specifically includes: controlling the optical element to control a direction of the homogenized beam, to obtain a first emergent beam and a second emergent beam.

Through homogenization, an optical power of the beam can be more uniform in an angular space, or distributed based on a specific rule, to prevent an excessively low local optical power, thereby avoiding a blind spot in a finally obtained depth image of the target object.

Based on steps 7001 to 7005, the method shown in FIG. 78 may further include step 7006 or step 7007.

Alternatively, based on steps 7001 to 7005, the method shown in FIG. 78 may further include step 7006 and step 7007. In this case, after step 7001 is performed, step 7006 may be performed first, then step 7007 is performed, and then step 7002 is performed. Alternatively, step 7007 may be performed first, then step 7006 is performed, and then step 7002 is performed. In other words, after the light source generates the beam in step 7001, the beam may be first collimated and then homogenized (the energy distribution of the beam is adjusted by using the homogenizer), and then the optical element controls the direction of the beam. Alternatively, after the light source generates the beam in step 7001, the beam may be first homogenized (the energy distribution of the beam is adjusted by using the homogenizer) and then collimated, and then the optical element controls the direction of the beam.

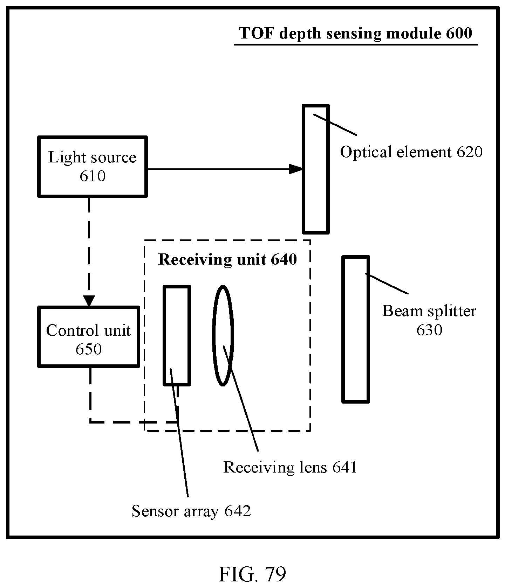

The foregoing describes in detail one TOF depth sensing module and image generation method with reference to FIG. 70 to FIG. 78. The following describes in detail another TOF depth sensing module and image generation method with reference to FIG. 79 to FIG. 88.

Liquid crystal components have excellent polarization and phase adjustment capabilities, and therefore are widely used in TOF depth sensing modules to deflect beams. However, due to a birefringence characteristic of a liquid crystal material, a polarization film is generally added at a transmit end in an existing TOF depth sensing module using a liquid crystal component, to emit polarized light.

In a process of emitting the polarized light, due to a polarization selection function of the polarization film, half of energy is lost during beam emission, and the lost energy is absorbed or scattered and converted into heat by the polarization film, which increases a temperature of the TOF depth sensing module, and affects stability of the TOF depth sensing module. Therefore, how to reduce the heat loss of the TOF depth sensing module and improve a signal-to-noise ratio of the TOF depth sensing module is a problem that needs to be resolved.

This application provides a new TOF depth sensing module, to reduce a heat loss of a system by transferring a polarization film from a transmit end to a receive end, and improve a signal-to-noise ratio of the system relative to background stray light.

The following first briefly describes the TOF depth sensing module with reference to FIG. 79.

The TOF depth sensing module 600 shown in FIG. 79 includes a light source 610, an optical element 620, a beam splitter 630, a receiving unit 640, and a control unit 650.

The following describes in detail the several modules or units in the TOF depth sensing module 600.

Light source 610:

The light source 610 is configured to generate a beam.

Optionally, the light source 610 is a vertical cavity surface emitting laser (vertical cavity surface emitting laser, VCSEL).

Optionally, the light source 610 is a Fabry-Perot laser (which may be referred to as an FP laser for short).

A single FP laser can implement a larger power than a single VCSEL, and has higher electro-optical conversion efficiency than the VCSEL, thereby improving a scanning effect of the TOF depth sensing module.

Optionally, a wavelength of the beam emitted by the light source 610 is greater than 900 nm.

Because intensity of light whose wavelength is greater than 900 nm in sunlight is weak, when the wavelength of the beam is greater than 900 nm, interference caused by the sunlight can be reduced, thereby improving a scanning effect of the TOF depth sensing module.

Optionally, a wavelength of the beam emitted by the light source 610 is 940 nm or 1550 nm.

Because intensity of light whose wavelength is near 940 nm or 1550 nm in sunlight is weak, when the wavelength of the beam is 940 nm or 1550 nm, interference caused by the sunlight can be greatly reduced, thereby improving a scanning effect of the TOF depth sensing module.

Optionally, a light emitting area of the light source 610 is less than or equal to $5 \times 5$ mm$^2$.

Because a size of the light source is small, the TOF depth sensing module including the light source is easily integrated into a terminal device, and a space occupied in the terminal device can be reduced to some extent.

Optical element 620:

The optical element 620 is disposed in an emergent direction of the beam, and the optical element 620 is configured to control a direction of the beam to obtain a first emergent beam and a second emergent beam. An emergent direction of the first emergent beam and an emergent direction of the second emergent beam are different, and a polarization direction of the first emergent beam and a polarization direction of the second emergent beam are orthogonal.

Optionally, as shown in FIG. 35, the optical element 620 may include a horizontal polarization control sheet, a horizontal liquid crystal polarization grating, a vertical polarization control sheet, and a vertical liquid crystal polarization grating. Distances between the light source and the horizontal polarization control sheet, the horizontal liquid crystal polarization grating, the vertical polarization control sheet, and the vertical liquid crystal polarization grating are in ascending order of magnitude.

Alternatively, in the optical element 620, distances between the light source and the vertical polarization control sheet, the vertical liquid crystal polarization grating, the horizontal polarization control sheet, and the horizontal liquid crystal polarization grating are in ascending order of magnitude.

Receiving unit 640:

The receiving unit 640 may include a receiving lens 641 and a sensor 642.

Beam splitter 630:

The beam splitter 630 is configured to transmit, to different regions of the sensor, a third reflected beam that is obtained by reflecting the first emergent beam by a target object and a fourth reflected beam that is obtained by reflecting the second emergent beam by the target object.

The beam splitter is a passive selector, is generally not controlled by the control unit, and can respectively propagate beams in different polarization states in beams in hybrid polarization states to different regions of the receiving unit.

Optionally, the beam splitter is implemented based on any one of a liquid crystal polarization grating LCPG, a polarization beam splitting PBS prism, and a polarization filter.

In this application, the polarization film is transferred from the transmit end to the receive end, so that the heat loss of the system can be reduced. In addition, the beam splitter is disposed at the receive end, so that the signal-to-noise ratio of the TOF depth sensing module can be improved.

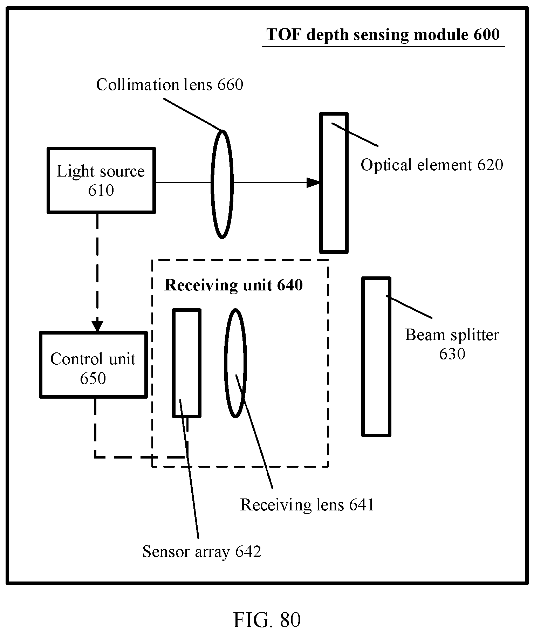

As shown in FIG. 80, the TOF depth sensing module 600 may further include a collimation lens 660. The collimation lens 660 is disposed in the emergent direction of the beam, and the collimation lens 660 is disposed between the light source 610 and the optical element 620. The collimation lens 660 is configured to collimate the beam to obtain a collimated beam. When the collimation lens 660 is disposed between the light source 610 and the optical element 620, the optical element 620 is configured to control a direction of the collimated beam to obtain a first emergent beam and a second emergent beam.

In the foregoing, the collimation lens collimates the beam, so that an approximately parallel beam can be obtained, thereby improving a power density of the beam, and further improving an effect of scanning by the beam subsequently.

Optionally, a clear aperture of the collimation lens is less than or equal to 5 mm.

Because a size of the collimation lens is small, the TOF depth sensing module including the collimation lens is easily integrated into a terminal device, and a space occupied in the terminal device can be reduced to some extent.

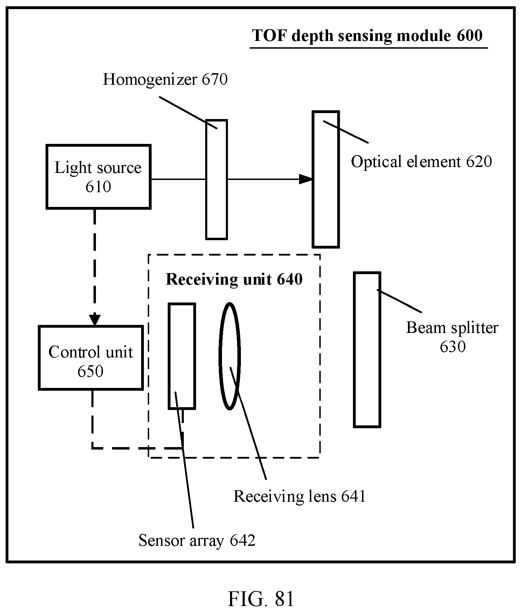

As shown in FIG. 81, the TOF depth sensing module 600 may further include:

a homogenizer 670, where the homogenizer 670 is disposed in the emergent direction of the beam, and the homogenizer 670 is disposed between the light source and the optical element. The homogenizer 670 is configured to adjust energy distribution of the beam to obtain a homogenized beam. When the homogenizer 670 is disposed between the light source 610 and the optical element 620, the optical element 620 is configured to control a direction of the homogenized beam to obtain a first emergent beam and a second emergent beam.

Optionally, the homogenizer may be a microlens diffuser or a diffractive optical element diffuser.

It should be understood that the TOF depth sensing module 600 may include both the collimation lens 660 and the homogenizer 670, and the collimation lens 660 and the homogenizer 670 may both be located between the light source 610 and the optical element 620. For the collimation lens 660 and the homogenizer 670, the collimation lens 660 may be closer to the light source, or the homogenizer 670 may be closer to the light source.

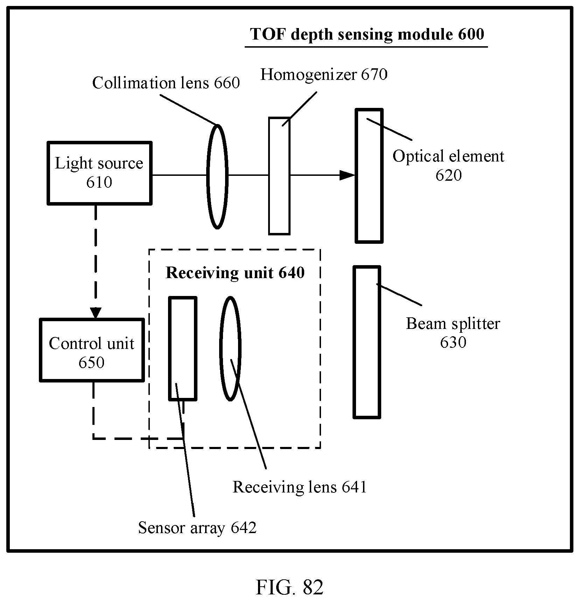

As shown in FIG. 82, a distance between the collimation lens 660 and the light source 610 is less than a distance between the homogenizer 670 and the light source 610.

In the TOF depth sensing module 600 shown in FIG. 82, the beam emitted by the light source 610 is first collimated by the collimation lens 660, then homogenized by the homogenizer 670, and subsequently propagated to the optical element 620 for processing.

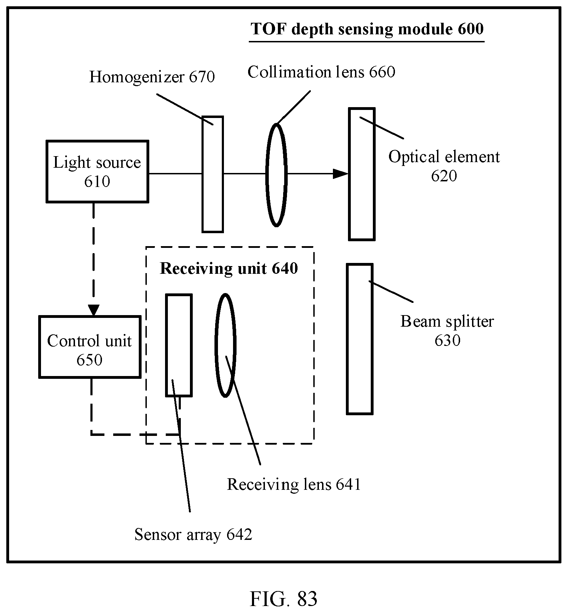

As shown in FIG. 83, the distance between the collimation lens 660 and the light source 610 is greater than the distance between the homogenizer 670 and the light source 610.

In the TOF depth sensing module 600 shown in FIG. 83, the beam emitted by the light source 610 is first homogenized by the homogenizer 670, then collimated by the collimation lens 660, and subsequently propagated to the optical element 620 for processing.

The following describes in detail a specific structure of the TOF depth sensing module 600 with reference to accompanying drawings.

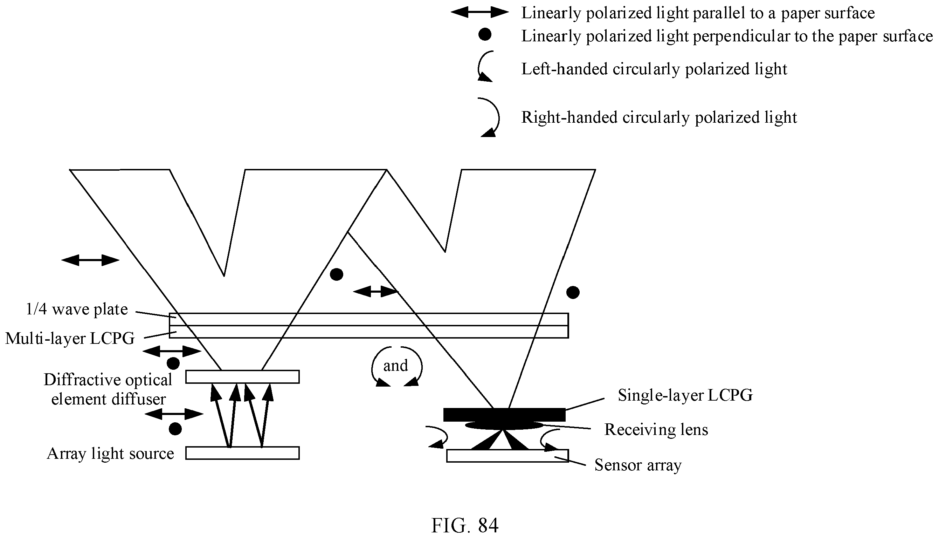

FIG. 84 is a schematic diagram of a structure of a TOF depth sensing module 600.

As shown in FIG. 84, the TOF depth sensing module 600 includes a projection end and a receive end. A light source of the projection end is a VCSEL light source, a homogenizer is a diffractive optical element diffuser (DOE Diffuser), and a beam element is a plurality of layers of LCPGs and a 1/4 wave plate. Each layer of LCPG includes an LCPG component electrically controlled in a horizontal direction and an LCPG component electrically controlled in a vertical direction. Two-dimensional block scanning in the horizontal direction and the vertical direction can be implemented by using a plurality of layers of LCPGs that are cascaded.

Specifically, a wavelength of the VCSEL array light source may be greater than 900 nm. Specifically, the wavelength of the VCSEL array light source may be 940 nm or 1650 nm.

When the wavelength of the VCSEL array light source is 940 nm or 1650 nm, solar spectral intensity in a 940 nm band is weak. This helps reduce noise caused by sunlight in an outdoor scene.

Laser light emitted by the VCSEL array light source may be continuous-wave light or pulsed light. The VCSEL array light source may be divided into several blocks to implement time division control of turning on different regions at different times.

A function of the diffractive optical element diffuser is to shape the beam emitted by the VCSEL array light source into a uniform square or rectangular light source with a specific FOV (for example, a 5°×5° FOV).

A function of the plurality of layers of LCPGs and the 1/4 wave plate is to implement beam scanning.

The receive end and the transmit end share the plurality of layers of LCPGs and the 1/4 wave plate. A receiving lens of the receive end may be a single lens or a combination of a plurality of lenses. The sensor at the receive end is a single-photon avalanche diode (SPAD) array, which can increase a detection distance of the TOF depth sensing module 600 because of sensitivity of the SPAD to detect a single photon. The receive end includes a beam splitter, and the beam splitter is implemented by using a single-layer LCPG. At a same moment, the projection end emits light in two polarization states to different FOV ranges, and then the light passes through the plurality of layers of LCPGs at the receive end and is converged into a same beam. Then, the beam is split into two beams in different directions based on different polarization states by the beam splitter, and is emitted to different locations in the SPAD array.

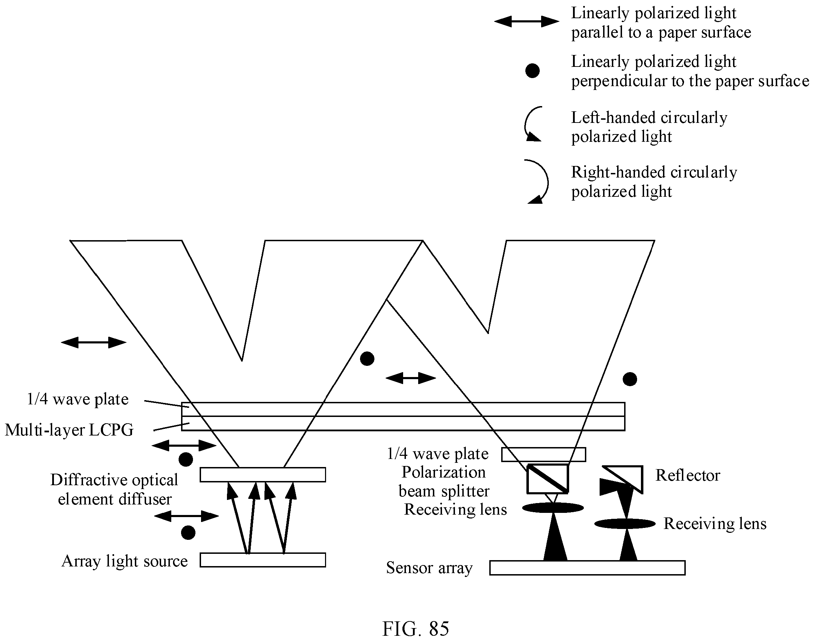

FIG. 85 is a schematic diagram of a structure of a TOF depth sensing module 600.

A difference between the TOF depth sensing module 600 shown in FIG. 85 and the TOF depth sensing module 600 shown in FIG. 84 lies in that, in FIG. 84, the beam splitter is implemented by using a single-layer LCPG, while in FIG. 85, the beam splitter is implemented by using a polarization beam splitter, and the polarization beam splitter is usually formed by gluing coated edges and angles. Because the polarization beam splitter is an existing product, using the polarization beam splitter as the beam splitter has a specific cost advantage.

As shown in FIG. 85, two orthogonal polarization states of the beam obtained through reflection are separated on the polarization beam splitter. One is directly transmitted to a SPAD array sensor, and the other is reflected by another reflector to the SPAD array sensor after reflection.

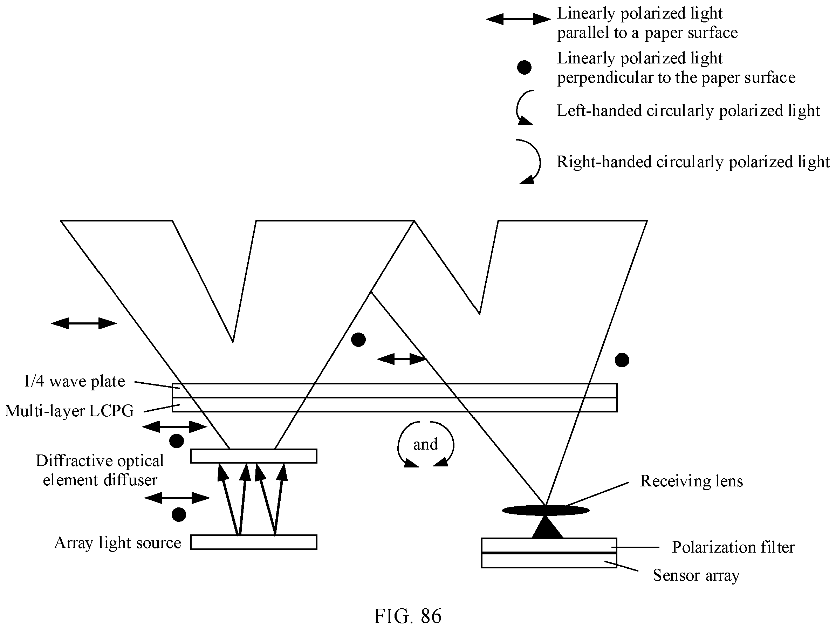

FIG. 86 is a schematic diagram of a structure of a TOF depth sensing module.

A difference from the TOF depth sensing module 600 shown in FIG. 84 lies in that, in FIG. 86, the beam splitter is implemented by using a polarization filter. For example, in FIG. 86, a 1/4 wave plate may be used for implementation.

The polarization filter performs processing similar to pixel processing. Polarization states that can be transmitted on adjacent pixels are different, and each SPAD pixel corresponds to a polarization state. In this way, the SPAD sensor can simultaneously receive two pieces of polarization state information.

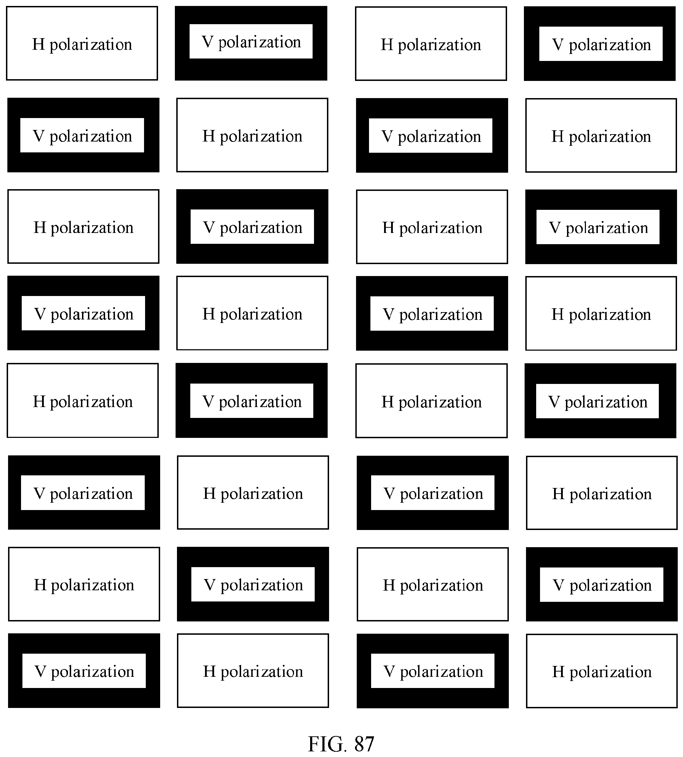

FIG. 87 is a schematic diagram of receiving a polarized beam by a polarization filter.

As shown in FIG. 87, H polarization or V polarization may be transmitted in different regions of the polarization filter, where the H polarization represents polarization in a horizontal direction, and the V polarization represents polarization in a vertical direction. In FIG. 87, different regions on the polarization filter allow only a beam of a corresponding polarization state to reach a corresponding position of the sensor. For example, the H polarization allows only a vertically and horizontally polarized beam to reach a corresponding position of the sensor, and the V-polarization allows only a vertically polarized beam to reach a corresponding position of the sensor.

When the beam splitter uses the polarization filter, because the polarization filter is thin and has a small volume, it is convenient to integrate the polarization filter into a terminal device with a small volume.

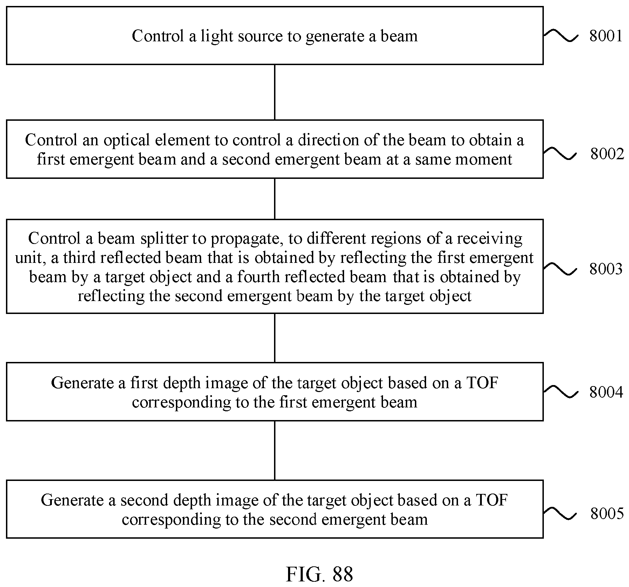

FIG. 88 is a schematic flowchart of an image generation method.

The method shown in FIG. 88 may be performed by a TOF depth sensing module or a terminal device including a TOF depth sensing module. Specifically, the method shown in FIG. 88 may be performed by the TOF depth sensing module shown in FIG. 79 or a terminal device including the TOF depth sensing module shown in FIG. 79. The method shown in FIG. 88 includes steps 8001 to 8006, which are described in detail below.

8001. Control the light source to generate a beam.

8002. Control the optical element to control a direction of the beam to obtain a first emergent beam and a second emergent beam.

An emergent direction of the first emergent beam and an emergent direction of the second emergent beam are different, and a polarization direction of the first emergent beam and a polarization direction of the second emergent beam are orthogonal.

8003. Control a beam splitter to propagate, to different regions of the receiving unit, a third reflected beam that is obtained by reflecting the first emergent beam by a target object and a fourth reflected beam that is obtained by reflecting the second emergent beam by the target object.

8004. Generate a first depth image of the target object based on a TOF corresponding to the first emergent beam.

8005. Generate a second depth image of the target object based on a TOF corresponding to the second emergent beam.

A process of the method shown in FIG. 88 is the same as a basic process of the method shown in FIG. 78, and a main difference lies in that in step 7003 of the method shown in FIG. 78, the third reflected beam and the fourth reflected beam are propagated to different regions of the receiving unit by using the beam selector. However, in step 8003 of the method shown in FIG. 88, the third reflected beam and the fourth reflected beam are propagated to different regions of the receiving unit by using the beam splitter.

Because the transmit end does not have a polarization filter, the beam emitted by the light source may reach the optical element almost without a loss (the polarization filter generally absorbs much light energy, leading to a heat loss), so that a heat loss of the terminal device can be reduced.

Optionally, the method shown in FIG. 88 further includes: splicing the first depth image and the second depth image to obtain a depth image of the target object.

It should be understood that, in the method shown in FIG. 88, a third depth image, a fourth depth image, and the like may be further generated in a similar manner. Next, all depth images may be spliced or combined, to obtain a final depth image of the target object.

Optionally, the terminal device further includes a collimation lens. The collimation lens is disposed between the light source and the optical element. The method shown in FIG. 88 further includes:

8006. Collimate the beam by using the collimation lens to obtain a collimated beam.

Step 8002 specifically includes: controlling the optical element to control a direction of the collimated beam, to obtain a first emergent beam and a second emergent beam.

In addition, in the foregoing, the collimation lens collimates the beam, so that an approximately parallel beam can be obtained, thereby improving a power density of the beam, and further improving an effect of scanning by the beam subsequently.

Optionally, the terminal device further includes a homogenizer. The homogenizer is disposed between the light source and the optical element. The method shown in FIG. 88 further includes:

8007. Adjust energy distribution of the beam by using the homogenizer to obtain a homogenized beam.

That the step 8002 specifically includes: controlling the optical element to control a direction of the beam, to obtain a first emergent beam and a second emergent beam includes: controlling the optical element to control a direction of the homogenized beam, to obtain the first emergent beam and the second emergent beam.

Through homogenization, an optical power of the beam can be more uniform in an angular space, or distributed based on a specific rule, to prevent an excessively low local optical power, thereby avoiding a blind spot in a finally obtained depth image of the target object.

Based on steps 8001 to 8005, the method shown in FIG. 88 may further include step 8006 or step 8007.

Alternatively, based on steps 8001 to 8005, the method shown in FIG. 88 may further include step 8006 and step 8007. In this case, after step 8001 is performed, step 8006 may be performed first, then step 8007 is performed, and then step 8002 is performed. Alternatively, step 8007 may be performed first, then step 8006 is performed, and then step 8002 is performed. In other words, after the light source generates the beam in step 8001, the beam may be first collimated and then homogenized (the energy distribution of the beam is adjusted by using the homogenizer), and then the optical element controls the direction of the beam. Alternatively, after the light source generates the beam in step 8001, the beam may be first homogenized (the energy distribution of the beam is adjusted by using the homogenizer) and then collimated, and then the optical element controls the direction of the beam.

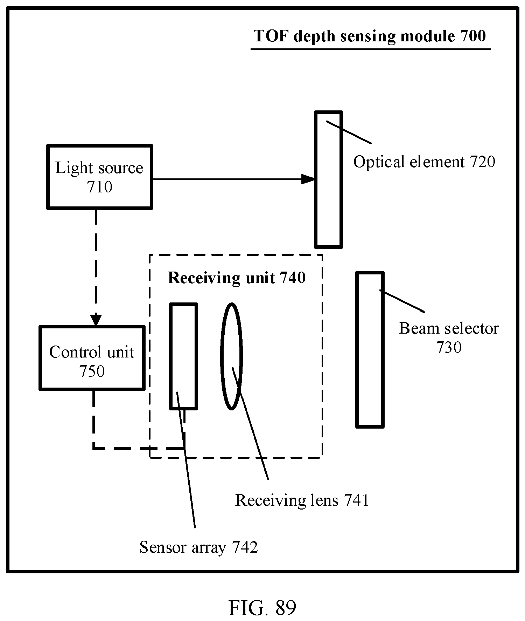

The foregoing describes in detail one TOF depth sensing module and image generation method with reference to FIG. 79 to FIG. 88. The following describes in detail another TOF depth sensing module and image generation method with reference to FIG. 89 to FIG. 101.

Due to excellent polarization and phase adjustment capabilities of a liquid crystal device, a liquid crystal device is usually used in a TOF depth sensing module to control a beam. However, due to a limitation of a liquid crystal material, a response time of the liquid crystal device is limited to some extent, and is usually in a millisecond order. Therefore, a scanning frequency of the TOF depth sensing module using the liquid crystal device is low (usually less than 1 kHz).

This application provides a new TOF depth sensing module. Time sequences of drive signals of electrically controlled liquid crystal of a transmit end and a receive end are controlled to be staggered by a specific time (for example, half a period), to increase a scanning frequency of a system.

The following first briefly describes the TOF depth sensing module with reference to FIG. 89.

The TOF depth sensing module 700 shown in FIG. 89 includes a light source 710, an optical element 720, a beam selector 730, a receiving unit 740, and a control unit 750.

Functions of the modules or units in the TOF depth sensing module are specifically as follows:

Light source 710:

The light source 710 is configured to generate a beam.

Optionally, the light source 710 is a vertical cavity surface emitting laser (vertical cavity surface emitting laser, VCSEL).

Optionally, the light source 710 is a Fabry-Perot laser (which may be referred to as an FP laser for short).

A single FP laser can implement a larger power than a single VCSEL, and has higher electro-optical conversion efficiency than the VCSEL, thereby improving a scanning effect of the TOF depth sensing module.

Optionally, a wavelength of the beam emitted by the light source 710 is greater than 900 nm.

Because intensity of light whose wavelength is greater than 900 nm in sunlight is weak, when the wavelength of the beam is greater than 900 nm, interference caused by the sunlight can be reduced, thereby improving a scanning effect of the TOF depth sensing module.

Optionally, a wavelength of the beam emitted by the light source 710 is 940 nm or 1550 nm.

Because intensity of light whose wavelength is near 940 nm or 1550 nm in sunlight is weak, when the wavelength of the beam is 940 nm or 1550 nm, interference caused by the sunlight can be greatly reduced, thereby improving a scanning effect of the TOF depth sensing module.

Optionally, a light emitting area of the light source 710 is less than or equal to $5 \times 5$ mm$^2$.

Because a size of the light source is small, the TOF depth sensing module including the light source is easily integrated into a terminal device, and a space occupied in the terminal device can be reduced to some extent.

Optionally, an average output optical power of the TOF depth sensing module 700 is less than 800 mw.

When the average output optical power of the TOF depth sensing module is less than or equal to 800 mw, the TOF depth sensing module has small power consumption, and can be disposed in a device sensitive to power consumption, such as a terminal device.

Optical element 720:

The optical element 720 is disposed in a direction in which the light source emits a beam, and the optical element 720 is configured to deflect the beam under control of the control unit 750, to obtain an emergent beam.

Beam selector 730:

The beam selector 730 is configured to select, under control of the control unit 750, a beam having at least two polarization states from beams in each period in reflected beams of a target object, to obtain a received beam, and transmit the received beam to the receiving unit 740.

The emergent beam is a beam changing periodically, a value of a change period of the emergent beam is a first time interval. In emergent beams, tilt angles of beams in adjacent periods are different, beams in a same period have at least two polarization states, and the beams in the same period have a same tilt angle and different azimuths.

The direction and the polarization state of the beam emitted by the light source are adjusted by using the optical element and the beam selector, so that the emergent beams in adjacent periods have different tilt angles, and the beams in the same period have at least two polarization states. This increases the scanning frequency of the TOF depth sensing module.

In this application, the control unit controls control signals of the transmit end and the receive end to stagger the time sequence by a specific time, so that the scanning frequency of the TOF depth sensing module can be increased.

Optionally, as shown in FIG. 35, the optical element 720 includes a horizontal polarization control sheet, a horizontal liquid crystal polarization grating, a vertical polarization control sheet, and a vertical liquid crystal polarization grating. Distances between the light source and the horizontal polarization control sheet, the horizontal liquid crystal polarization grating, the vertical polarization control sheet, and the vertical liquid crystal polarization grating are in ascending order of magnitude.

Alternatively, in the optical element 720, distances between the light source and the vertical polarization control sheet, the vertical liquid crystal polarization grating, the horizontal polarization control sheet, and the horizontal liquid crystal polarization grating are in ascending order of magnitude.

Optionally, the beam selector includes a 1/4 wave plate + an electrically controlled half wave plate + a polarization film.

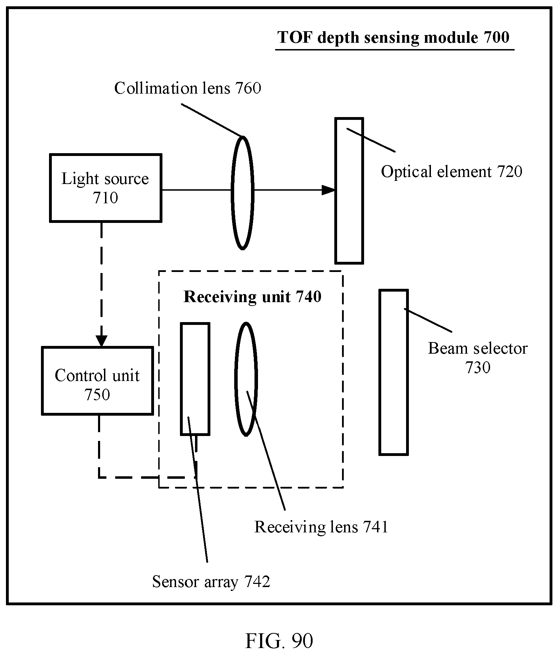

As shown in FIG. 90, the TOF depth sensing module may further include a collimation lens 760. The collimation lens 760 is disposed between the light source 710 and the optical element 720. The collimation lens 760 is configured to collimate the beam. The optical element 720 is configured to deflect, under the control of the control unit 750, a collimated beam of the collimation lens, to obtain an emergent beam.

When the TOF depth sensing module includes the collimation lens, the collimation lens can be used to collimate the beams emitted by the light source, so that approximately parallel beams can be obtained, thereby improving power densities of the beams, and further improving an effect of scanning by the beams subsequently.

Optionally, a clear aperture of the collimation lens is less than or equal to 5 mm.

Because a size of the collimation lens is small, the TOF depth sensing module including the collimation lens is easily integrated into a terminal device, and a space occupied in the terminal device can be reduced to some extent.

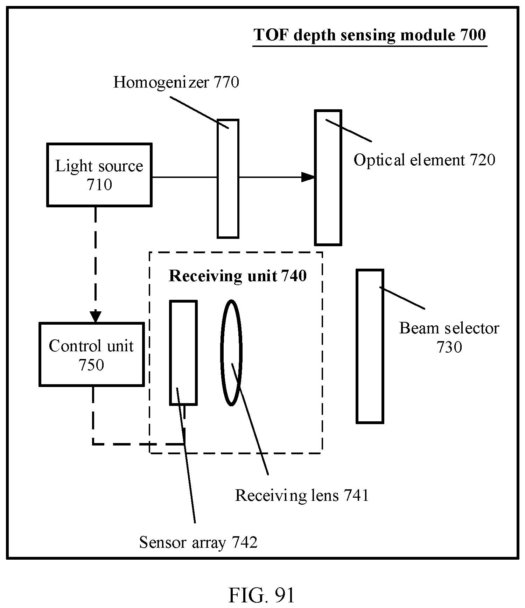

As shown in FIG. 91, the TOF depth sensing module 700 further includes a homogenizer 770. The homogenizer 770 is disposed between the light source 710 and the optical element 720. The homogenizer 770 is configured to adjust angular intensity distribution of a beam. The optical element 720 is configured to control, under control of the control unit 750, a direction of a beam homogenized by the homogenizer 770, to obtain an emergent beam.

Optionally, the homogenizer 770 is a microlens diffuser or a diffractive optical element diffuser.

Through homogenization, an optical power of the beam can be more uniform in an angular space, or distributed based on a specific rule, to prevent an excessively low local optical power, thereby avoiding a blind spot in a finally obtained depth image of the target object.

It should be understood that the TOF depth sensing module 700 may include both the collimation lens 760 and the homogenizer 770, and the collimation lens 760 and the homogenizer 770 may both be located between the light source 710 and the optical element 720. For the collimation lens 760 and the homogenizer 770, the collimation lens 760 may be closer to the light source, or the homogenizer 770 may be closer to the light source.

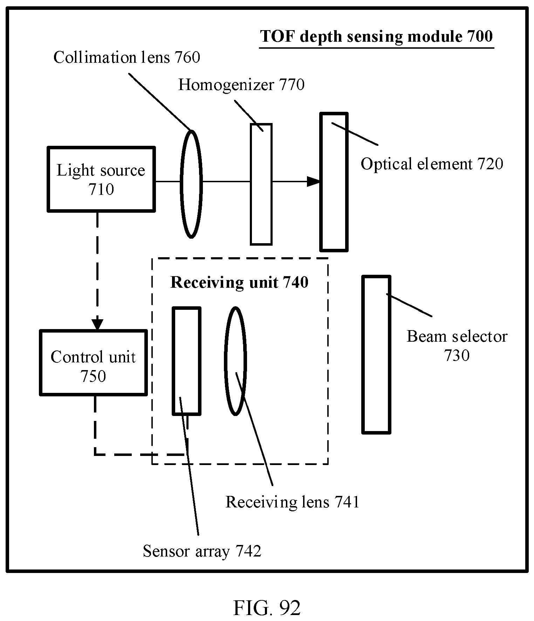

FIG. 92 is a schematic diagram of a specific structure of a TOF depth sensing module.

As shown in FIG. 92, a distance between the collimation lens 760 and the light source 710 is less than a distance between the homogenizer 770 and the light source 710.

In the TOF depth sensing module 700 shown in FIG. 92, the beam emitted by the light source 710 is first collimated by the collimation lens 760, then homogenized by the homogenizer 770, and subsequently propagated to the optical element 720 for processing.

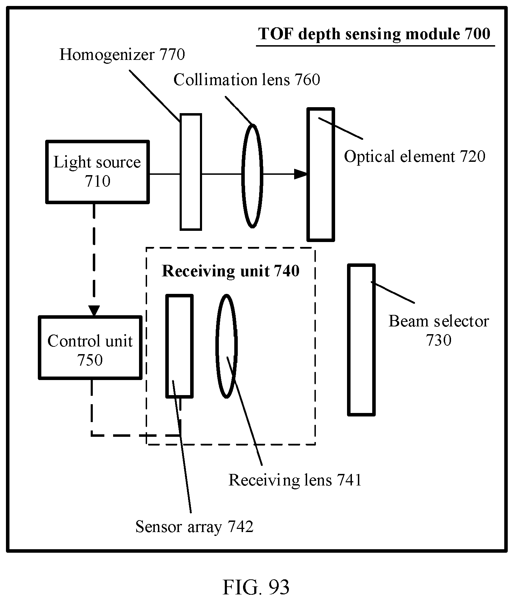

FIG. 93 is a schematic diagram of a specific structure of a TOF depth sensing module.

As shown in FIG. 93, the distance between the collimation lens 760 and the light source 710 is greater than the distance between the homogenizer 770 and the light source 710.

In the TOF depth sensing module 700 shown in FIG. 93, the beam emitted by the light source 710 is first homogenized by the homogenizer 770, then collimated by the collimation lens 760, and subsequently propagated to the optical element 720 for processing.

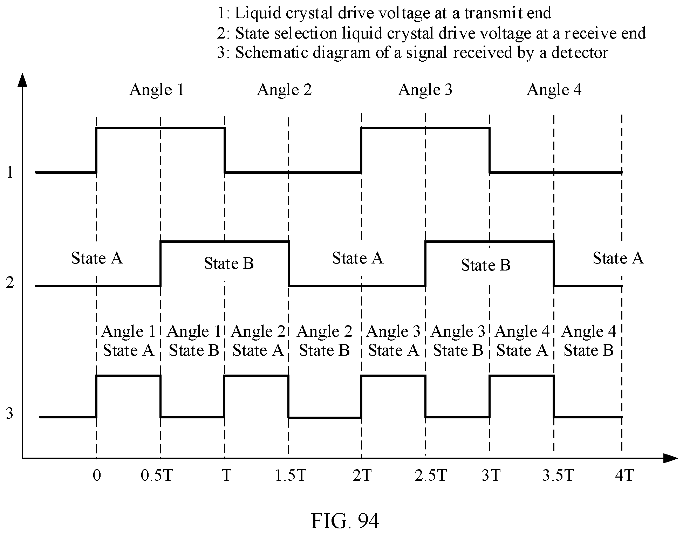

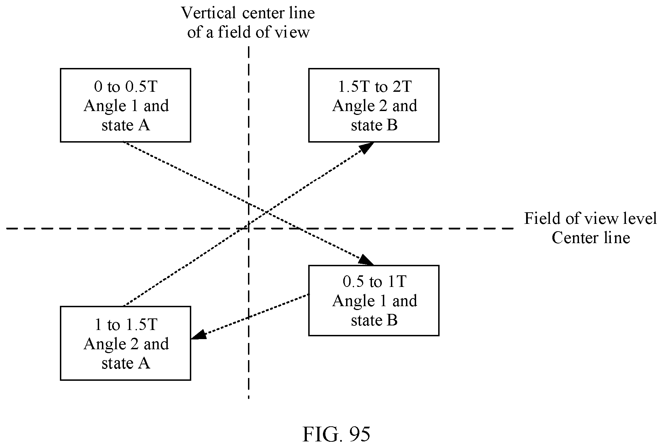

The following describes a working process of the TOF depth sensing module 700 with reference to FIG. 94 and FIG. 95.

As shown in FIG. 94, assuming that highest frequencies of the electrically controlled components of the transmit end and the receive end of the TOF depth sensing module 700 are both 1/T, the control unit staggers control time sequences of the transmit end and the receive end by half a period (0.5T). In this case, a sensor at the receive end can receive beams at different spatial locations at an interval of 0.5T.

As shown in FIG. 95, within a time of 0 to 0.5T, the sensor at the receive end receives a beam at an angle 1 and in a state A. Within a time of 0.5T to T, the sensor at the receive end receives a beam at the angle 1 and in a state B. Within a time of T to 1.5T, the sensor at the receive end receives a beam at an angle 2 and in the state A. Within a time of 1.5T to 2T, the sensor at the receive end receives a beam at the angle 2 and in the state B. In this way, a scanning frequency of the system is doubled from 1/T to 2/T.

The following describes in detail a specific structure of the TOF depth sensing module 700 with reference to the accompanying drawings.

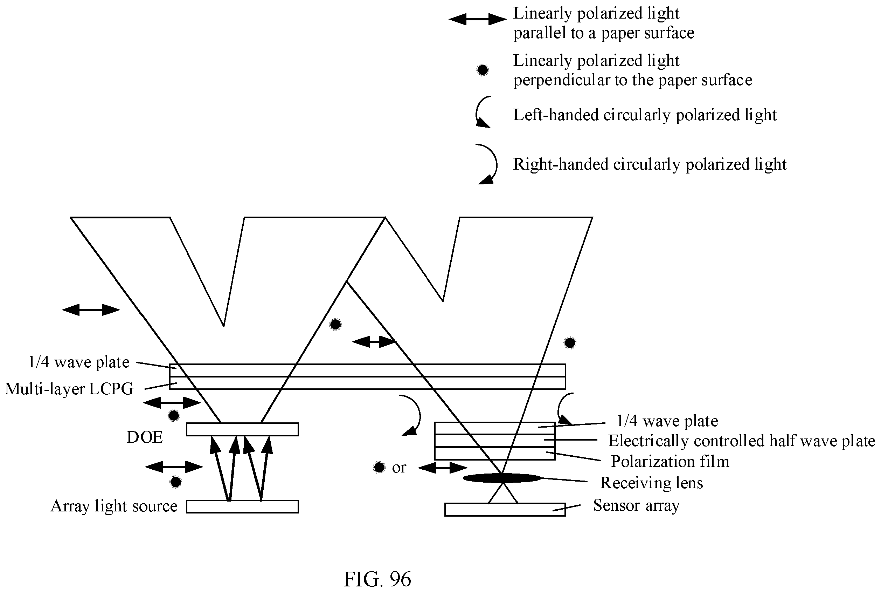

FIG. 96 is a schematic diagram of a structure of a TOF depth sensing module 700.

As shown in FIG. 96, the TOF depth sensing module 700 includes a projection end, a receive end and a control unit. The projection end includes a light source, a homogenizer, and an optical element. The receive end includes an optical element, a beam (dynamic) selector, a receiving lens, and a two-dimensional sensor. The control unit is configured to control the projection end and the receive end to complete beam scanning.

A light source of the projection end is a VCSEL light source, a homogenizer is a diffractive optical element diffuser (DOE Diffuser), and a beam element is a plurality of layers of LCPGs and a 1/4 wave plate. Each layer of LCPG includes an LCPG component electrically controlled in a horizontal direction and an LCPG component electrically controlled in a vertical direction. Two-dimensional block scanning in the horizontal direction and the vertical direction can be implemented by using a plurality of layers of LCPGs that are cascaded.

Specifically, a wavelength of the VCSEL array light source may be greater than 900 nm. Specifically, the wavelength of the VCSEL array light source may be 940 nm or 1650 nm.

When the wavelength of the VCSEL array light source is 940 nm or 1650 nm, solar spectral intensity in a 940 nm band is weak. This helps reduce noise caused by sunlight in an outdoor scene.

Laser light emitted by the VCSEL array light source may be continuous-wave light or pulsed light. The VCSEL array light source may be divided into several blocks to implement time division control of turning on different regions at different times.

A function of the diffractive optical element diffuser is to shape the beam emitted by the VCSEL array light source into a uniform square or rectangular light source with a specific FOV (for example, a 5°×5° FOV).

A function of the plurality of layers of LCPGs and the 1/4 wave plate is to implement beam scanning.

In this application, light at different angles and in different states may be dynamically selected to enter the sensor through time division control at the transmit end and the receive end. As shown in FIG. 96, laser light emitted by an ordinary VCSEL array light source has no fixed polarization state, which may be decomposed into linearly polarized laser light parallel to a paper surface and linearly polarized laser light perpendicular to the paper surface. After passing through the LCPGs, the linearly polarized laser light is split into two laser beams in different polarization states (left-handed circular polarization and right-handed circular polarization), which respectively have different emergent angles. After the two laser beams pass through the 1/4 wave plate, corresponding polarization states are converted into linearly polarized light parallel to the paper surface and linearly polarized light perpendicular to the paper surface. Reflected beams generated after the two laser beams in the different polarization states irradiate an object in a target region are received by the LCPGs and the 1/4 wave plate that are shared at the transmit end and the receive end, and then become laser light having a same divergence angle but in different polarization states: left-handed circularly polarized light and right-handed circularly polarized light. The beam selector at the receive end includes the 1/4 wave plate + the electrically controlled half wave plate + the polarization film. After the received light passes through the 1/4 wave plate, the polarization states are converted into linearly polarized light parallel to the paper surface and linearly polarized light perpendicular to the paper surface. In this way, through time division control, the electrically controlled half wave plate rotates a polarization state of linearly polarized light by 90 degrees or does not change a polarization state passing through the half wave plate, so that the linearly polarized light parallel to the paper surface and the linearly polarized light perpendicular to the paper surface are transmitted at different times, and light in the other polarization state is absorbed or scattered by the polarization film.

In FIG. 96, time division control signals at the transmit end and the receive end may be shown in FIG. 94. By staggering the control time sequence of an electrically controlled LCPG of the transmit end and the control time sequence of the electrically controlled half-wave plate of the receive end by half the period (0.5T), the scanning frequency of the system can be doubled.

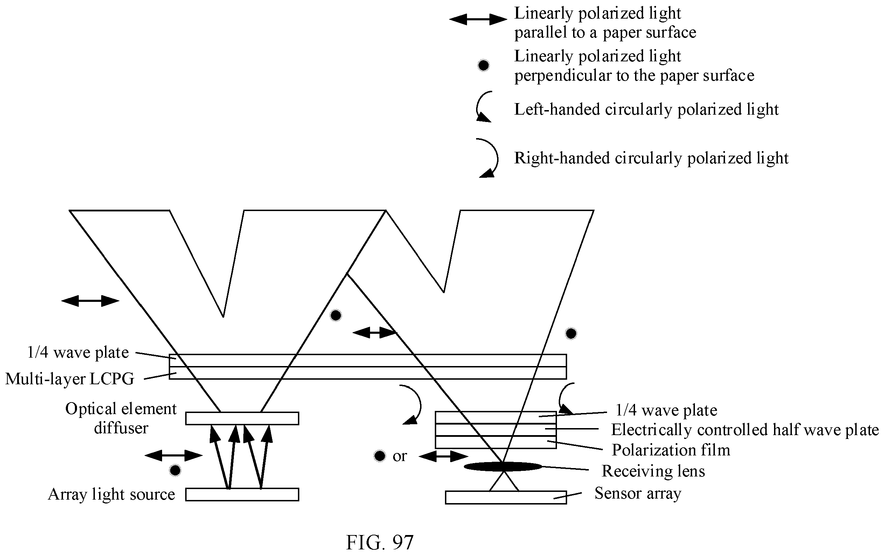

FIG. 97 is a schematic diagram of a structure of a TOF depth sensing module 700.

As shown in FIG. 97, based on the TOF depth sensing module shown in FIG. 96, the diffractive optical element diffuser (DOE Diffuser) in rear of the VCSEL array light source is changed to a microlens diffuser (Diffuser). The microlens diffuser implements homogenization based on geometrical optics, and therefore has high transmission efficiency that can reach more than 80%, while transmission efficiency of a conventional diffractive optical element diffuser (DOE Diffuser) is only about 70%. A form of the microlens diffuser is shown in FIG. 77. The microlens diffuser includes a series of randomly distributed microlenses. A position and a form of each microlens are designed and optimized through simulation, so that a shaped beam is as uniform as possible and transmission efficiency is high.

A driving principle of the TOF depth sensing module shown in FIG. 97 is the same as that of the TOF depth sensing module shown in FIG. 96, and the diffractive optical element diffuser (DOE Diffuser) in the TOF depth sensing module shown in FIG. 96 is replaced with an optical diffuser to improve transmission efficiency of the transmit end. Other details are not described.

For the TOF depth sensing module shown in FIG. 97, time division control signals at the transmit end and the receive end may be shown in FIG. 94. By staggering the control time sequence of an electrically controlled LCPG of the transmit end and the control time sequence of the electrically controlled half-wave plate of the receive end by half the period (0.5T), the scanning frequency of the system can be doubled.

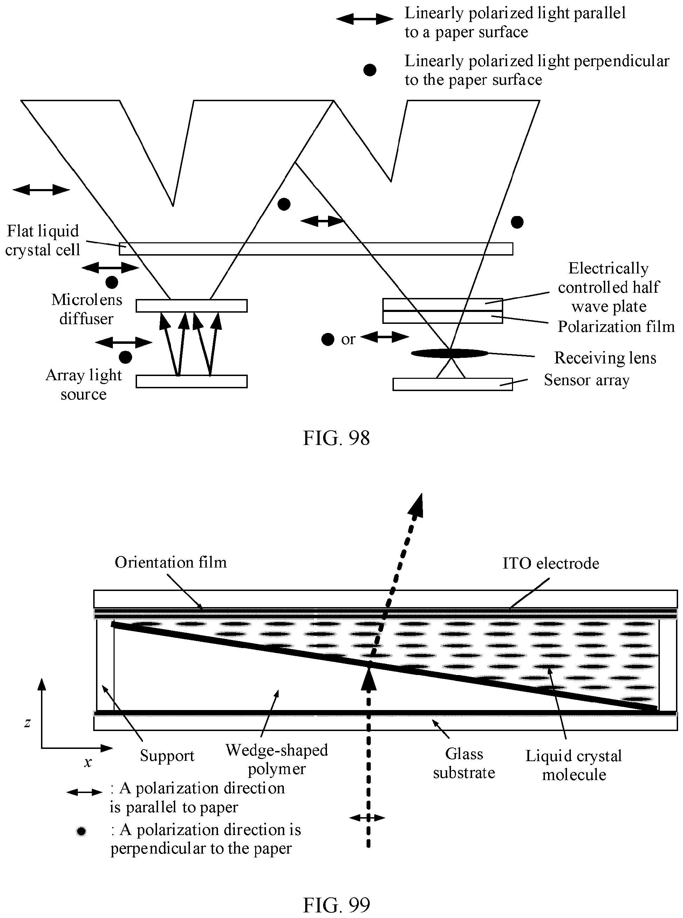

FIG. 98 is a schematic diagram of a structure of a TOF depth sensing module 700.

Based on the TOF depth sensing module shown in FIG. 96 or FIG. 97, the optical element may be changed from the multilayer LCPG and the 1/4 wave plate to a multilayer flat liquid crystal cell, as shown in FIG. 98. A plurality of layers of flat liquid crystal cells are used to implement beam deflection at a plurality of angles and in horizontal and vertical directions. The beam selector at the receive end includes an electrically controlled half wave plate and a polarization film.

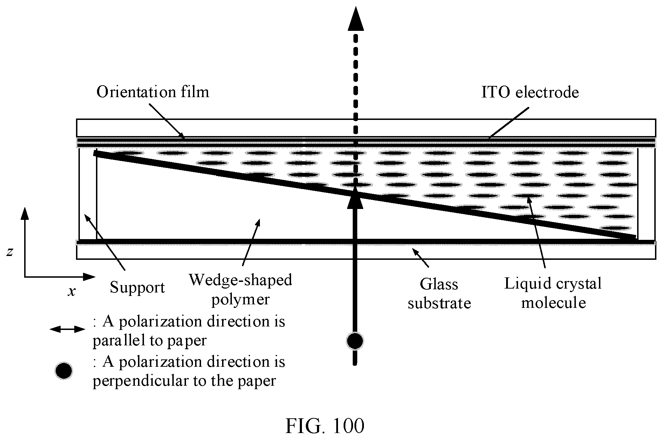

A beam deflection principle of the flat liquid crystal cell is shown in FIG. 99 and FIG. 100. Beam deflection is implemented by using a wedge-shaped polymer (Polymer) interface. A refractive index of the wedge-shaped polymer material needs to be equal to an ordinary refractive index $n_0$ of liquid crystal. In this way, as shown in FIG. 99, when an optical axis of a liquid crystal molecule is parallel to an x direction, incident light parallel to a paper surface deflects at a specific angle. A magnitude of the deflection angle may be controlled by controlling a voltage applied to the incident light, and incident light perpendicular to the paper surface propagates along a straight line. In this way, by superimposing a plurality of layers of flat liquid crystal cells with different orientations (an optical axis is parallel to an x direction or a y direction), deflected incident light can be simultaneously projected to different angles.

Similarly, by controlling a drive voltage of the flat liquid crystal cell at the transmit end and the drive voltage of the electric control half-wave plate at the receive end, the control time sequences of the two are staggered by half the period (0.5T), so that the scanning frequency of the liquid crystal can be increased.

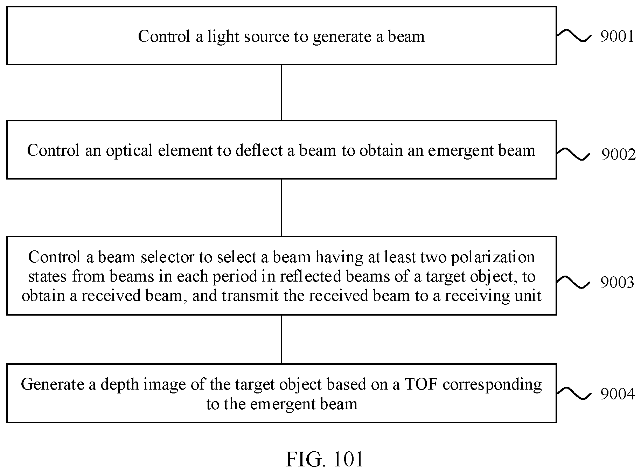

FIG. 101 is a schematic flowchart of an image generation method.

The method shown in FIG. 101 may be performed by a TOF depth sensing module or a terminal device including a TOF depth sensing module. Specifically, the method shown in FIG. 101 may be performed by the TOF depth sensing module shown in FIG. 89 or a terminal device including the TOF depth sensing module shown in FIG. 89. The method shown in FIG. 101 includes steps 9001 to 9004, which are described in detail below.

9001. Control the light source to generate a beam.

9002. Control an optical element to deflect a beam to obtain an emergent beam.

9003. Control the beam selector to select a beam having at least two polarization states from beams in each period in reflected beams of a target object, to obtain a received beam, and transmit the received beam to a receiving unit.

9004. Generate a depth image of the target object based on a TOF corresponding to the emergent beam.

The emergent beam is a beam changing periodically, a value of a change period of the emergent beam is a first time interval. In emergent beams, tilt angles of beams in adjacent periods are different, beams in a same period have at least two polarization states, and the beams in the same period have a same tilt angle and different azimuths.

The TOF corresponding to the emergent beam may be specifically time difference information between a moment at which the reflected beam corresponding to the emergent beam is received by the receiving unit and an emission moment of an emergent light source. The reflected beam corresponding to the emergent beam may be specifically a beam that is generated after the emergent beam is processed by the optical element and the beam selector and is reflected by the target object when reaching the target object.

The direction and the polarization state of the beam emitted by the light source are adjusted by using the optical element and the beam selector, so that the emergent beams in adjacent periods have different tilt angles, and the beams in the same period have at least two polarization states. This increases the scanning frequency of the TOF depth sensing module.

Optionally, the terminal device further includes a collimation lens. The collimation lens is disposed between the light source and the optical element. In this case, the method shown in FIG. 101 further includes:

9005. Collimate the beam by using the collimation lens to obtain a collimated beam.

The controlling an optical element to deflect a beam to obtain an emergent beam in step 9002 specifically includes: controlling the optical element to control a direction of the collimated beam, to obtain an emergent beam.

In the foregoing, the collimation lens collimates the beam, so that an approximately parallel beam can be obtained, thereby improving a power density of the beam, and further improving an effect of scanning by the beam subsequently.

Optionally, the terminal device further includes a homogenizer. The homogenizer is disposed between the light source and the optical element. In this case, the method shown in FIG. 101 further includes:

9006. Adjust energy distribution of the beam by using the homogenizer to obtain a homogenized beam.

The controlling an optical element to deflect a beam to obtain an emergent beam in step 9002 specifically includes: controlling the optical element to control a direction of the homogenized beam, to obtain the emergent beam.

Through homogenization, an optical power of the beam can be more uniform in an angular space, or distributed based on a specific rule, to prevent an excessively low local optical power, thereby avoiding a blind spot in a finally obtained depth image of the target object.

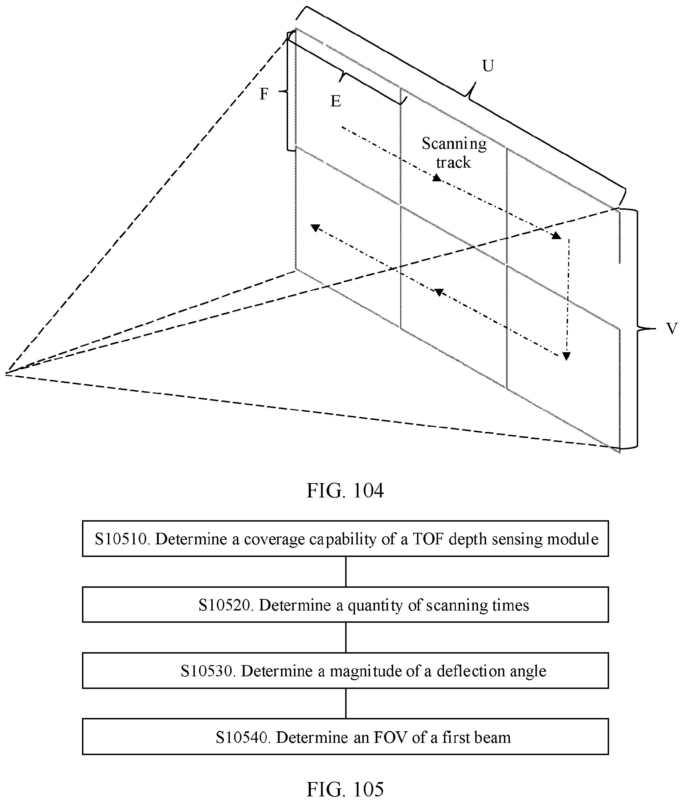

With reference to FIG. 102 and FIG. 104, the following describes that the FOV of the first beam obtained through processing by the beam shaper in the TOF depth sensing module 300 and the total FOV obtained through scanning in the M different directions. In addition, an overall solution design is described with reference to FIG. 105.

It should be understood that the beam shaper 330 in the TOF depth sensing module 300 adjusts a beam to obtain a first beam, where an FOV of the first beam meets a first preset range.

Optionally, the first preset range may include [5°×5°, 20°×20°].

FIG. 102 is a schematic diagram of the FOV of the first beam.

As shown in FIG. 102, the first beam is emitted from a point O, an FOV of the first beam in a vertical direction is an angle A, an FOV of the first beam in a horizontal direction is an angle B, and a rectangle E is a region in which the first beam is projected onto the target object (the region in which the first beam is projected onto the target object may be a rectangular region, or certainly may be of another shape). A value range of the angle A is between 5° and 20° (which may include 5° and 20°). Similarly, a value range of the angle B is also between 5° and 20° (which may include 5° and 20°).

In the TOF depth sensing module 300, the control unit 370 may be configured to control the first optical element to respectively control a direction of the first beam at M different moments, to obtain emergent beams in M different directions, where a total FOV covered by the emergent beams in the M different directions meets a second preset range.

Optionally, the second preset range may be [50°×50°, 80°×80°].

FIG. 103 is a schematic diagram of a total FOV covered by emergent beams in M different directions.

Specifically, as shown in FIG. 103, M emergent beams in different directions are emitted from the point O, and a region covered on the target object is a rectangle F. An angle C is a superimposed value of FOVs of the M emergent beams in different directions in a vertical direction, and an angle D is a superimposed value of FOVs of the M emergent beams in different directions in a horizontal direction. A value range of the angle C is between 50° and 80° (which may include 50° and 80°). Similarly, a value range of the angle D is also between 50° and 80° (which may include 50° and 80°).

It should be understood that a total FOV covered by the M emergent beams in different directions is obtained by scanning in the M different directions by the first beam. For example, FIG. 104 is a schematic diagram of scanning performed in M different directions by a TOF depth sensing module.

In this example, as shown in FIG. 104, an FOV of the first beam is E×F, a total FOV covered by the TOF depth sensing module is U×V, and a quantity of scanning times is 6. In other words, scanning is performed in six different directions.

The six times of scanning are performed in the following manner: Scanning is separately performed on two rows, and each row is scanned for three times (in other words, a quantity of columns to be scanned is 3, and a quantity of rows to be scanned is 2). Therefore, the quantity of scanning times may also be represented as $3\times2$.

In this example, a scanning track is first scanning a first row for three times from left to right, then deflecting to a second row, and scanning the second row for three times from right to left, to cover an entire FOV range.

It should be understood that the scanning track and the quantity of scanning times in this example are merely used as an example, and cannot constitute a limitation on this application.

It should be understood that, in an actual operation, when scanning is performed in two adjacent directions, transformation from one direction to the other adjacent direction may be implemented by setting a specific deflection angle.

It should be further understood that, before actual scanning, a magnitude of the deflection angle further needs to be determined based on an actual situation. Only when the deflection angle is controlled within an appropriate range, the first beam can cover an entire to-be-scanned region after a plurality of times of scanning. The following describes an overall solution design with reference to FIG. 105.

FIG. 105 is a schematic flowchart of an overall solution design. As shown in FIG. 105, the overall solution design includes steps S10510 to S10540. It should be understood that a sequence of the foregoing steps is not limited in this application. Any combination of the foregoing steps that can be used to implement the solutions of this application falls within the protection scope of this application. The following describes the foregoing steps in detail.

S10510. Determine a coverage capability of the TOF depth sensing module.

It should be understood that during solution design, the coverage capability of the TOF depth sensing module needs to be determined first, and then an appropriate deflection angle can be determined with reference to a quantity of scanning times.

It should be understood that the coverage capability of the TOF depth sensing module is a range that an FOV of the TOF depth sensing module can cover.

Optionally, the TOF depth sensing module is mainly designed for front-facing facial recognition. To ensure unlocking requirements of a user in different scenarios, the FOV of the TOF depth sensing module should be greater than $50\times50$. In addition, an FOV range of the TOF depth sensing module should not be very large. If the FOV range is very large, aberration and distortion increase. Therefore, the FOV range of the TOF depth sensing module may generally range from $50\times50$ to $80\times80$.

In this example, the determined a total FOV that can be covered by the TOF depth sensing module may be represented by $U\times V$.

S10520. Determine a quantity of scanning times.

It should be understood that an upper limit of a quantity of scanning times is determined by performance of the first optical element. For example, the first optical element is a liquid crystal polarization grating (LCPG), and a response time of a liquid crystal molecule is approximately S ms (millisecond). In this case, the first optical element scans a maximum of 1000/S times within 1S. Considering that a frame rate of a depth image generated by the TOF depth sensing module is T frames/second, each frame of picture may be scanned for a maximum of 1000/(S*T) times.

It should be understood that, under a same condition, a larger quantity of scanning times each frame of picture indicates a higher intensity density of scanning on a beam, and a longer scanning distance can be implemented.

It should be understood that a quantity of scanning times in an actual operation may be determined based on a determined upper limit of the quantity of scanning times, provided that it is ensured that the quantity of scanning times does not exceed the upper limit. This is not further limited in this application.

It should be understood that, in this example, the determined quantity of scanning times may be represented by $X\times Y$. Y indicates that a quantity of rows to be scanned is Y, and X indicates that a quantity of columns to be scanned is X. In other words, scanning is performed in Y rows, and each row is scanned for X times.

S10530. Determine a magnitude of the deflection angle.

It should be understood that, the magnitude of the deflection angle may be determined based on the FOV coverage capability and the quantity of scanning times that are of the TOF depth sensing module and that are determined in the foregoing two steps.

Specifically, if the total FOV that can be covered by the TOF depth sensing module is $U\times V$, the quantity of scanning times is $X\times Y$. Therefore, a deflection angle in a horizontal (that is, on each row) scanning process should be greater than or equal to U/X, and a deflection angle in a vertical (that is, column direction that indicates deflection from one row to another row) scanning process should be greater than or equal to V/Y.

It should be understood that, if the deflection angle is small, the total FOV of the TOF depth sensing module cannot be covered in a preset quantity of scanning times.

S10540. Determine an FOV of the first beam.

It should be understood that, after the magnitude of the deflection angle is determined, the FOV of the first beam is determined based on the magnitude of the deflection angle. In this example, the FOV of the first beam may be represented by $E\times F$. It should be understood that the FOV of the first beam should be greater than or equal to the magnitude of the deflection angle, to ensure that there is no slit (that is, a missed region that is not scanned) in adjacent scanning regions. In this case, E should be greater than or equal to a horizontal deflection angle, and F should be greater than or equal to a vertical deflection angle.

Optionally, the FOV of the first beam may be slightly greater than the deflection angle. For example, the FOV of the first beam may be 5% greater than the deflection angle. This is not limited in this application.

It should be understood that the coverage capability, the quantity of scanning times, the FOV of the first beam, and the magnitude of the deflection angle of the TOF depth sensing module may be determined through mutual coordination in an actual operation, to control all the four within an appropriate range. This is not limited in this application.

It should be understood that, with reference to FIG. 102 to FIG. 104, the foregoing explanations of the first beam generated by the TOF depth sensing module 300 and the FOVs of the M emergent beams in different directions are also applicable to the first beam generated by the TOF depth sensing module 400 and the M emergent beams in different directions. Details are not described herein again.

A person of ordinary skill in the art may be aware that, in combination with the examples described in embodiments disclosed in this specification, units and algorithm steps may be implemented by electronic hardware or a combination of computer software and electronic hardware. Whether the functions are performed by hardware or software depends on particular applications and design constraint conditions of the technical solutions. A person skilled in the art may use different methods to implement the described functions for each particular application, but it should not be considered that the implementation goes beyond the scope of this application.

It may be clearly understood by a person skilled in the art that, for the purpose of convenient and brief description, for a detailed working process of the foregoing system, apparatus, and unit, refer to a corresponding process in the foregoing method embodiments. Details are not described herein again.

In the several embodiments provided in this application, it should be understood that the disclosed system, apparatus, and method may be implemented in other manners. For example, the described apparatus embodiment is merely an example. For example, division into the units is merely logical function division and may be other division during actual implementation. For example, a plurality of units or components may be combined or integrated into another system, or some features may be ignored or not performed. In addition, the displayed or discussed mutual couplings or direct couplings or communication connections may be implemented through some interfaces. The indirect couplings or communication connections between the apparatuses or units may be implemented in an electrical form, a mechanical form, or another form.

The units described as separate parts may or may not be physically separate, and parts displayed as units may or may not be physical units, may be located in one location, or may be distributed on a plurality of network units. Some or all of the units may be selected based on actual requirements to achieve the objective of the solutions of embodiments.

In addition, functional units in embodiments of this application may be integrated into one processing unit, each of the units may exist alone physically, or two or more units may be integrated into one unit.

When the functions are implemented in a form of a software function unit and sold or used as an independent product, the functions may be stored in a computer-readable storage medium. Based on such an understanding, the technical solutions of this application essentially, or the part contributing to the conventional technology, or some of the technical solutions may be implemented in a form of a software product. The computer software product is stored in a storage medium, and includes several instructions for instructing a computer device (which may be a personal computer, a server, a network device, or the like) to perform all or some of the steps of the methods described in embodiments of this application. The foregoing storage medium includes any medium that can store program code, such as a USB flash drive, a removable hard disk, a read-only memory (read-only memory, ROM), a random access memory (random access memory, RAM), a magnetic disk, or an optical disc.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A time of flight TOF depth sensing module (300), wherein the TOF depth sensing module comprises a light source (310), a polarization filter (320), a beam shaper (330), a first optical element (340), a second optical element (350), a receiving unit (360), and a control unit (370), the light source can generate light in a plurality of polarization states, and the polarization filter is located between the light source and the beam shaper;

    the light source is configured to generate (5001) a beam;
    the polarization filter is configured to filter (5002) the beam to obtain a beam in a single polarization state, wherein the single polarization state is one of the plurality of polarization states;
    the beam shaper is configured to increase (5003) a field of view FOV of the beam in the single polarization state to obtain a first beam, wherein the FOV of the first beam meets a first preset range;

the control unit is configured to control the first optical element to control a direction of the first beam to obtain an emergent beam; and

the control unit is further configured to control the second optical element to deflect, to the receiving unit, a reflected beam that is obtained by reflecting the emergent beam by a target object;

and the control unit is further configured to:

control (5004) the first optical element to respectively control the direction of the first beam at M different moments, to obtain emergent beams in M different directions,

control (5005) the second optical element to respectively deflect, to the receiving unit, M reflected beams that are obtained by reflecting the emergent beams in the M different directions by a target object, and

generate (5006) a depth image of the target object based on TOFs respectively corresponding to the emergent beams in the M difference directions.

2. The TOF depth sensing module according to claim 1, wherein the first preset range is [5°×5°, 20°×20°].

3. The TOF depth sensing module according to claim 1, wherein total FOV covered by the emergent beams in the M different directions meets a second preset range.

4. The TOF depth sensing module according to any one of claims 1 to 3, wherein a distance between the first optical element and the second optical element is less than or equal to 1 cm.

5. The TOF depth sensing module according to any one of claims 1 to 4, wherein the first optical element and/or the second optical element is a liquid crystal polarization element.

6. The TOF depth sensing module according to any one of claims 1 to 5, wherein the first optical element and/or the second optical element is a rotating mirror component, and the rotating mirror component rotates to control emergent directions of the emergent beams.

7. The TOF depth sensing module according to any one of claims 1 to 6, wherein the beam shaper comprises a diffusion lens and a rectangular aperture stop.

8. The TOF depth sensing module according to any one of claims 1 to 6, wherein the light source is a vertical cavity surface emitting laser.

9. The TOF depth sensing module according to any one of claims 1 to 8, wherein the TOF depth sensing module further comprises:

a collimation lens (380), wherein the collimation lens (380) is located between the light source (310) and the polarization filter (320), and the collimation lens is configured to collimate the beam; and

the polarization filter is configured to filter a collimated beam of the collimation lens, to obtain a beam in a single polarization state.

10. The TOF depth sensing module according to any one of claims 1 to 9, wherein a light emitting area of the light source is less than or equal to $5×5$ mm$^2$.

11. The TOF depth sensing module according to any one of claims 1 to 10, wherein an average output optical power of the TOF depth sensing module is less than 800 mw.

12. An image generation method, wherein the image generation method is applied to a terminal device comprising a time of flight TOF depth sensing module (300);

the TOF depth sensing module comprises a light source (310), a polarization filter (320), a beam shaper (330), a first optical element (340), a second optical element, a receiving unit (360), and a control unit (370), the light source (310) can generate light in a plurality of polarization states, and the polarization filter (320) is located between the light source (310) and the beam shaper (330);

and the image generation method comprises:

controlling (5001) the light source to generate a beam;

filtering (5002) the beam by using the polarization filter to obtain a beam in a single polarization state, wherein the single polarization state is one of the plurality of polarization states;

adjusting (5003) a field of view FOV of the beam in the single polarization state by using the beam shaper to obtain a first beam, wherein the FOV of the first beam meets a first preset range;

controlling (5004) the first optical element to respectively control a direction of the first beam from the beam shaper at M different moments, to obtain emergent beams in M different directions, wherein a total FOV covered by the emergent beams in the M different directions meets a second preset range;

controlling (5005) the second optical element to respectively deflect, to the receiving unit, M reflected beams that are obtained by reflecting the emergent beams in the M different directions by a target object;

obtaining TOFs respectively corresponding to the emergent beams in the M different directions; and

generating (5006) a depth image of the target object based on the TOFs respectively corresponding to the emergent beams in the M different directions.

13. The image generation method according to claim 13, wherein the generating a depth image of the target object based on the TOFs respectively corresponding to the emergent beams in the M different directions comprises:

determining distances between the TOF depth sensing module and M regions of the target object based on the TOFs respectively corresponding to the M emergent beams;

generating depth images of the M regions of the target object based on the distances between the TOF depth sensing module and the M regions of the target object; and

synthesizing the depth image of the target object based on the depth images of the M regions of the target object.

14. A terminal device, comprising the time of flight TOF depth sensing module according to any one of claims 1 to 11.

**Patentansprüche**

1. Flugzeit-(TOF-)Tiefenmessmodul (300), wobei das TOF-Tiefenmessmodul eine Lichtquelle (310), einen Polarisationsfilter (320), einen Strahlformer (330), ein erstes optisches Element (340), ein zweites optisches Element (350), eine Empfangseinheit (360) und eine Steuereinheit (370) umfasst, die Lichtquelle Licht in einer Vielzahl von Polarisationszuständen erzeugen kann und sich der Polarisationsfilter zwischen der Lichtquelle und dem Strahlformer befindet;

die Lichtquelle dazu konfiguriert ist, einen Strahl zu erzeugen (5001);

der Polarisationsfilter dazu konfiguriert ist, den Strahl zu filtern (5002), um einen Strahl in einem Einzelpolarisationszustand zu erlangen, wobei der Einzelpolarisationszustand einer der Vielzahl von Polarisationszuständen ist;

der Strahlformer dazu konfiguriert ist, ein Sichtfeld (FOV) des Strahls in dem Einzelpolarisationszustand zu vergrößern (5003), um einen ersten Strahl zu erlangen, wobei das FOV des ersten Strahls einem ersten voreingestellten Bereich entspricht;

die Steuereinheit dazu konfiguriert ist, das erste optische Element zu steuern, um eine Richtung des ersten Strahls zu steuern, um einen austretenden Strahl zu erlangen; und

die Steuereinheit ferner dazu konfiguriert ist, das zweite optische Element zu steuern, um einen reflektierten Strahl, der durch Reflektieren des austretenden Strahls durch ein Zielobjekt erlangt wird, zu der Empfangseinheit umzulenken;

und wobei die Steuereinheit ferner zu Folgendem konfiguriert ist:

Steuern (5004) des ersten optischen Elements, um jeweils die Richtung des ersten Strahls zu M verschiedenen Zeitpunkten zu steuern, um in M verschiedene Richtungen austretende Strahlen zu erlangen.

Steuern (5005) des zweiten optischen Elements, um jeweils M reflektierte Strahlen, die durch Reflektieren der in M verschiedene Richtungen austretenden Strahlen durch ein Zielobjekt erlangt werden, zu der Empfangseinheit umzulenken, und

Erzeugen (5006) eines Tiefenbildes des Zielobjekts basierend auf TOFen, die jeweils mit den in M verschiedene Richtungen austretenden Strahlen übereinstimmen.

2. TOF-Tiefenmessmodul nach Anspruch 1, wobei der erste voreingestellte Bereich [5°×5°, 20°×20°] ist.

3. TOF-Tiefenmessmodul nach Anspruch 1, wobei das gesamte FOV, das von den in die M verschiedenen Richtungen austretenden Strahlen abgedeckt wird, einem zweiten voreingestellten Bereich entspricht.

4. TOF-Tiefenmessmodul nach einem der Ansprüche 1 bis 3, wobei ein Abstand zwischen dem ersten optischen Element und dem zweiten optischen Element kleiner oder gleich 1 cm ist.

5. TOF-Tiefenmessmodul nach einem der Ansprüche 1 bis 4, wobei das erste optische Element und/oder das zweite optische Element ein Flüssigkristallpolarisationselement ist.

6. TOF-Tiefenmessmodul nach einem der Ansprüche 1 bis 5, wobei das erste optische Element und/oder das zweite optische Element eine rotierende Spiegelkomponente ist und die rotierende Spiegelkomponente rotiert, um Austrittsrichtungen der austretenden Strahlen zu steuern.

7. TOF-Tiefenmessmodul nach einem der Ansprüche 1 bis 6, wobei der Strahlformer eine Diffusionslinse und eine rechteckige Aperturblende umfasst.

8. TOF-Tiefenmessmodul nach einem der Ansprüche 1 bis 6, wobei die Lichtquelle ein oberflächenemittierender Laser mit vertikaler Kavität ist.

9. TOF-Tiefenmessmodul nach einem der Ansprüche 1 bis 8, wobei das TOF-Tiefenmessmodul ferner Folgendes umfasst:

   eine Kollimationslinse (380), wobei sich die Kollimationslinse (380) zwischen der Lichtquelle (310) und dem Polarisationsfilter (320) befindet und
   die Kollimationslinse dazu konfiguriert ist, den Strahl zu kollimieren; und
   der Polarisationsfilter dazu konfiguriert ist, einen kollimierten Strahl der Kollimationslinse zu filtern, um einen Strahl in einem Einzelpolarisationszustand zu erlangen.

10. TOF-Tiefenmessmodul nach einem der Ansprüche 1 bis 9, wobei eine lichtemittierende Fläche der Lichtquelle kleiner oder gleich $5\times5$ mm$^2$ ist.

11. TOF-Tiefenmessmodul nach einem der Ansprüche 1 bis 10, wobei eine durchschnittliche optische Ausgangsleistung des TOF-Tiefenmessmoduls kleiner als 800 mW ist.

12. Bilderzeugungsverfahren, wobei das Bilderzeugungsverfahren auf eine Endgerätevorrichtung, umfassend ein Flugzeit-(TOF-) Tiefenmessmodul (300), angewendet wird; das TOF-Tiefenmessmodul eine Lichtquelle (310), einen Polarisationsfilter (320), einen Strahlformer (330), ein erstes optisches Element (340), ein zweites optisches Element, eine Empfangseinheit (360) und eine Steuereinheit (370) umfasst, die Lichtquelle (310) Licht in einer Vielzahl von Polarisationszuständen erzeugen kann und sich der Polarisationsfilter (320) zwischen der Lichtquelle (310) und dem Strahlformer (330) befindet; und das Bilderzeugungsverfahren Folgendes umfasst:

   Steuern (5001) der Lichtquelle, um einen Strahl zu erzeugen;
   Filtern (5002) des Strahls durch Verwenden des Polarisationsfilters, um einen Strahl in einem Einzelpolarisationszustand zu erlangen, wobei der Einzelpolarisationszustand einer der Vielzahl von Polarisationszuständen ist;
   Einstellen (5003) eines Sichtfeldes (FOV) des Strahls in dem Einzelpolarisationszustand durch Verwenden des Strahlformers, um einen ersten Strahl zu erlangen, wobei das FOV des ersten Strahls einem ersten voreingestellten Bereich entspricht;
   Steuern (5004) des ersten optischen Elements, um jeweils eine Richtung des ersten Strahls von dem Strahlformer zu M verschiedenen Zeitpunkten zu steuern, um in M verschiedene Richtungen austretende Strahlen zu erlangen, wobei ein gesamtes FOV, das von den in die M verschiedenen Richtungen austretenden Strahlen abgedeckt wird, einem zweiten voreingestellten Bereich entspricht;
   Steuern (5005) des zweiten optischen Elements, um jeweils M reflektierte Strahlen, die durch Reflektieren der in M verschiedene Richtungen austretenden Strahlen durch ein Zielobjekt erlangt werden, zu der Empfangseinheit umzulenken;
   Erlangen von TOFen, die jeweils mit den in die M verschiedenen Richtungen austretenden Strahlen übereinstimmen; und
   Erzeugen (5006) eines Tiefenbildes des Zielobjekts basierend auf den TOFen, die jeweils mit den in M verschiedene Richtungen austretenden Strahlen übereinstimmen.

13. Bilderzeugungsverfahren nach Anspruch 13, wobei das Erzeugen eines Tiefenbildes des Zielobjekts basierend auf den TOFen, die jeweils mit den in die M verschiedenen Richtungen austretenden Strahlen übereinstimmen, Folgendes umfasst:

Bestimmen von Abständen zwischen dem TOF-Tiefenmessmodul und M Bereichen des Zielobjekts basierend auf den TOFen, die jeweils mit den M austretenden Strahlen übereinstimmen;
Erzeugen von Tiefenbildern der M Bereiche des Zielobjekts basierend auf den Abständen zwischen dem TOF-Tiefenmessmodul und den M Bereichen des Zielobjekts; und
Synthetisieren des Tiefenbildes des Zielobjekts basierend auf den Tiefenbildern der M Bereiche des Zielobjekts.

14. Endgerätevorrichtung, umfassend das Flugzeit-(TOF-)Tiefenmessmodul nach einem der Ansprüche 1 bis 11.

**Revendications**

1. Module de détection de profondeur à temps de vol TOF (300), dans lequel le module de détection de profondeur à TOF comprend une source lumineuse (310), un filtre de polarisation (320), un façonneur de faisceau (330), un premier élément optique (340), un second élément optique (350), une unité de réception (360) et une unité de commande (370), la source lumineuse peut générer de la lumière dans une pluralité d'états de polarisation, et le filtre de polarisation est situé entre la source lumineuse et le façonneur de faisceau ;

la source lumineuse est configurée pour générer (5001) un faisceau ;
le filtre de polarisation est configuré pour filtrer (5002) le faisceau pour obtenir un faisceau dans un état de polarisation unique, dans lequel l'état de polarisation unique est l'un de la pluralité d'états de polarisation ;
le façonneur de faisceau est configuré pour augmenter (5003) un champ de vision FOV du faisceau dans l'état de polarisation unique pour obtenir un premier faisceau, dans lequel le FOV du premier faisceau satisfait à une première plage prédéfinie ;
l'unité de commande est configurée pour commander le premier élément optique afin de commander une direction du premier faisceau pour obtenir un faisceau émergent ; et
l'unité de commande est également configurée pour commander le second élément optique pour dévier, vers l'unité de réception, un faisceau réfléchi qui est obtenu par réflexion du faisceau émergent par un objet cible ; et l'unité de commande est également configurée pour :

commander (5004) le premier élément optique pour commander respectivement la direction du premier faisceau à M moments différents, pour obtenir des faisceaux émergents dans M directions différentes,
commander (5005) le second élément optique pour dévier respectivement, vers l'unité de réception, M faisceaux réfléchis qui sont obtenus par réflexion des faisceaux émergents dans les M directions différentes par un objet cible, et
générer (5006) une image de profondeur de l'objet cible sur la base des TOF correspondant respectivement aux faisceaux émergents dans les M directions de différence.

2. Module de détection de profondeur à TOF selon la revendication 1, dans lequel la première plage prédéfinie est [5°×5°, 20° ×20°].

3. Module de détection de profondeur à TOF selon la revendication 1, dans lequel le FOV total couvert par les faisceaux émergents dans les M directions différentes satisfait à une seconde plage prédéfinie.

4. Module de détection de profondeur à TOF selon l'une quelconque des revendications 1 à 3, dans lequel une distance entre le premier élément optique et le second élément optique est inférieure ou égale à 1 cm.

5. Module de détection de profondeur à TOF selon l'une quelconque des revendications 1 à 4, dans lequel le premier élément optique et/ou le second élément optique est un élément de polarisation à cristaux liquides.

6. Module de détection de profondeur à TOF selon l'une quelconque des revendications 1 à 5, dans lequel le premier élément optique et/ou le second élément optique est un composant de miroir rotatif, et le composant de miroir rotatif tourne pour commander les directions émergentes des faisceaux émergents.

7. Module de détection de profondeur à TOF selon l'une quelconque des revendications 1 à 6, dans lequel le façonneur de faisceau comprend une lentille de diffusion et un diaphragme d'ouverture rectangulaire.

8. Module de détection de profondeur à TOF selon l'une quelconque des revendications 1 à 6, dans lequel la source lumineuse est un laser à cavité verticale émettant par la surface.

9. Module de détection de profondeur à TOF selon l'une quelconque des revendications 1 à 8, dans lequel le module de détection de profondeur à TOF comprend également :

    une lentille de collimation (380), dans lequel la lentille de collimation (380) est située entre la source lumineuse (310) et le filtre de polarisation (320), et
    la lentille de collimation est configurée pour collimater le faisceau ; et
    le filtre de polarisation est configuré pour filtrer un faisceau collimaté de la lentille de collimation, pour obtenir un faisceau dans un état de polarisation unique.

10. Module de détection de profondeur à TOF selon l'une quelconque des revendications 1 à 9, dans lequel une zone d'émission de lumière de la source lumineuse est inférieure ou égale à $5\times5$ mm$^2$.

11. Module de détection de profondeur à TOF selon l'une quelconque des revendications 1 à 10, dans lequel une puissance optique de sortie moyenne du module de détection de profondeur à TOF est inférieure à 800 mw.

12. Procédé de génération d'images, dans lequel le procédé de génération d'images est appliqué à un dispositif terminal comprenant un module de détection de profondeur à temps de vol TOF (300) ;

    le module de détection de profondeur à TOF comprend une source lumineuse (310),
    un filtre de polarisation (320), un façonneur de faisceau (330),
    un premier élément optique (340), un second élément optique, une unité de réception (360) et une unité de commande (370), la source lumineuse (310) peut générer de la lumière dans une pluralité d'états de polarisation, et le filtre de polarisation (320) est situé entre la source lumineuse (310) et le façonneur de faisceau (330) ; et le procédé de génération d'images comprend :

    la commande (5001) de la source lumineuse pour générer un faisceau ;
    le filtrage (5002) du faisceau à l'aide du filtre de polarisation pour obtenir un faisceau dans un état de polarisation unique, dans lequel l'état de polarisation unique est l'un de la pluralité d'états de polarisation ;
    le réglage (5003) d'un champ de vision FOV du faisceau dans l'état de polarisation unique à l'aide du façonneur de faisceau pour obtenir un premier faisceau, dans lequel le FOV du premier faisceau satisfait à une première plage prédéfinie ;
    la commande (5004) du premier élément optique pour commander respectivement une direction du premier faisceau provenant du façonneur de faisceau à M moments différents, pour obtenir des faisceaux émergents dans M directions différentes, dans lequel un FOV total couvert par les faisceaux émergents dans les M directions différentes satisfait à une seconde plage prédéfinie ;
    la commande (5005) du second élément optique pour dévier respectivement, vers l'unité de réception, M faisceaux réfléchis qui sont obtenus par réflexion des faisceaux émergents dans les M directions différentes par un objet cible ;
    l'obtention des TOF correspondant respectivement aux faisceaux émergents dans les M directions différentes ; et
    la génération (5006) d'une image de profondeur de l'objet cible sur la base des TOF correspondant respectivement aux faisceaux émergents dans les M directions différentes.

13. Procédé de génération d'images selon la revendication 13, dans lequel la génération d'une image de profondeur de l'objet cible sur la base des TOF correspondant respectivement aux faisceaux émergents dans les M directions différentes comprend :

    la détermination des distances entre le module de détection de profondeur à TOF et les M régions de l'objet cible sur la base des TOF correspondant respectivement aux M faisceaux émergents ;
    la génération des images de profondeur des M régions de l'objet cible sur la base des distances entre le module de détection de profondeur à TOF et les M régions de l'objet cible ; et
    la synthétisation de l'image de profondeur de l'objet cible sur la base des images de profondeur des M régions de l'objet cible.

14. Dispositif terminal, comprenant le module de détection de profondeur à temps de vol TOF selon l'une quelconque des revendications 1 à 11.

FIG. 1

FIG. 2

**TOF depth sensing module 100**

Collimation lens 120

Array light source 110

Beam splitter 130

**Receiving unit 140**

Control unit 150

Receiving lens 141

Sensor array 142

FIG. 3

FIG. 4

FIG. 5

● t0 moment
○ t1 moment
⊗ t2 moment
◉ t3 moment

Beam splitting

A   B
C   D

FIG. 6

FIG. 7

FIG. 8

FIG. 9

FIG. 10

FIG. 11

Beam splitter

Array light source

FIG. 12

TOF depth sensing module 100

Optical element 160

Beam splitter 130

Array light source 110

Collimation lens 120

Receiving unit 140

Control unit 150

Receiving lens 141

Sensor array 142

FIG. 13

**TOF depth sensing module 100**

Collimation lens 120

Optical element 160

Beam splitter 130

Array light source 110

Control unit 150

**Receiving unit 140**

Receiving lens 141

Sensor array 142

FIG. 14

FIG. 15

FIG. 16

FIG. 17

| Control, by using a control unit, M of N light emitting regions of an array light source to respectively emit light at M different moments | ∿ 2001 |

| Collimate, by using a collimation lens, beams that are respectively generated by the M light emitting regions at the M different moments, to obtain collimated beams | ∿ 2002 |

| Split the collimated beams by using a beam splitter | ∿ 2003 |

| Receive reflected beams of a target object by using a receiving unit | ∿ 2004 |

| Generate M depth images based on TOFs corresponding to the beams that are respectively emitted by the M light emitting regions of an array light source at the M different moments | ∿ 2005 |

| Obtain a final depth image of the target object based on the M depth images | ∿ 2006 |

FIG. 18

FIG. 19

Control, by using a control unit, M of N light emitting regions of an array light source to respectively emit light at M different moments ~ 3001

Split, by using a beam splitter, beams that are respectively generated by the M light emitting regions at the M different moments ~ 3002

Collimate, by using a collimation lens, beams emitted by the beam splitter ~ 3003

Receive reflected beams of a target object by using a receiving unit ~ 3004

Generate M depth images based on TOFs corresponding to the beams that are respectively emitted by the M light emitting regions of an array light source at the M different moments ~ 3005

Obtain a final depth image of the target object based on the M depth images ~ 3006

FIG. 20

4001. Determine a working mode of a terminal device

4002. Obtain a final depth image of a target object in a first working mode

4003. Obtain a final depth image of a target object in a second working mode

FIG. 21

Control L of N light emitting regions of an array light source to emit light at a same time — 4002A

Collimate, by using a collimation lens, beams emitted by the L light emitting regions — 4002B

Split collimated beams of the collimation lens by using a beam splitter — 4002C

Receive reflected beams of a target object by using a receiving unit — 4002D

Obtain a final depth image of the target object based on TOFs corresponding to the beams emitted by the L light emitting regions — 4002E

FIG. 22

Control L of N light emitting regions of an array light source to emit light at a same time ⟋ 4002a

Split beams of the L light emitting regions by using a beam splitter ⟋ 4002b

Collimate, by using a collimation lens, beams emitted by the beam splitter, to obtain collimated beams ⟋ 4002c

Receive reflected beams of a target object by using a receiving unit ⟋ 4002d

Obtain a final depth image of the target object based on TOFs corresponding to the beams emitted by the L light emitting regions ⟋ 4002e

FIG. 23

| Control M of N light emitting regions of an array light source to emit light at M different moments | 4003A |

| Collimate, by using a collimation lens, beams that are respectively generated by the M light emitting regions at the M different moments, to obtain collimated beams | 4003B |

| Split the collimated beams by using a beam splitter | 4003C |

| Receive reflected beams of a target object by using a receiving unit | 4003D |

| Generate M depth images based on TOFs corresponding to the beams that are respectively emitted by the M light emitting regions at the M different moments | 4003E |

| Obtain a final depth image of the target object based on the M depth images | 4003F |

FIG. 24

Control M of N light emitting regions of an array light source to emit light at M different moments — 4003a

Split, by using a beam splitter, beams that are respectively generated by the M light emitting regions at the M different moments — 4003b

Collimate, by using a collimation lens, beams emitted by the beam splitter — 4003c

Receive reflected beams of a target object by using a receiving unit — 4003d

Generate M depth images based on TOFs corresponding to the beams that are respectively emitted by the M light emitting regions at the M different moments — 4003e

Obtain a final depth image of the target object based on the M depth images — 4003f

FIG. 25

Target scenario

Distance =
time × beam

Emitted
beam

Received
beam

Projection lens (optional)

Optical element

Polarization filter

Collimation lens (optional)

Light source

**Projection end**

Receiving lens (optional)

Two-dimensional sensor
array

**Receive end**

**Control unit**

FIG. 26

**TOF depth sensing module 200**

Polarization filter 220

Light source 210

Optical element 230

Control unit 250

**Receiving unit 240**

Receiving lens 241

Sensor array 242

FIG. 27

FIG. 28

FIG. 29

FIG. 30

FIG. 31

Scanning
manner A

Scanning
manner B

Scanning
manner C

Scanning
manner D

Scanning
manner E

Scanning
manner F

Scanning
manner G

Scanning
manner H

Scanning
manner I

Scanning
manner J

Scanning
manner K

FIG. 32

FIG. 33

**TOF depth sensing module 200**

Polarization filter 220

Light source
210

Optical element 230

2: Horizontal LCPG

4: Vertical LCPG

2    4

**Receiving unit 240**

Control unit
250

Receiving lens 241

Sensor array 242

FIG. 34

1. Horizontal polarization control sheet
2. Horizontal LCPG
3. Vertical polarization control sheet
4. Vertical LCPG

1   2   3   4

FIG. 35

## TOF depth sensing module 200

Polarization filter 220

Light source 210

Optical element 230
1: Horizontal polarization control sheet
2: Horizontal LCPG
3: Vertical polarization control sheet
4: Vertical LCPG

1    2    3    4

Control unit 250

Receiving unit 240

Receiving lens 241

Sensor array 242

FIG. 36

y

0        0.5Λ        Λ        1.5Λ        2Λ

z    x

FIG. 37

| V≥V$_{th}$ | V=0V | V=0V |
|---|---|---|
| Light in any polarization state | Left-handed circularly polarized light | Right-handed circularly polarized light |

FIG. 38

FIG. 39

FIG. 40

FIG. 41

FIG. 42

**TOF depth sensing module 200**

Polarization filter 220

Light source
210

5: Horizontal electro-optic crystal

6: Vertical electro-optic crystal

5          6

**Receiving unit 240**

Control unit
250

Receiving lens 241

Sensor array 242

FIG. 43

FIG. 44

1: Control voltage signal applied to a horizontal deflection electro-optic crystal

2: Control voltage signal applied to a vertical deflection electro-optic crystal

FIG. 45

FIG. 46

FIG. 47

FIG. 48

TOF depth sensing module 200

Polarization filter 220

Light source 210

OPA component

Receiving unit 240

Control unit 250

Receiving lens 241

Sensor array 242

FIG. 49

FIG. 50

FIG. 51

| Control a light source to generate a beam | 5001 |

| Filter the beam by using a polarization filter to obtain a beam in a single polarization state | 5002 |

| Control an optical element to respectively have different birefringence parameters at M different moments to obtain emergent beams in M different directions | 5003 |

| Receive M reflected beams by using a receiving unit | 5004 |

| Generate a depth image of a target object based on TOFs corresponding to the emergent beams in the M different directions | 5005 |

FIG. 52

FIG. 53

**TOF depth sensing module 300**

Polarization filter 320

Beam shaper 330

Light source 310

First optical element 340

**Receiving unit 360**

Control unit 370

Second optical element 350

Receiving lens 361

Sensor array 362

FIG. 54

## TOF depth sensing module 300

Polarization filter 320

Collimation lens 380

Beam shaper 330

Light source 310

First optical element 340

Receiving unit 360

Control unit 370

Second optical element 350

Receiving lens 361

Sensor array 362

FIG. 55

FIG. 56

| Control a light source to generate a beam | 5001 |

| Filter the beam by using a polarization filter to obtain a beam in a single polarization state | 5002 |

| Adjust the beam by using a beam shaper to obtain a first beam | 5003 |

| Control a first optical element to respectively control, at M different moments, a direction of the first beam emitted by the beam shaper, to obtain emergent beams in M different directions | 5004 |

| Control a second optical element to respectively deflect, to a receiving unit, M reflected beams that are obtained by reflecting the emergent beams in the M directions by a target object | 5005 |

| Generate a depth image of the target object based on TOFs respectively corresponding to the emergent beams in the M directions | 5006 |

FIG. 57

Polarization filter 420        **TOF depth sensing module 400**

Beam shaper 430

Light source
410

Control unit
460

**Receiving unit 450**

Optical element
440

Receiving lens 451

Sensor array 452

FIG. 58

Polarization filter 420    **TOF depth sensing module 400**

Beam shaper 430

Collimation lens 470

Light source 410

Control unit 460

**Receiving unit 450**

Optical element 440

Receiving lens 451

Sensor array 452

FIG. 59

**TOF depth sensing module 400**

Polarization filter 420

Beam shaper 430

Collimation lens 470

Light source 410

Control unit 460

Receiving unit 450

Optical element 440

Receiving lens 451

Sensor array 452

FIG. 60

Projection/Receiving FOV

Beam splitter

Light source

Homogenizer

MEMS galvanometer

Receiving lens

Sensor array

FIG. 61

Control a light source to generate a beam ⌇ 6001

Filter the beam by using a polarization filter to obtain a beam in a single polarization state ⌇ 6002

Adjust the beam by using a beam shaper to obtain a first beam ⌇ 6003

Control an optical element to respectively control, at M different moments, a direction of the first beam emitted by the beam shaper, to obtain emergent beams in M different directions ⌇ 6004

Control the optical element to respectively deflect, to a receiving unit, M reflected beams that are obtained by reflecting the emergent beams in the M directions by a target object ⌇ 6005

Generate a depth image of the target object based on TOFs respectively corresponding to the emergent beams in the M directions ⌇ 6006

FIG. 62

Projection FOV

Receiving FOV

1/4 wave plate

Multi-layer LCPG

Homogenizer

Polarization film

Receiving lens

Light source

Sensor array

FIG. 63

1  2  3  4 5

1. Horizontal single-diffraction-angle LCPG
2. Horizontal double-diffraction-angle LCPG
3. Vertical single-diffraction-angle LCPG
4. Vertical double-diffraction-angle LCPG
5. Polarization control sheet

FIG. 64

| t0 | t1 | t2 | t3 |
|---|---|---|---|
| t4 | t5 | t6 | t7 |
| t8 | t9 | t10 | t11 |
| t12 | t13 | t14 | t15 |

FIG. 65

FIG. 66

FIG. 67

FIG. 68

FIG. 69

State A

State B

Projection lens (optional)

Optical element

Homogenizer

Collimation lens (optional)

Light source

**Projection end**

Optical element (optional)

Beam selector

Receiving unit

**Receive end**

**Control unit**

FIG. 70

FIG. 71

**TOF depth sensing module 500**

Collimation lens 560

Light source 510

Optical element 520

Receiving unit 540

Control unit 550

Beam selector 530

Receiving lens 541

Sensor array 542

FIG. 72

FIG. 73

**TOF depth sensing module 500**

Collimation lens 560   Homogenizer 570

Light source 510

Optical element 520

Receiving unit 540

Control unit 550

Beam selector 530

Receiving lens 541

Sensor array 542

FIG. 74

TOF depth sensing module 500

Homogenizer 570   Collimation lens 560

Light source
510

Optical element
520

Receiving unit 540

Beam selector
530

Control unit
550

Receiving lens 541

Sensor array 542

FIG. 75

FIG. 76

EP 4 080 448 B1

FIG. 77

| | |
|---|---|
| Control a light source to generate a beam | 7001 |
| Control an optical element to control a direction of the beam to obtain a first emergent beam and a second emergent beam at a same moment | 7002 |
| Control a beam selector to propagate, to different regions of a receiving unit, a third reflected beam that is obtained by reflecting the first emergent beam by a target object and a fourth reflected beam that is obtained by reflecting the second emergent beam by the target object | 7003 |
| Generate a first depth image of the target object based on a TOF corresponding to the first emergent beam | 7004 |
| Generate a second depth image of the target object based on a TOF corresponding to the second emergent beam | 7005 |

FIG. 78

**TOF depth sensing module 600**

Light source 610

Optical element 620

**Receiving unit 640**

Beam splitter 630

Control unit 650

Receiving lens 641

Sensor array 642

FIG. 79

**TOF depth sensing module 600**

Collimation lens 660

Light source
610

Optical element 620

**Receiving unit 640**

Control unit
650

Beam splitter
630

Receiving lens 641

Sensor array 642

FIG. 80

**TOF depth sensing module 600**

Homogenizer 670

Light source 610

Optical element 620

**Receiving unit 640**

Beam splitter 630

Control unit 650

Receiving lens 641

Sensor array 642

FIG. 81

**TOF depth sensing module 600**

Collimation lens 660    Homogenizer 670

Light source 610

Optical element 620

Control unit 650

**Receiving unit 640**

Beam splitter 630

Receiving lens 641

Sensor array 642

FIG. 82

**TOF depth sensing module 600**

Homogenizer 670        Collimation lens 660

Light source 610

Optical element 620

Receiving unit 640

Control unit 650

Beam splitter 630

Receiving lens 641

Sensor array 642

FIG. 83

Linearly polarized light parallel to a paper surface

Linearly polarized light perpendicular to the paper surface

Left-handed circularly polarized light

Right-handed circularly polarized light

1/4 wave plate

Multi-layer LCPG

Diffractive optical element diffuser

and

Array light source

Single-layer LCPG

Receiving lens

Sensor array

FIG. 84

Linearly polarized light
parallel to a paper surface

Linearly polarized light
perpendicular to the paper surface

Left-handed circularly
polarized light

Right-handed circularly
polarized light

1/4 wave plate

Multi-layer LCPG

Diffractive optical
element diffuser

1/4 wave plate
Polarization
beam splitter
Receiving lens

Reflector

Receiving lens

Array light source

Sensor array

FIG. 85

FIG. 86

| H polarization | V polarization | H polarization | V polarization |
| V polarization | H polarization | V polarization | H polarization |
| H polarization | V polarization | H polarization | V polarization |
| V polarization | H polarization | V polarization | H polarization |
| H polarization | V polarization | H polarization | V polarization |
| V polarization | H polarization | V polarization | H polarization |
| H polarization | V polarization | H polarization | V polarization |
| V polarization | H polarization | V polarization | H polarization |

FIG. 87

Control a light source to generate a beam                                  8001

Control an optical element to control a direction of the beam to obtain a
first emergent beam and a second emergent beam at a same moment          8002

Control a beam splitter to propagate, to different regions of a receiving
unit, a third reflected beam that is obtained by reflecting the first emergent
beam by a target object and a fourth reflected beam that is obtained by
reflecting the second emergent beam by the target object                 8003

Generate a first depth image of the target object based on a TOF
corresponding to the first emergent beam                                  8004

Generate a second depth image of the target object based on a TOF
corresponding to the second emergent beam                                8005

FIG. 88

TOF depth sensing module 700

Light source
710

Optical element 720

Receiving unit 740

Control unit
750

Beam selector
730

Receiving lens 741

Sensor array 742

FIG. 89

TOF depth sensing module 700

Collimation lens 760

Light source
710

Optical element 720

Receiving unit 740

Control unit
750

Beam selector
730

Receiving lens 741

Sensor array 742

FIG. 90

**TOF depth sensing module 700**

Homogenizer 770

Light source 710

Optical element 720

Receiving unit 740

Beam selector 730

Control unit 750

Receiving lens 741

Sensor array 742

FIG. 91

FIG. 92

TOF depth sensing module 700

Homogenizer 770

Collimation lens 760

Light source 710

Optical element 720

Receiving unit 740

Control unit 750

Beam selector 730

Receiving lens 741

Sensor array 742

FIG. 93

1: Liquid crystal drive voltage at a transmit end
2: State selection liquid crystal drive voltage at a receive end
3: Schematic diagram of a signal received by a detector

FIG. 94

Vertical center line
of a field of view

| 0 to 0.5T Angle 1 and state A | 1.5T to 2T Angle 2 and state B |
| --- | --- |

Field of view level
Center line

| 0.5 to 1T Angle 1 and state B |
| --- |

| 1 to 1.5T Angle 2 and state A |
| --- |

FIG. 95

FIG. 96

EP 4 080 448 B1

FIG. 97

Linearly polarized light parallel
to a paper surface

Linearly polarized light perpendicular
to the paper surface

Flat liquid
crystal cell

Electrically
controlled half
wave plate
Polarization film

Microlens
diffuser

Receiving lens
Sensor array

● or

Array light
source

FIG. 98

Orientation film

ITO electrode

z

x

Support     Wedge-shaped
polymer

Glass
substrate

Liquid crystal
molecule

: A polarization direction
is parallel to paper

● : A polarization direction is
perpendicular to the paper

FIG. 99

Orientation film

ITO electrode

$z$

$x$

Support

Wedge-shaped
polymer

Glass
substrate

Liquid crystal
molecule

↔ : A polarization direction is
parallel to paper

● : A polarization direction is
perpendicular to the paper

FIG. 100

Control a light source to generate a beam      9001

Control an optical element to deflect a beam to obtain an emergent beam      9002

Control a beam selector to select a beam having at least two polarization states from beams in each period in reflected beams of a target object, to obtain a received beam, and transmit the received beam to a receiving unit      9003

Generate a depth image of the target object based on a TOF corresponding to the emergent beam      9004

FIG. 101

FIG. 102

FIG. 103

FIG. 104

| S10510. Determine a coverage capability of a TOF depth sensing module |
|---|

| S10520. Determine a quantity of scanning times |
|---|

| S10530. Determine a magnitude of a deflection angle |
|---|

| S10540. Determine an FOV of a first beam |
|---|

FIG. 105

**REFERENCES CITED IN THE DESCRIPTION**

**Patent documents cited in the description**

- US 20160245903 A
- WO 2018221049 A
- US 20160187471 A